# EUROPEAN PATENT APPLICATION

(11) **EP 4 839 071 A1**
(43) Date of publication of application: **11.11.2026**
(21) Application number: 24915442.8
(22) Date of filing: 30.12.2024
(51) Int. Cl.: H10K 85/60, H10K 50/11, H10K 50/16, C09K 11/06, H10K 101/00

(54) **ORGANIC OPTOELECTRONIC DIODE AND DISPLAY DEVICE**

(30) Priority: 03.01.2024 KR 20240001127
(71) Applicant: SAMSUNG SDI CO., LTD., Yongin-si, Gyeonggi-do 17084 (KR)
(72) Inventor: LEE, Mijin, Suwon-si, Gyeonggi-do 16678 (KR); LYU, Seungchul, Suwon-si, Gyeonggi-do 16678 (KR); LEE, Yoonman, Suwon-si, Gyeonggi-do 16678 (KR); LEE, Hanill, Suwon-si, Gyeonggi-do 16678 (KR); JUNG, Ho Kuk, Suwon-si, Gyeonggi-do 16678 (KR); JO, Youngkyoung, Suwon-si, Gyeonggi-do 16678 (KR); KIM, Hyung Sun, Suwon-si, Gyeonggi-do 16678 (KR)
(74) Representative: Michalski Hüttermann & Partner mbB
(86) International application number: PCT/KR2024/021394
(87) International publication number: WO 2025/147030

(57) **Abstract**

Disclosed is an organic optoelectronic device including an an anode and a cathode facing each other, a light emitting layer between the anode and the cathode, and an electron transport layer between the light emitting layer and the cathode, wherein the light emitting layer includes a first compound represented by Chemical Formula 1 and a second compound represented by a combination of Chemical Formula 2 and Chemical Formula 3, and the electron transport layer includes a third compound represented by Chemical Formula 4.

Details for Chemical Formula 1 to Chemical Formula 4 are as defined in the specification.

## Description

### [Technical Field]

An organic optoelectronic device and a display device are disclosed.

### [Background Art]

An organic optoelectronic device (organic optoelectronic diode) is a device capable of converting electrical energy and optical energy to each other.

Organic optoelectronic devices may be largely divided into two types according to a principle of operation. One is a photoelectric device that generates electrical energy by separating excitons formed by light energy into electrons and holes, and transferring the electrons and holes to different electrodes, respectively and the other is a light emitting device that generates light energy from electrical energy by supplying voltage or current to the electrodes.

Examples of the organic optoelectronic device include an organic photoelectric device, an organic light emitting diode, an organic solar cell, and an organic photoconductor drum.

Among them, organic light emitting diodes (OLEDs) are attracting much attention in recent years due to increasing demands for flat panel display devices. The organic light emitting diode is a device that converts electrical energy into light, and the performance of the organic light emitting diode is greatly influenced by an organic material between electrodes.

### [Disclosure]

### [Technical Problem]

An embodiment provides a composition for an organic optoelectronic device capable of lowering the driving voltage and implementing high-efficiency and long life-span organic optoelectronic device.

Another embodiment provides a composition for an organic optoelectronic device including the compound for the organic optoelectronic device.

Another embodiment provides an organic optoelectronic device including the compound for the organic optoelectronic device or composition for the organic optoelectronic device.

Another embodiment provides a display device including the organic optoelectronic device.

### [Technical Solution]

According to an embodiment, an organic optoelectronic device includes an anode and a cathode facing each other, a light emitting layer between the anode and the cathode, and an electron transport layer between the light emitting layer and the cathode, wherein the light emitting layer includes a first compound represented by Chemical Formula 1 and a second compound represented by a combination of Chemical Formula 2 and Chemical Formula 3, and the electron transport layer includes a third compound represented by Chemical Formula 4.

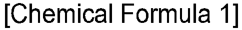

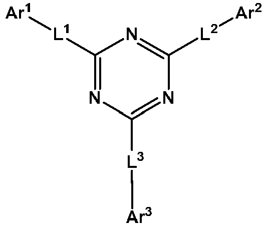

In Chemical Formula 1,
Ar¹ to Ar³ are each independently a substituted or unsubstituted C6 to C30 aryl group, or a substituted or unsubstituted C2 to C30 heterocyclic group, and
L¹ to L³ are each independently a single bond, a substituted or unsubstituted C6 to C20 arylene group, or a substituted or unsubstituted C2 to C30 heteroarylene group; 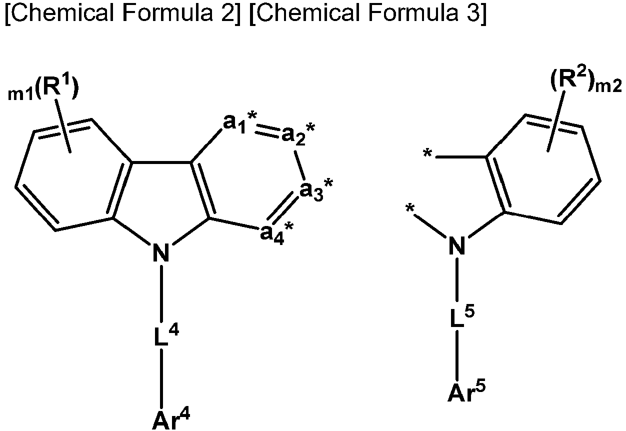
wherein, in Chemical Formula 2 and Chemical Formula 3,
among a₁* to a₄* in Chemical Formula 2, two adjacent ones are each a linking carbon (C) that is linked to * in Chemical Formula 3,
among a₁* to a₄* of Chemical Formula 2, the remaining two that are not linked to Chemical Formula 3 are C-L^{a}-R^{a},
L^{a}, L⁴, and L⁵ are each independently a single bond or a substituted or unsubstituted C6 to C20 arylene group,
R^{a}, R¹, and R² are each independently hydrogen, deuterium, a cyano group, a halogen, a substituted or unsubstituted amine group, a substituted or unsubstituted C1 to C30 alkyl group, a substituted or unsubstituted C6 to C30 aryl group, or a substituted or unsubstituted C2 to C30 heterocyclic group,
Ar⁴ and Ar⁵ are each independently a substituted or unsubstituted C6 to C20 aryl group or a substituted or unsubstituted C2 to C30 heterocyclic group,
m1 and m2 are each independently one of integers of 1 to 4,
when m1 is 2 or more, each R¹ is the same or different from each other, and
when m2 is 2 or more, each R² is the same or different from each other; 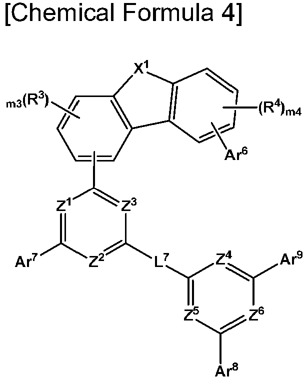
wherein, in Chemical Formula 4,
X¹ is O or S,
Z¹ to Z⁶ are each independently N or CR^{b},
at least two of Z¹ to Z³ are N,
at least two of Z⁴ to Z⁶ are N,
L⁷ is a substituted or unsubstituted phenylene group or a substituted or unsubstituted biphenylene group,
Ar⁶ to Ar⁹ are each independently a substituted or unsubstituted C6 to C30 aryl group,
R^{b}, R³, and R⁴ are each independently hydrogen, deuterium, a cyano group, a halogen, a substituted or unsubstituted C1 to C30 alkyl group, a substituted or unsubstituted C6 to C30 aryl group, or a substituted or unsubstituted C2 to C30 heterocyclic group,
m3 and m4 are each independently one of integers of 1 to 3,
when m3 is 2 or more, each R³ is the same or different from each other, and
when m4 is 2 or more, each R⁴ is the same or different from each other.

According to another embodiment, a display device including the organic optoelectronic device is provided.

### [Advantageous Effects]

An organic optoelectronic device with high efficiency and a long life-span may be realized while lowering a driving voltage.

### [Description of the Drawings]

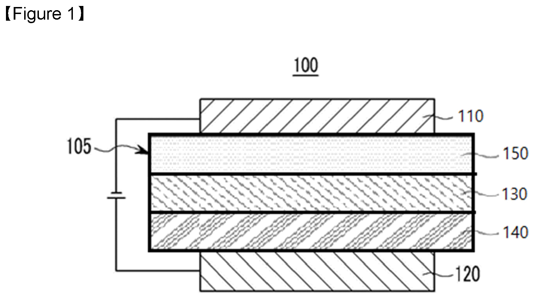

FIG. 1 is a cross-sectional view illustrating an organic light emitting diode according to an embodiment.

### <Description of Symbols>

- 100:: organic light emitting diode
- 105:: organic layer
- 110:: cathode
- 120:: anode
- 130:: light emitting layer
- 140:: hole transport region
- 150:: electron transport region

### [Best Mode]

Hereinafter, embodiments of the present invention are described in detail. However, this is presented as an example and is not intended to limit the invention, and the invention is defined only by the scope of the claims set forth below.

In the present specification, when a definition is not otherwise provided, "substituted" refers to replacement of at least one hydrogen of a substituent or a compound by deuterium, a halogen, a hydroxyl group, an amino group, a substituted or unsubstituted C1 to C30 amine group, a nitro group, a substituted or unsubstituted C1 to C40 silyl group, a C1 to C30 alkyl group, a C1 to C10 alkylsilyl group, a C6 to C30 arylsilyl group, a C3 to C30 cycloalkyl group, a C3 to C30 heterocycloalkyl group, a C6 to C30 aryl group, a C2 to C30 heteroaryl group, a C1 to C20 alkoxy group, a C1 to C10 trifluoroalkyl group, a cyano group, or a combination thereof.

In one example of the present invention, the "substituted" refers to replacement of at least one hydrogen of a substituent or a compound by deuterium, a C1 to C30 alkyl group, a C1 to C10 alkylsilyl group, a C6 to C30 arylsilyl group, a C3 to C30 cycloalkyl group, a C3 to C30 heterocycloalkyl group, a C6 to C30 aryl group, a C2 to C30 heteroaryl group, or a cyano group. In specific example of the present invention, the "substituted" refers to replacement of at least one hydrogen of a substituent or a compound by deuterium, a C1 to C20 alkyl group, a C1 to C5 alkylsilyl group, a C6 to C20 aryl group, a C2 to C20 heteroaryl group, or a cyano group. In specific example of the present invention, the "substituted" refers to replacement of at least one hydrogen of a substituent or a compound by deuterium, a C1 to C5 alkyl group, a C1 to C5 alkylsilyl group, a C6 to C18 aryl group, a C2 to C18 heteroaryl group, or a cyano group. In specific example of the present invention, the "substituted" refers to replacement of at least one hydrogen of a substituent or a compound by deuterium, a cyano group, a methyl group, an ethyl group, an n-propyl group, an iso-propyl group, an n-butyl group, an iso-butyl group, a sec-butyl group, a tert-butyl group, a trimethylsilyl group, a phenyl group, a biphenyl group, a terphenyl group, or a naphthyl group.

In the present specification, "unsubstituted" refers to non-replacement of a hydrogen atom by another substituent and remaining of the hydrogen atom.

In the present specification, "hydrogen substitution (-H)" may include "deuterium substitution (-D)" or "tritium substitution (-T)."

In the present specification, when a definition is not otherwise provided, "hetero" refers to one including one to three heteroatoms selected from N, O, S, P, and Si, and remaining carbons in one functional group.

In the present specification, "aryl group" refers to a group including at least one hydrocarbon aromatic moiety, and all elements of the hydrocarbon aromatic moiety have p-orbitals which form conjugation, for example a phenyl group, a naphthyl group, and the like, two or more hydrocarbon aromatic moieties may be linked by a sigma bond and may be, for example a biphenyl group, a terphenyl group, a quaterphenyl group, and the like, and two or more hydrocarbon aromatic moieties are fused directly or indirectly to provide a non-aromatic fused ring, for example a fluorenyl group.

The aryl group may include a monocyclic, polycyclic, or fused ring polycyclic (i.e., rings sharing adjacent pairs of carbon atoms) functional group.

As used herein, "a heterocyclic group" is a generic concept of a heteroaryl group, and may include at least one heteroatom selected from N, O, S, P, and Si instead of carbon (C) in a cyclic compound such as aryl group, a cycloalkyl group, a fused ring thereof, or a combination thereof. When the heterocyclic group is a fused ring, the entire ring or each ring of the heterocyclic group may include one or more heteroatoms.

For example, "a heteroaryl group" may refer to aryl group including at least one heteroatom selected from N, O, S, P, and Si. Two or more heteroaryl groups are linked by a sigma bond directly, or when the heteroaryl group includes two or more rings, the two or more rings may be fused. When the heteroaryl group is a fused ring, each ring may include one to three heteroatoms.

More specifically, the substituted or unsubstituted C6 to C30 aryl group may be a substituted or unsubstituted phenyl group, a substituted or unsubstituted naphthyl group, a substituted or unsubstituted anthracenyl group, a substituted or unsubstituted phenanthrenyl group, a substituted or unsubstituted naphthacenyl group, a substituted or unsubstituted pyrenyl group, a substituted or unsubstituted biphenyl group, a substituted or unsubstituted p-terphenyl group, a substituted or unsubstituted m-terphenyl group, a substituted or unsubstituted o-terphenyl group, a substituted or unsubstituted chrysenyl group, a substituted or unsubstituted benzophenanthrenyl group, a substituted or unsubstituted triphenylene group, a substituted or unsubstituted perylenyl group, a substituted or unsubstituted fluorenyl group, a substituted or unsubstituted indenyl group, or a combination thereof, but is not limited thereto.

More specifically, the substituted or unsubstituted C2 to C30 heterocyclic group may be a substituted or unsubstituted furanyl group, a substituted or unsubstituted thiophenyl group, a substituted or unsubstituted pyrrolyl group, a substituted or unsubstituted pyrazolyl group, a substituted or unsubstituted imidazolyl group, a substituted or unsubstituted triazolyl group, a substituted or unsubstituted oxazolyl group, a substituted or unsubstituted thiazolyl group, a substituted or unsubstituted oxadiazolyl group, a substituted or unsubstituted thiadiazolyl group, a substituted or unsubstituted pyridyl group, a substituted or unsubstituted pyrimidinyl group, a substituted or unsubstituted pyrazinyl group, a substituted or unsubstituted triazinyl group, a substituted or unsubstituted benzofuranyl group, a substituted or unsubstituted benzothiophenyl group, a substituted or unsubstituted benzimidazolyl group, a substituted or unsubstituted indolyl group, a substituted or unsubstituted quinolinyl group, a substituted or unsubstituted isoquinolinyl group, a substituted or unsubstituted quinazolinyl group, a substituted or unsubstituted quinoxalinyl group, a substituted or unsubstituted naphthyridinyl group, a substituted or unsubstituted benzoxazinyl group, a substituted or unsubstituted benzthiazinyl group, a substituted or unsubstituted acridinyl group, a substituted or unsubstituted phenazinyl group, a substituted or unsubstituted phenothiazinyl group, a substituted or unsubstituted phenoxazinyl group, a substituted or unsubstituted carbazolyl group, a substituted or unsubstituted dibenzofuranyl group, or a substituted or unsubstituted dibenzothiophenyl group, a substituted or unsubstituted benzonaphthofuranyl group, a substituted or unsubstituted benzonaphthothiophenyl group, a substituted or unsubstituted benzofuranofluorenyl group, a substituted or unsubstituted benzothiophenefluorenyl group, or a combination thereof, but is not limited thereto.

In the present specification, hole characteristics refer to an ability to donate an electron to form a hole when an electric field is applied and that a hole formed in the anode may be easily injected into the light emitting layer and transported in the light emitting layer due to conductive characteristics according to a highest occupied molecular orbital (HOMO) level.

In addition, electron characteristics refer to an ability to accept an electron when an electric field is applied and that electron formed in the cathode may be easily injected into the light emitting layer and transported in the light emitting layer due to conductive characteristics according to a lowest unoccupied molecular orbital (LUMO) level.

Hereinafter, an organic optoelectronic device according to an embodiment is described.

The organic optoelectronic device may be a suitable device to convert electrical energy into photoenergy and vice versa, e.g., an organic photoelectric device, an organic light emitting diode, an organic solar cell, or an organic photoconductor drum.

Herein, an organic light emitting diode as one example of an organic optoelectronic device is described, but the present invention is not limited thereto, and may be applied to other organic optoelectronic device in the same way.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present.

FIG. 1 is a cross-sectional view showing an organic light emitting diode according to an embodiment.

Referring to FIG. 1, an organic light emitting diode 100 according to an embodiment includes an anode 120 and a cathode 110 facing each other and an organic layer 105 disposed between the anode 120 and cathode 110.

The anode 120 may be made of a conductor having a large work function to help hole injection, and may be for example a metal, a metal oxide and/or a conductive polymer. The anode 120 may be, for example a metal such as nickel, platinum, vanadium, chromium, copper, zinc, gold, and the like or an alloy thereof; a metal oxide such as zinc oxide, indium oxide, indium tin oxide (ITO), indium zinc oxide (IZO), and the like; a combination of a metal and an oxide such as ZnO and Al or SnO₂ and Sb; a conductive polymer such as poly(3-methylthiophene), poly(3,4-(ethylene-1,2-dioxy)thiophene) (PEDOT), polypyrrole, and polyaniline, but is not limited thereto.

The cathode 110 may be made of a conductor having a small work function to help electron injection, and may be for example a metal, a metal oxide, and/or a conductive polymer. The cathode 110 may include a metal such as magnesium, calcium, sodium, potassium, titanium, indium, yttrium, lithium, gadolinium, aluminum, silver, tin, lead, cesium, barium, or an alloy thereof; a multilayer structure material such as LiF/Al, LiO₂/Al, LiF/Ca, LiF/Al, and BaF₂/Ca, but is not limited thereto.

The organic layer 105 includes a light emitting layer 130, the light emitting layer 130 includes a host and a dopant, and the host may include a composition for an organic optoelectronic device.

Hereinafter, the composition for the organic optoelectronic device is described.

The composition for the organic optoelectronic device includes a first compound represented by Chemical Formula 1 and a second compound represented by a combination of Chemical Formula 2 and Chemical Formula 3.

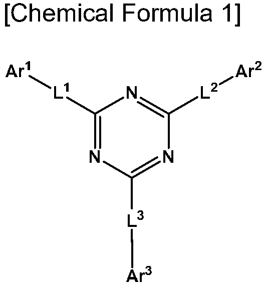

In Chemical Formula 1,
Ar¹ to Ar³ are each independently a substituted or unsubstituted C6 to C30 aryl group, or a substituted or unsubstituted C2 to C30 heterocyclic group,
L¹ to L³ are each independently a single bond, a substituted or unsubstituted C6 to C20 arylene group, or a substituted or unsubstituted C2 to C30 heteroarylene group; 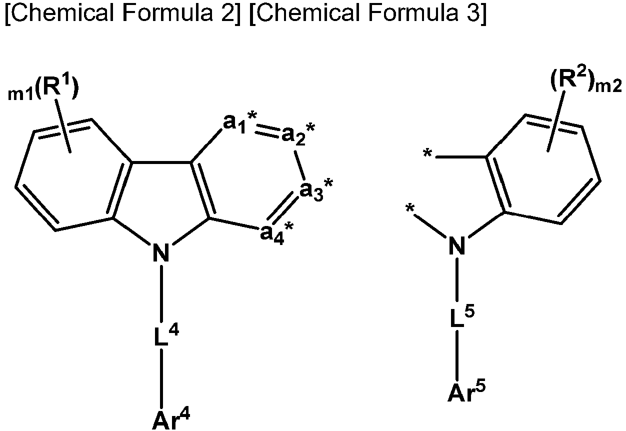
wherein, in Chemical Formula 2 and Chemical Formula 3,
among a₁* to a₄* in Chemical Formula 2, two adjacent ones are each a linking carbon (C) that is linked to * in Chemical Formula 3,
among a₁* to a₄* of Chemical Formula 2, the remaining two that are not linked to Chemical Formula 3 are C-L^{a}-R^{a},
L^{a}, L⁴, and L⁵ are each independently a single bond or a substituted or unsubstituted C6 to C20 arylene group,
R^{a}, R¹, and R² are each independently hydrogen, deuterium, a cyano group, a halogen, a substituted or unsubstituted amine group, a substituted or unsubstituted C1 to C30 alkyl group, a substituted or unsubstituted C6 to C30 aryl group, or a substituted or unsubstituted C2 to C30 heterocyclic group,
Ar⁴ and Ar⁵ are each independently a substituted or unsubstituted C6 to C20 aryl group or a substituted or unsubstituted C2 to C30 heterocyclic group,
m1 and m2 are each independently one of integers of 1 to 4.

In Chemical Formula 2, when m1 is 2 or more, each R¹ may be the same or different form each other.

In Chemical Formula 3, when m2 is 2 or more, each R² may be the same or different form each other.

In Chemical Formula 2 and Chemical Formula 3, when substituted with 2 or more R^{a}s, each R^{a} may be the same or different from each other.

As an example, in Chemical Formula 1, Ar¹ to Ar³ may each independently be a substituted or unsubstituted phenyl group, a substituted or unsubstituted biphenyl group, a substituted or unsubstituted terphenyl group, a substituted or unsubstituted naphthyl group, a substituted or unsubstituted anthracenyl group, a substituted or unsubstituted phenanthrenyl group, a substituted or unsubstituted fluorenyl group, a substituted or unsubstituted triphenylene group, a substituted or unsubstituted pyridinyl group, a substituted or unsubstituted pyrimidinyl group, a substituted or unsubstituted triazinyl group, a substituted or unsubstituted benzothiophenepyrimidinyl group, a substituted or unsubstituted benzofuranpyrimidinyl group, a substituted or unsubstituted dibenzofuranyl group, a substituted or unsubstituted dibenzothiophenyl group, a substituted or unsubstituted carbazolyl group, a substituted or unsubstituted benzocarbazolyl group, a substituted or unsubstituted oxazolocarbazolyl group, a substituted or unsubstituted indolocarbazolyl group, a substituted or unsubstituted indolofluorenyl group, a substituted or unsubstituted benzofuranocarbazolyl group, substituted or unsubstitutedbenzothienocarbazolyl group, or a substituted or unsubstituted dibenzosilolyl group.

As a specific example, in Chemical Formula 1, Ar¹ to Ar³ may each independently be a substituted or unsubstituted phenyl group, a substituted or unsubstituted biphenyl group, a substituted or unsubstituted dibenzofuranyl group, a substituted or unsubstituted dibenzothiophenyl group, or a substituted or unsubstituted carbazolyl group.

As an example, the first compound may be represented by any one of Chemical Formula 1-I , Chemical Formula 1-II, Chemical Formula 1-III and Chemical Formula 1-IV.

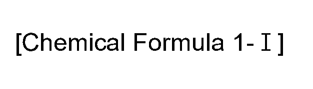

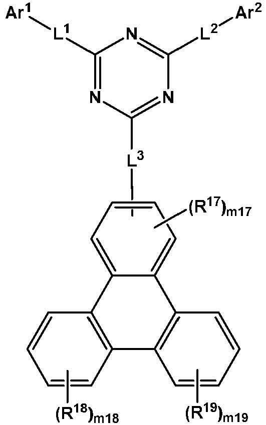

In Chemical Formula 1- I , L¹ to L³ are the same as described above,
Ar¹ and Ar² are each independently a substituted or unsubstituted phenyl group, a substituted or unsubstituted biphenyl group, a substituted or unsubstituted terphenyl group, a substituted or unsubstituted naphthyl group, a substituted or unsubstituted anthracenyl group, a substituted or unsubstituted phenanthrenyl group, a substituted or unsubstituted fluorenyl group, a substituted or unsubstituted triphenylene group, a substituted or unsubstituted dibenzofuranyl group, a substituted or unsubstituted dibenzothiophenyl group or a substituted or unsubstituted dibenzosilolyl group,
R¹⁷ to R¹⁹ are each independently hydrogen, deuterium, a cyano group, a halogen, a substituted or unsubstituted C1 to C30 alkyl group, or a substituted or unsubstituted C6 to C30 aryl group,
m17 is one of integers of 1 to 3,
m18 and m19 are each independently one of integers of 1 to 4,
when m17 is 2 or more, each R¹⁷ is the same or different from each other,
when m18 is 2 or more, each R¹⁸ is the same or different from each other, and
when m19 is 2 or more, each R¹⁹ is the same or different from each other; 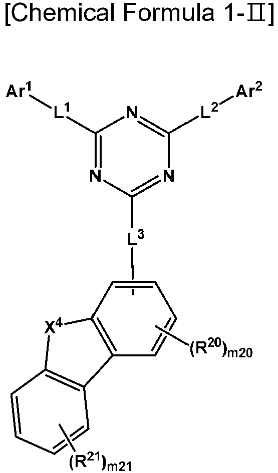
wherein, in Chemical Formula 1-II, L¹ to L³ are the same as described above,
X⁴ is O or S,
Ar¹ and Ar² are each independently a substituted or unsubstituted phenyl group, a substituted or unsubstituted biphenyl group, a substituted or unsubstituted terphenyl group, a substituted or unsubstituted naphthyl group, a substituted or unsubstituted anthracenyl group, a substituted or unsubstituted phenanthrenyl group, a substituted or unsubstituted fluorenyl group, a substituted or unsubstituted dibenzofuranyl group, a substituted or unsubstituted dibenzothiophenyl group or a substituted or unsubstituted dibenzosilolyl group,
R²⁰ to R²¹ are each independently hydrogen, deuterium, a cyano group, a halogen, a substituted or unsubstituted C1 to C30 alkyl group, a substituted or unsubstituted C6 to C30 aryl group, or a substituted or unsubstituted C2 to C30 heterocyclic group,
m20 is one of integers of 1 to 3,
m21 is one of integers of 1 to 4,
when m20 is 2 or more, each R²⁰ is the same or different from each other, and
when m21 is 2 or more, each R²¹ is the same or different from each other; 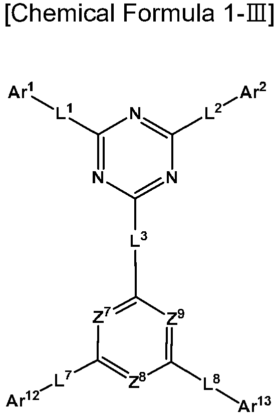
wherein, in Chemical Formula 1-III, L¹ to L³ are the same as described above,
Z⁷ to Z⁹ are each independently N or CR^{f},
at least two of Z⁷ to Z⁹ are N, and
Ar¹ and Ar² are each independently a substituted or unsubstituted phenyl group, a substituted or unsubstituted biphenyl group, a substituted or unsubstituted terphenyl group, a substituted or unsubstituted naphthyl group, a substituted or unsubstituted anthracenyl group, a substituted or unsubstituted phenanthrenyl group, a substituted or unsubstituted fluorenyl group, a substituted or unsubstituted triphenylene group, a substituted or unsubstituted dibenzofuranyl group, a substituted or unsubstituted dibenzothiophenyl group, a substituted or unsubstituted carbazolyl group, a substituted or unsubstituted benzocarbazolyl group, a substituted or unsubstituted oxazolocarbazolyl group, a substituted or unsubstituted indolocarbazolyl group, a substituted or unsubstituted indolofluorenyl group, a substituted or unsubstituted benzofuranocarbazolyl group, a substituted or unsubstitutedbenzothienocarbazolyl group, or a substituted or unsubstituted dibenzosilolyl group; 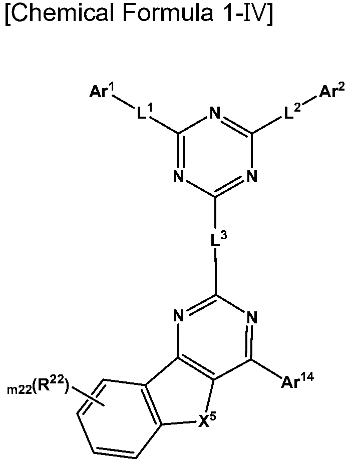
wherein, in Chemical Formula 1-IV, L¹ to L³ are the same as described above,
X⁵ is O or S,
Ar¹ and Ar² are each independently a substituted or unsubstituted phenyl group, a substituted or unsubstituted biphenyl group, a substituted or unsubstituted terphenyl group, a substituted or unsubstituted naphthyl group, a substituted or unsubstituted anthracenyl group, a substituted or unsubstituted phenanthrenyl group, a substituted or unsubstituted fluorenyl group, or a substituted or unsubstituted triphenylene group,
Ar¹⁴ is a substituted or unsubstituted C6 to C30 aryl group,
R²² is hydrogen, deuterium, a cyano group, a halogen, a substituted or unsubstituted C1 to C30 alkyl group, a substituted or unsubstituted C6 to C30 aryl group, or a substituted or unsubstituted C2 to C30 heterocyclic group,
m22 is one of integers of 1 to 4, and
when m22 is 2 or more, each R²² is the same or different from each other.

As another example, the first compound may be represented by Chemical Formula 1-V or Chemical Formula 1-VI.

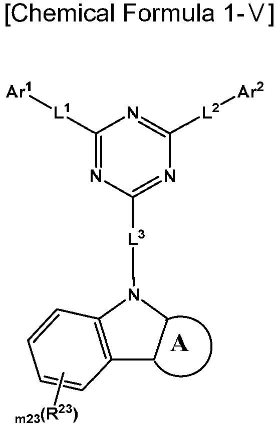

In Chemical Formula 1-V, L¹ to L³ are the same as described above,
ring A is a substituted or unsubstituted phenyl, a substituted or unsubstituted naphthyl, or a substituted or unsubstituted benzoxazole,
Ar¹ and Ar² are each independently a substituted or unsubstituted phenyl group, a substituted or unsubstituted biphenyl group, a substituted or unsubstituted terphenyl group, a substituted or unsubstituted naphthyl group, a substituted or unsubstituted anthracenyl group, a substituted or unsubstituted phenanthrenyl group, a substituted or unsubstituted fluorenyl group, a substituted or unsubstituted triphenylene group, a substituted or unsubstituted dibenzofuranyl group, a substituted or unsubstituted dibenzothiophenyl group, a substituted or unsubstituted carbazolyl group, a substituted or unsubstituted benzocarbazolyl group, a substituted or unsubstituted oxazolocarbazolyl group, or a substituted or unsubstituted dibenzosilolyl group,
R²³ is hydrogen, deuterium, a cyano group, a halogen, a substituted or unsubstituted C1 to C30 alkyl group, a substituted or unsubstituted C6 to C30 aryl group, or a substituted or unsubstituted C2 to C30 heterocyclic group,
m23 is one of integers of 1 to 4, and
when m23 is 2 or more, each R²³ is the same or different from each other; 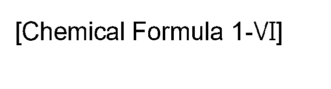 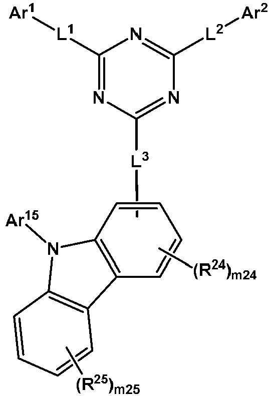
wherein, in Chemical Formula 1-VI, L¹ to L³ are the same as described above,
Ar¹⁵ is a substituted or unsubstituted C6 to C30 aryl group,
Ar¹ and Ar² are each independently a substituted or unsubstituted phenyl group, a substituted or unsubstituted biphenyl group, a substituted or unsubstituted terphenyl group, a substituted or unsubstituted naphthyl group, a substituted or unsubstituted anthracenyl group, a substituted or unsubstituted phenanthrenyl group, a substituted or unsubstituted fluorenyl group, a substituted or unsubstituted triphenylene group, a substituted or unsubstituted dibenzofuranyl group, a substituted or unsubstituted dibenzothiophenyl group, a substituted or unsubstituted carbazolyl group, a substituted or unsubstituted benzocarbazolyl group, a substituted or unsubstituted oxazolocarbazolyl group, or a substituted or unsubstituted dibenzosilolyl group,
R²⁴ and R²⁵ are each independently hydrogen, deuterium, a cyano group, a halogen, a substituted or unsubstituted C1 to C30 alkyl group, a substituted or unsubstituted C6 to C30 aryl group, or a substituted or unsubstituted C2 to C30 heterocyclic group,
m24 is one of integers of 1 to 3,
m25 is one of integers of 1 to 4,
when m24 is 2 or more, each R²⁴ is the same or different from each other, and
when m25 is 2 or more, each R²⁵ is the same or different from each other.

As another example, the first compound may be represented by any one of Chemical Formula 1-VII, Chemical Formula 1-VIII, Chemical Formula 1-IX, Chemical Formula 1-X, Chemical Formula 1-X I and Chemical Formula 1-X II.

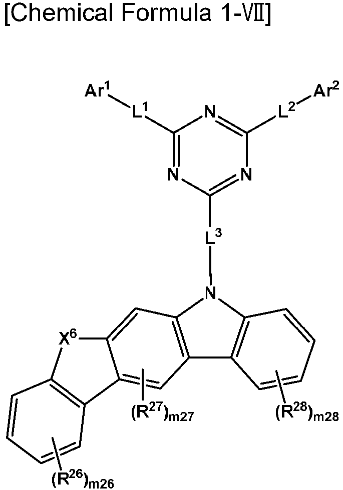

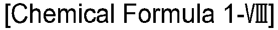

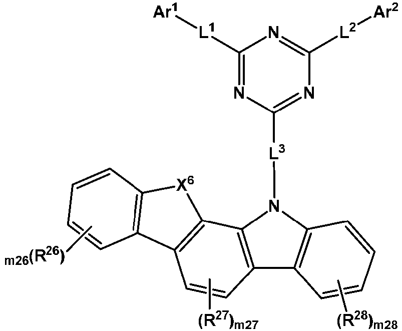

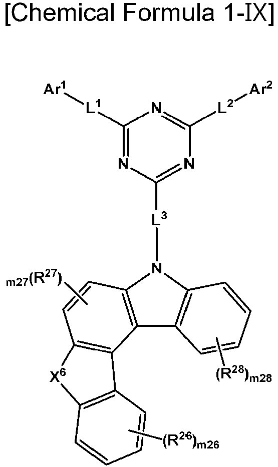

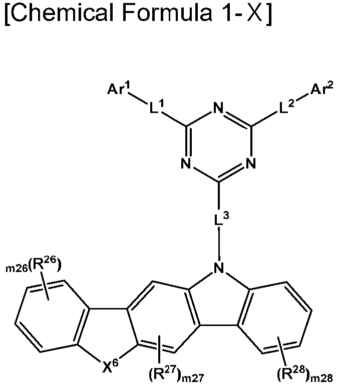

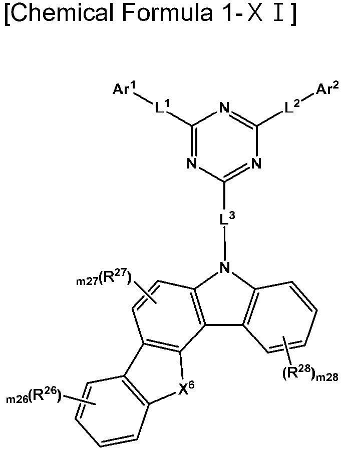

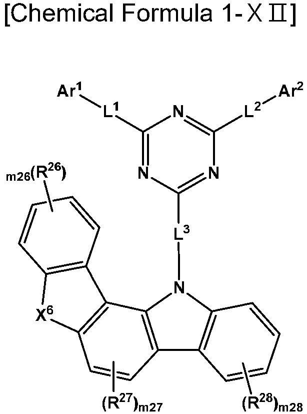

In Chemical Formula 1-VII, Chemical Formula 1-VΠI, Chemical Formula 1-IX, Chemical Formula 1-X, Chemical Formula 1-X I and Chemical Formula 1-X II, L¹ to L³ are the same as described above,
X⁶ is O, S, NR⁹, or CR^{h}Rⁱ,
Ar¹ and Ar² are each independently a substituted or unsubstituted phenyl group, a substituted or unsubstituted biphenyl group, a substituted or unsubstituted terphenyl group, a substituted or unsubstituted naphthyl group, a substituted or unsubstituted anthracenyl group, a substituted or unsubstituted phenanthrenyl group, a substituted or unsubstituted fluorenyl group, a substituted or unsubstituted triphenylene group, a substituted or unsubstituted dibenzofuranyl group, a substituted or unsubstituted dibenzothiophenyl group, a substituted or unsubstituted carbazolyl group, or a substituted or unsubstituted dibenzosilolyl group,
R⁹, R^{g}, Rⁱ, and R²⁶ to R²⁸ are each independently hydrogen, deuterium, a cyano group, a halogen, a substituted or unsubstituted C1 to C30 alkyl group, a substituted or unsubstituted C6 to C30 aryl group, or a substituted or unsubstituted C2 to C30 heterocyclic group,
m26 and m28 are each independently one of integers of 1 to 4,
m27 is an integer of 1 or 2,
when m26 is 2 or more, each R²⁶ is the same or different from each other,
when m27 is 2 or more, each R²⁷ is the same or different from each other, and
when m28 is 2 or more, each R²⁸ is the same or different from each other.

For example, R^{g}, R^{g}, Rⁱ, and R¹⁷ to R²⁸ may each independently be hydrogen, deuterium, a cyano group, a substituted or unsubstituted C1 to C10 alkyl group, a substituted or unsubstituted phenyl group, a substituted or unsubstituted biphenyl group, a substituted or unsubstituted dibenzofuranyl group, or a substituted or unsubstituted dibenzothiophenyl group.

For example, one or more of Ar¹ to Ar³ may be a 9-carbazolyl group.

In an embodiment, L¹-Ar¹, L²-Ar² and L³-Ar³ may each independently be selected from the substituents listed in Group I .

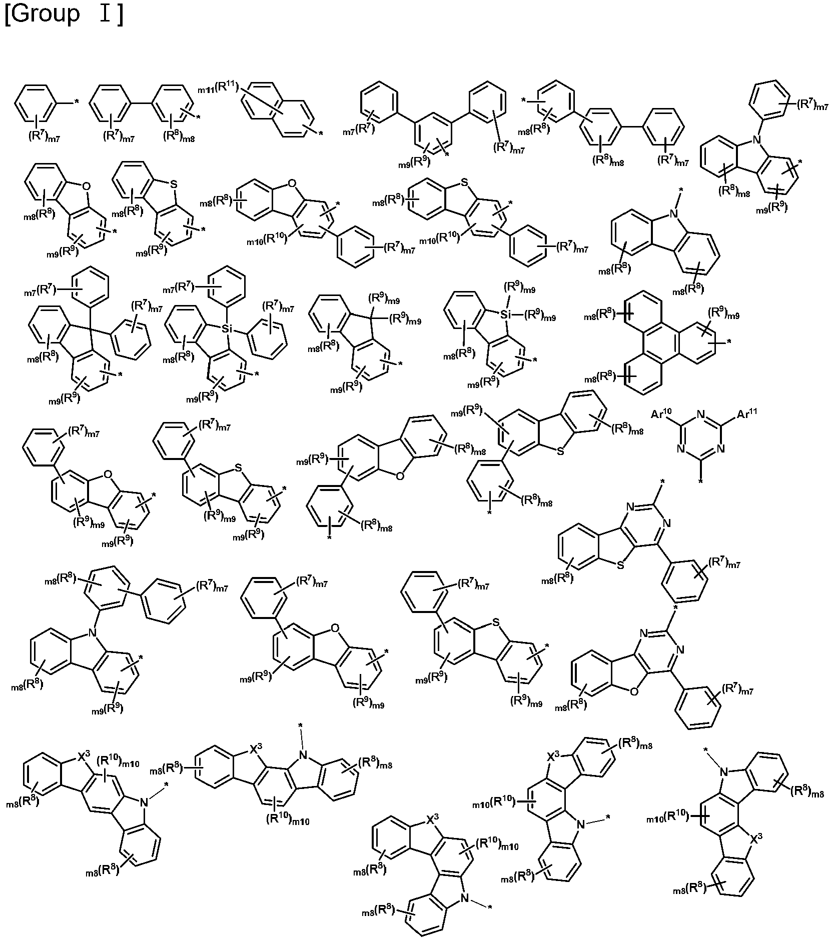

In Group I,
X³ is O, S, NR^{c}, or CR^{d}R^{e},
R^{c}, R^{d}, R^{e}, and R⁷ to R¹¹ are each independently hydrogen, deuterium, a cyano group, a substituted or unsubstituted C1 to C10 alkyl group, a substituted or unsubstituted C6 to C12 aryl group, or a substituted or unsubstituted C2 to C20 heteroaryl group,
Ar¹⁰ and Ar¹¹ are each independently a substituted or unsubstituted C6 to C20 aryl group,
m7 is one of integers of 1 to 5,
m8 is one of integers of 1 to 4,
m9 is one of integers of 1 to 3,
m10 is an integer of 1 or 2,
m11 is one of integers of 1 to 7, and
* is a linking point.

When m7 is 2 or more, each R⁷ may be the same or different from each other.

When m8 is 2 or more, each R⁸ may be the same or different from each other.

When m9 is 2 or more, each R⁹ may be the same or different from each other.

When m10 is 2, each R¹⁰ may be the same or different from each other.

When m11 is 2 or more, each R¹¹ may be the same or different from each other.

In a most specific embodiment, the first compound represented by Chemical Formula 1 may be one selected from the compounds listed in Group 1-1 to Group 1-3 below, but is not limited thereto. 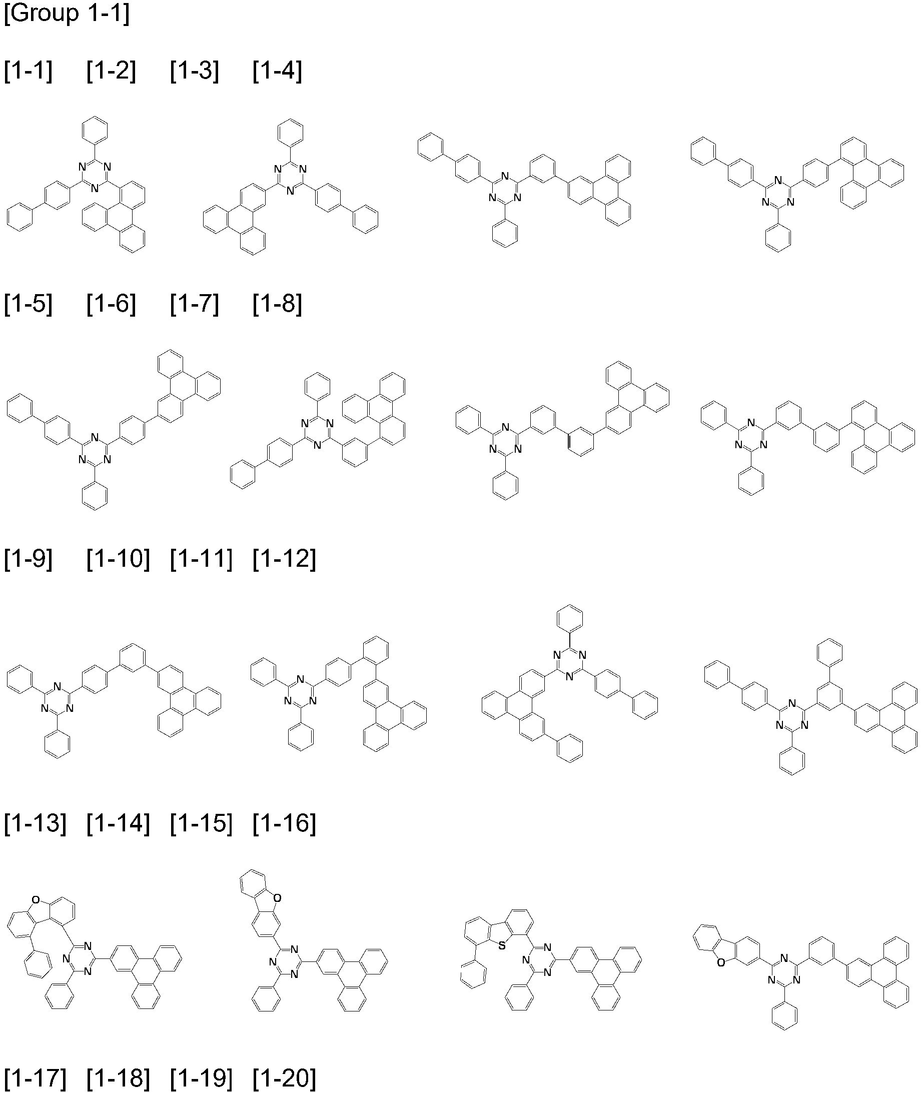 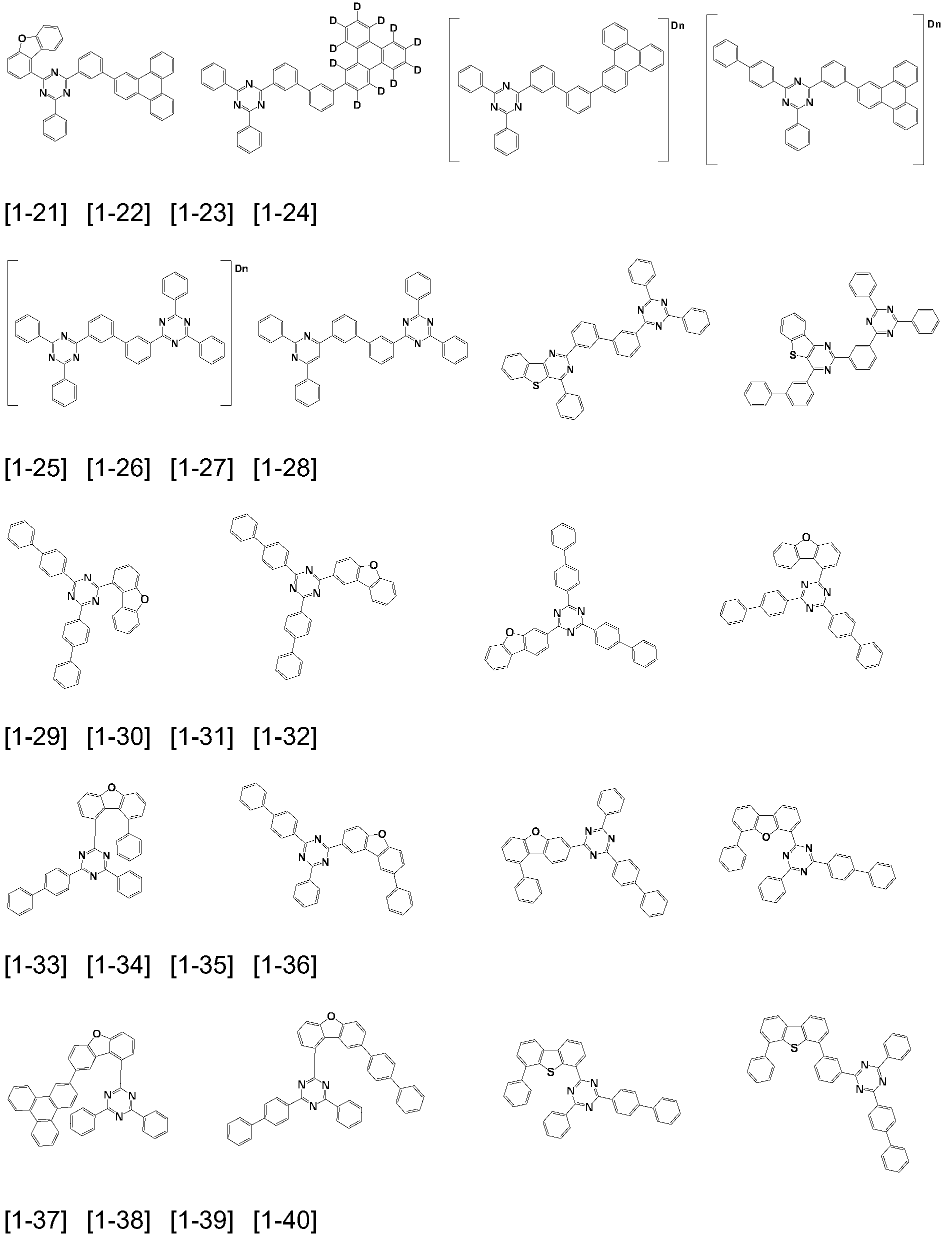 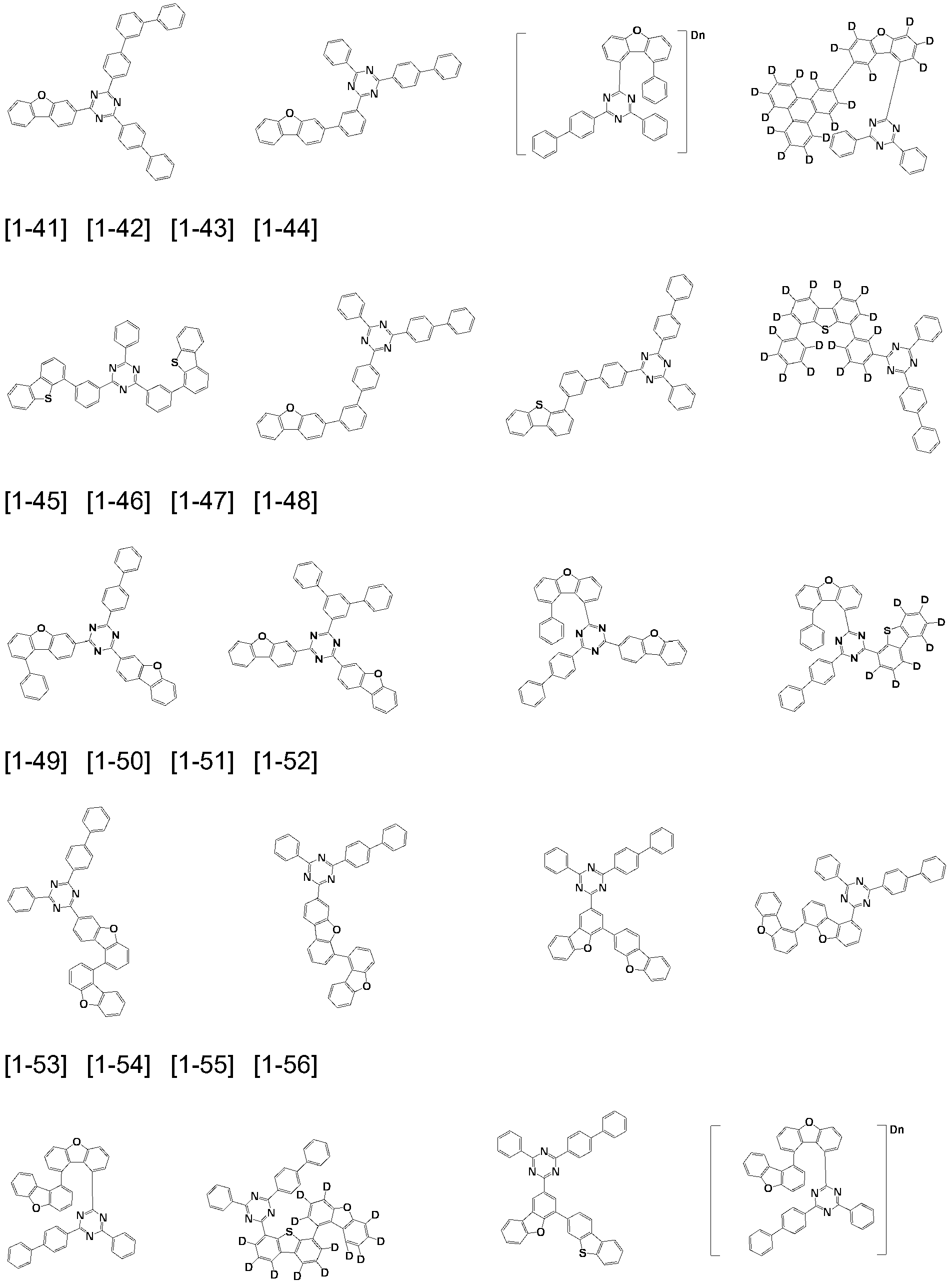 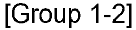 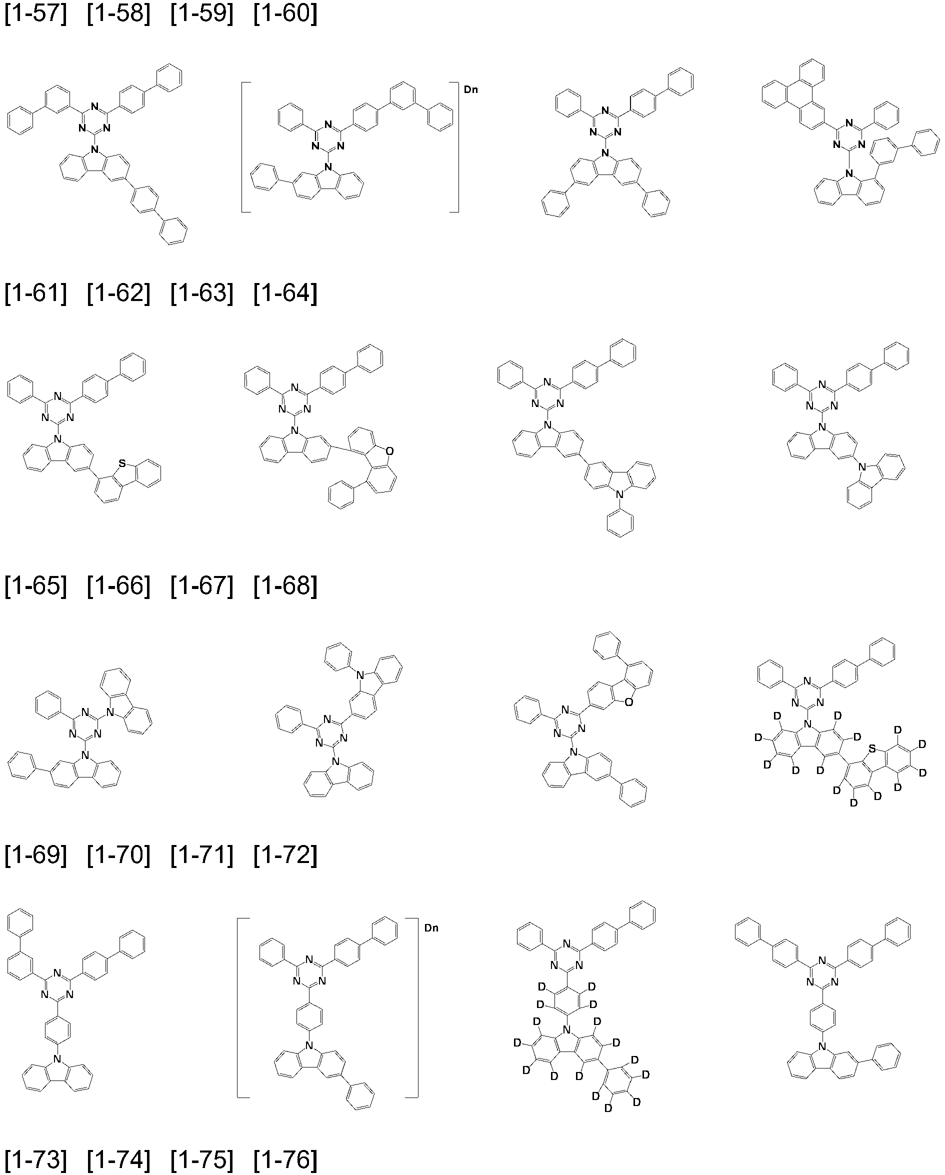 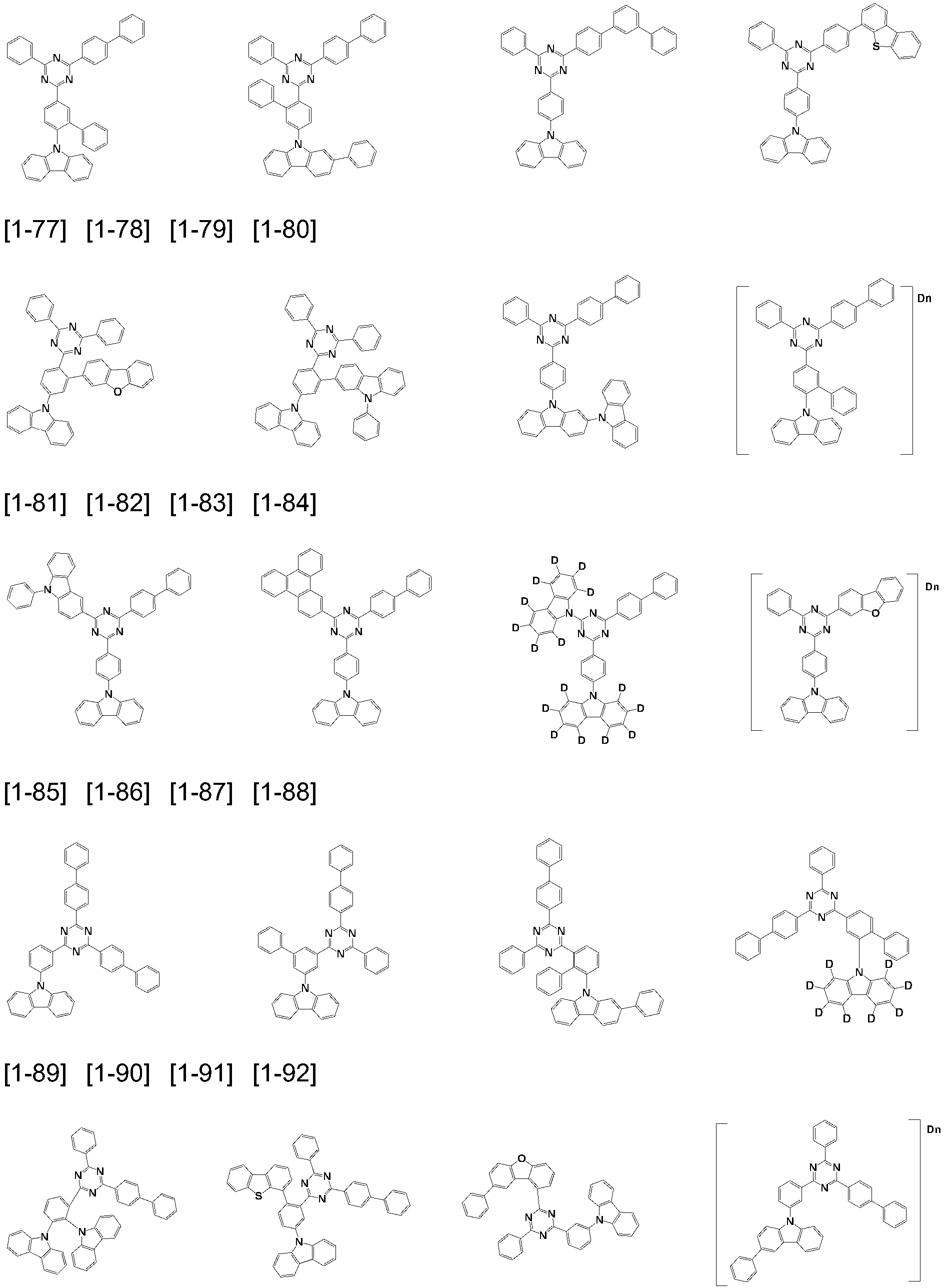 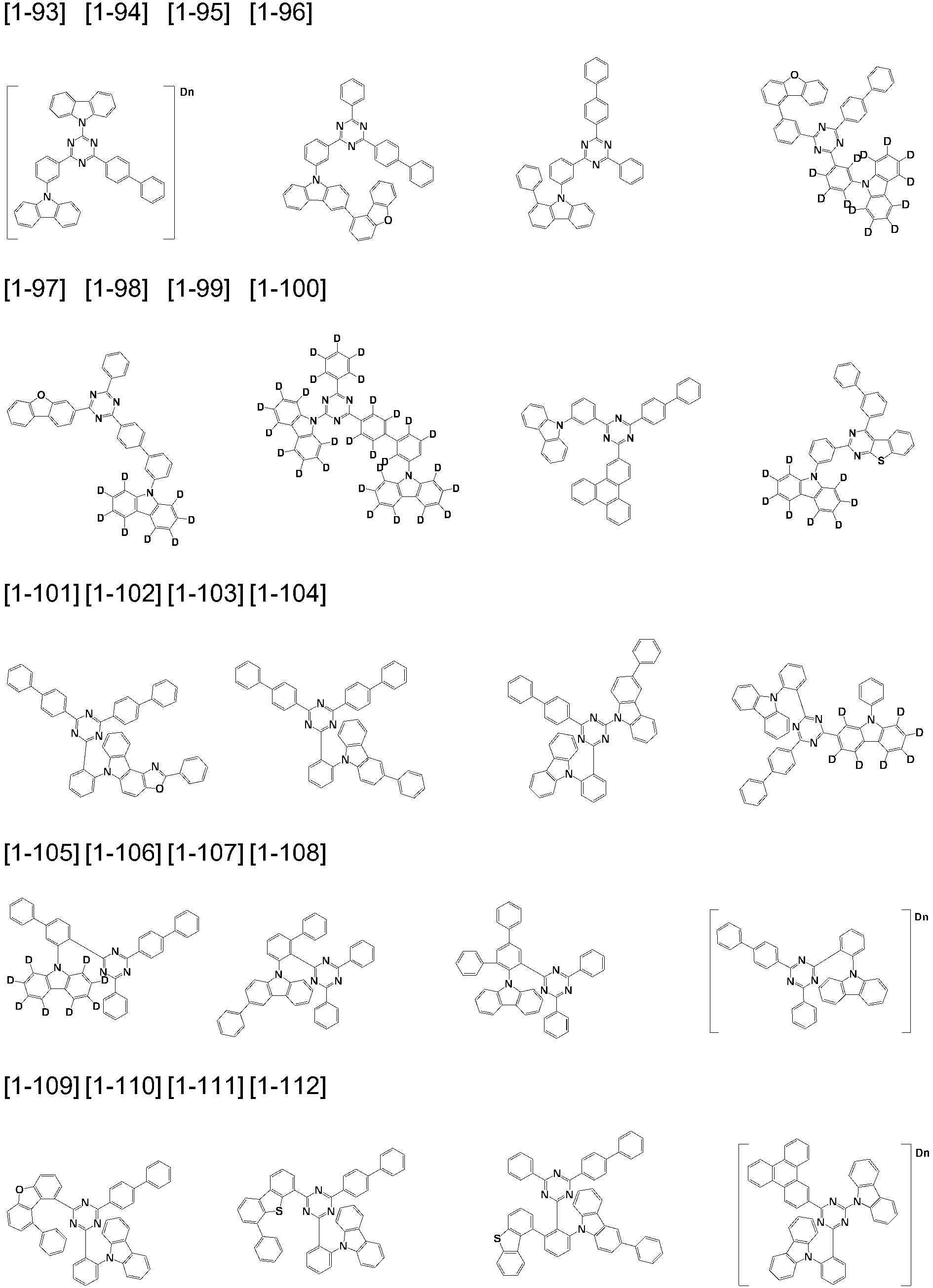 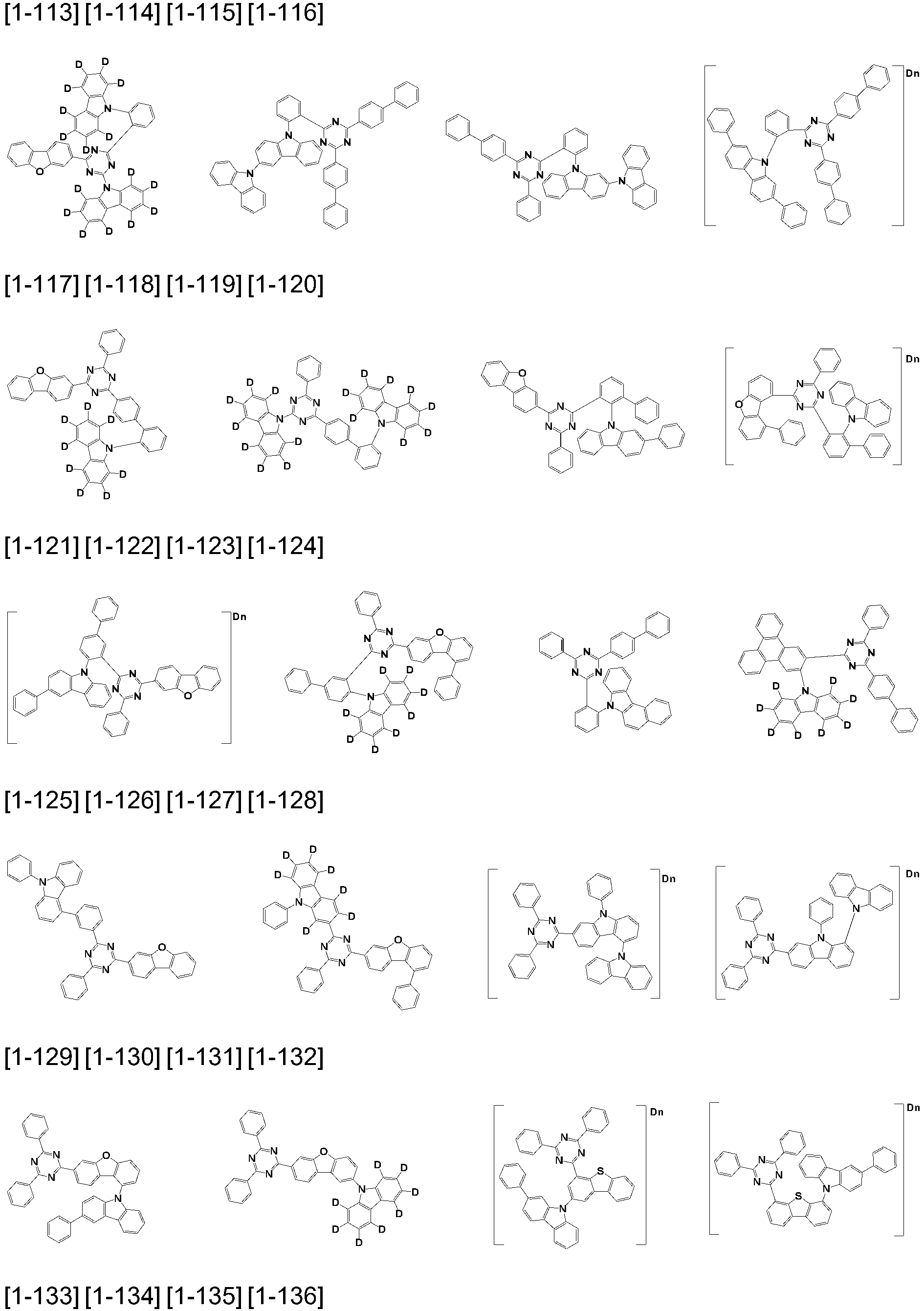 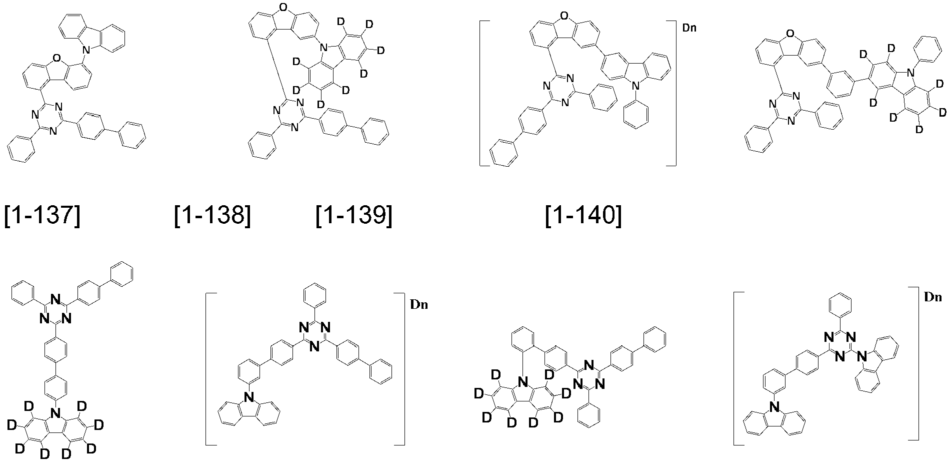 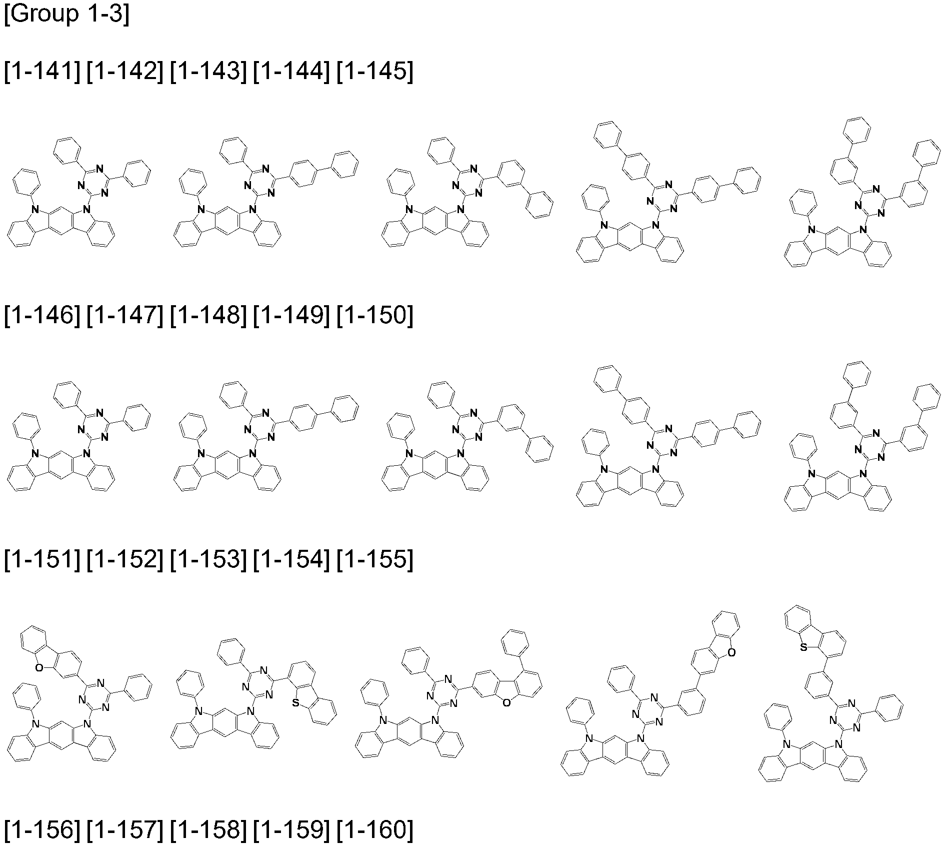 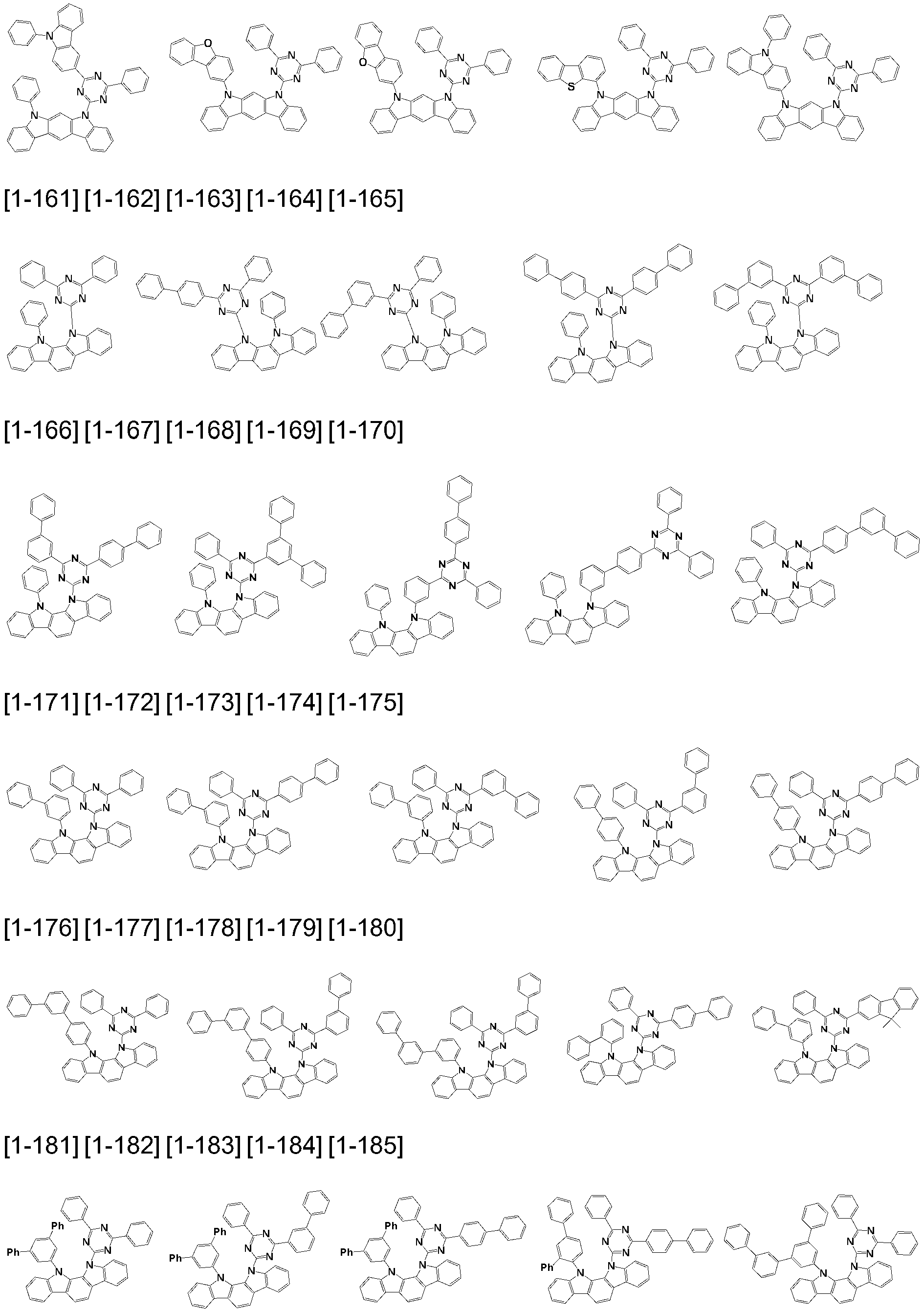 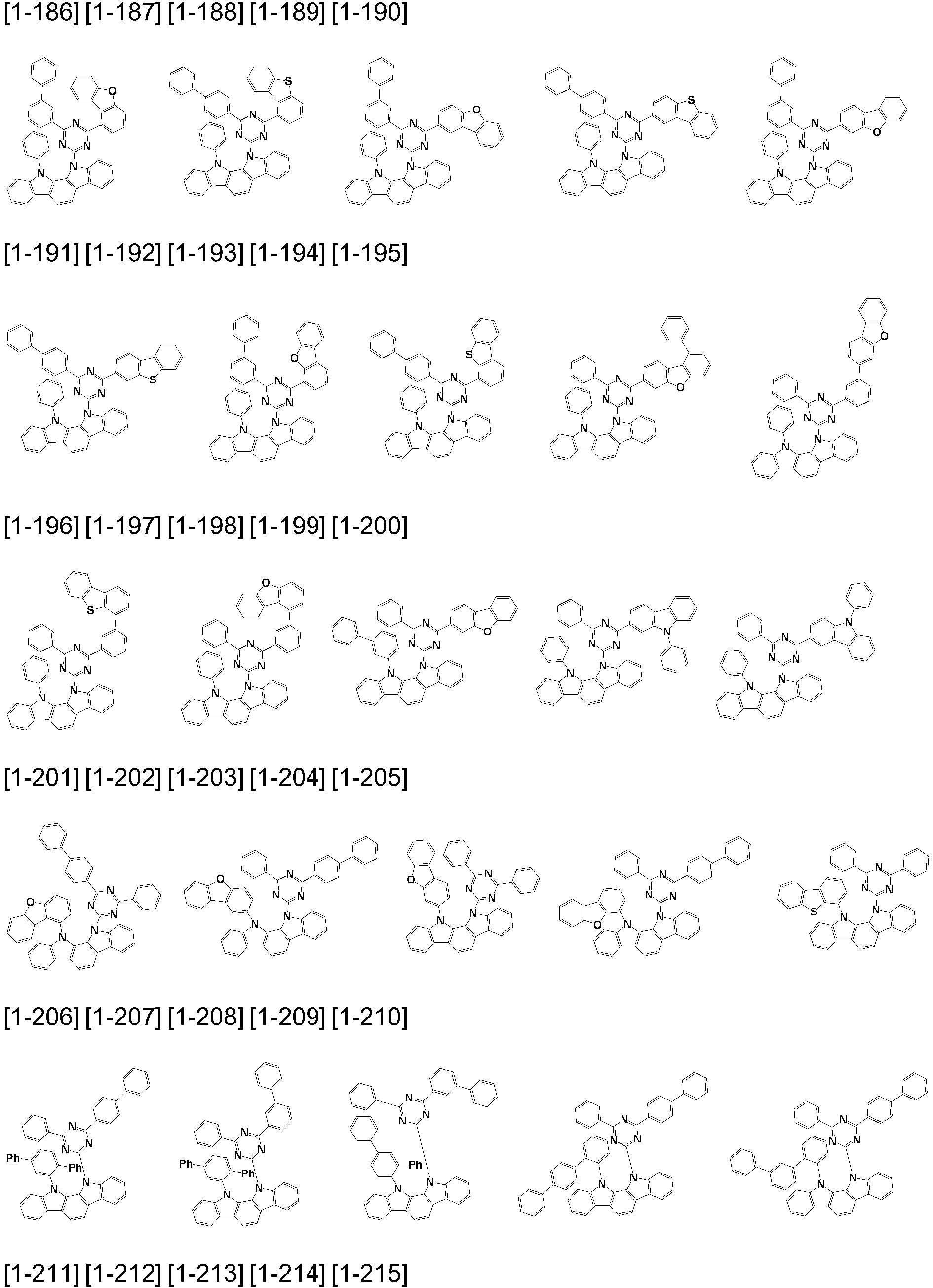 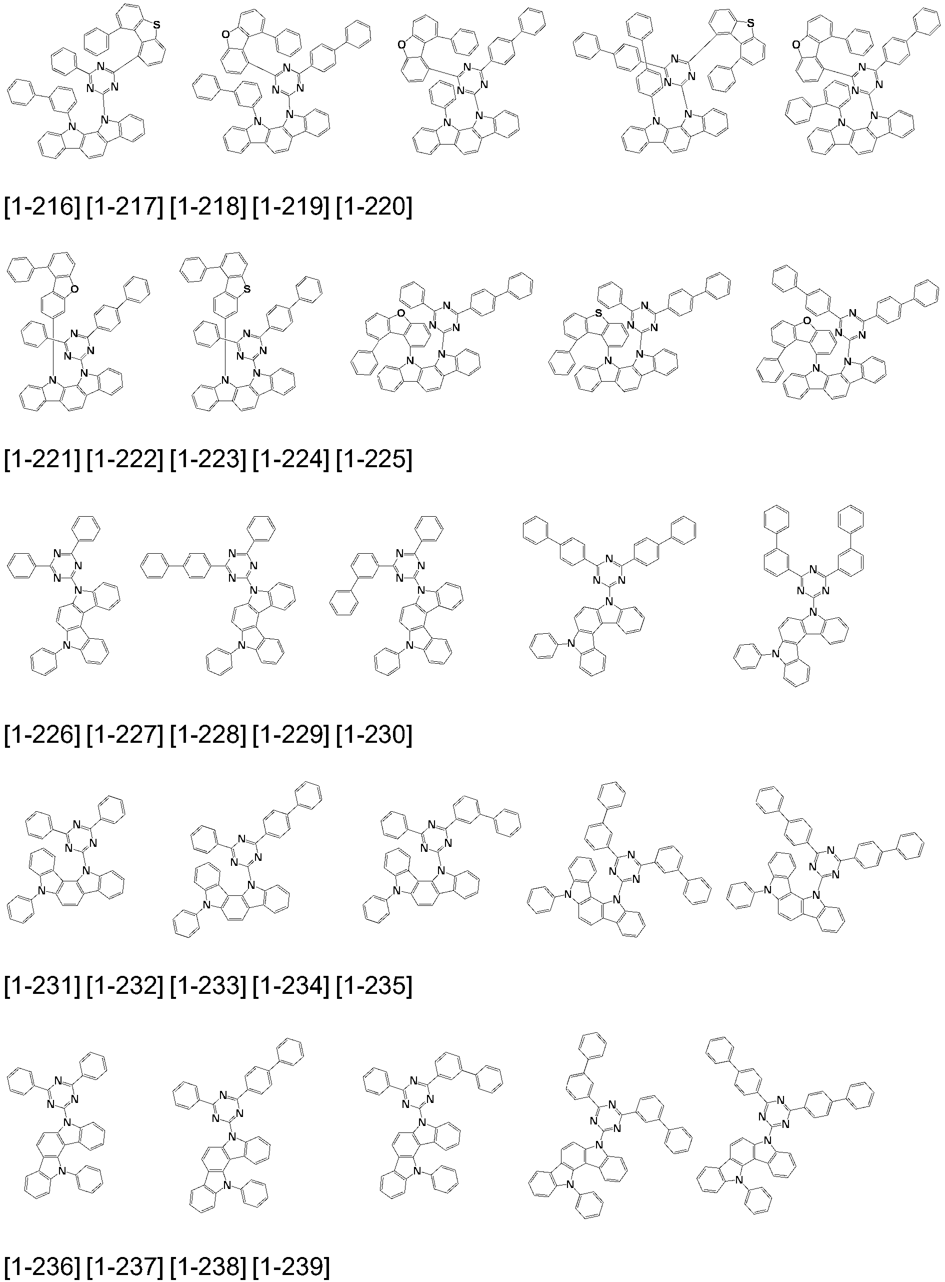 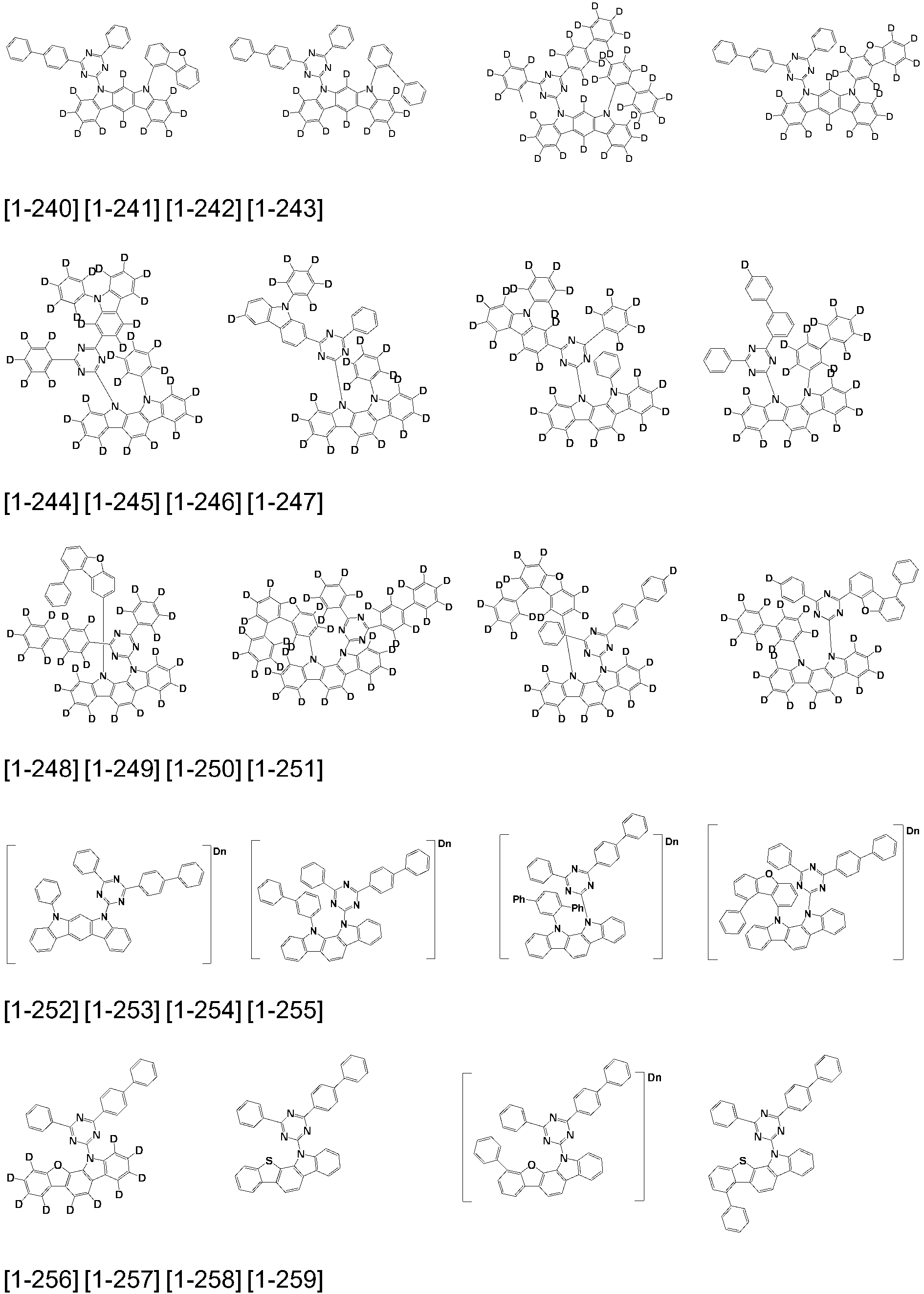 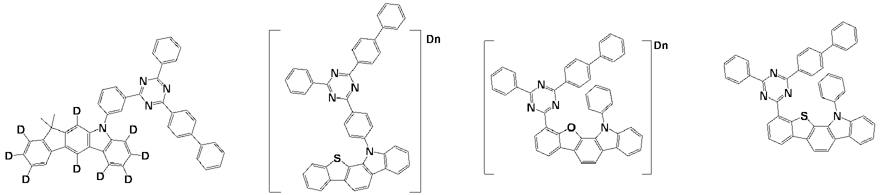 (Dn means the number of substituted deuteriums and indicates a structure in which one or more deuteriums are substituted).

The second compound may be used in the light emitting layer together with the first compound to increase charge mobility and stability, thereby improving light emission efficiency and life-span characteristics.

As an example, the second compound may be represented by any one of Chemical Formula 2A, Chemical Formula 2B, Chemical Formula 2C, Chemical Formula 2D, and Chemical Formula 2E.

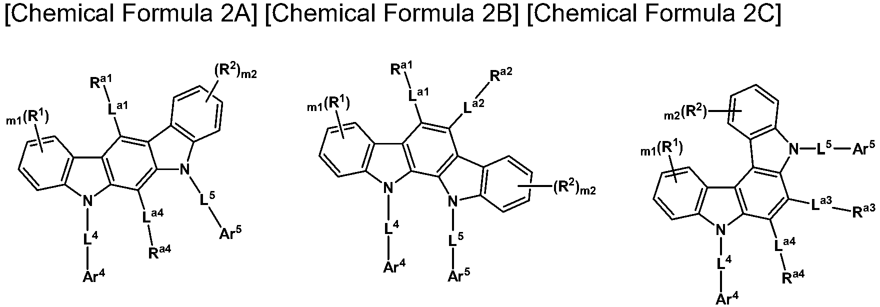

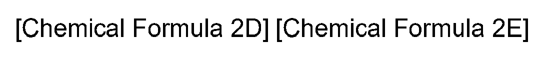

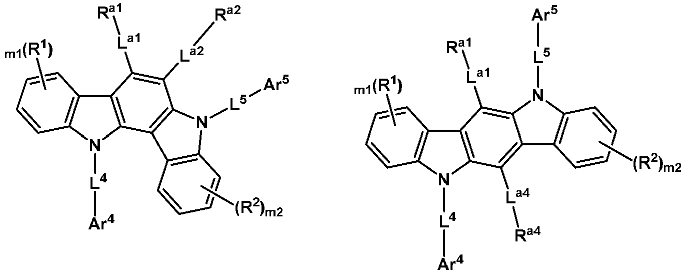

In Chemical Formula 2A, Chemical Formula 2B, Chemical Formula 2C, Chemical Formula 2D, and Chemical Formula 2E,
L^{a1} to L^{a4}, L⁴, and L⁵ are each independently a single bond or a substituted or unsubstituted C6 to C20 arylene group,
R^{a1} to R^{a4}, R¹, and R² are each independently hydrogen, deuterium, a cyano group, a halogen, a substituted or unsubstituted amine group, a substituted or unsubstituted C1 to C30 alkyl group, a substituted or unsubstituted C6 to C30 aryl group, or a substituted or unsubstituted C2 to C30 heterocyclic group,
Ar⁴ and Ar⁵ are each independently a substituted or unsubstituted C6 to C20 aryl group or a substituted or unsubstituted C2 to C30 heterocyclic group, and
m1 and m2 are each independently one of integers of 1 to 4.

For example, in Chemical Formulas 2 and 3, Ar⁴ and Ar⁵ may each independently be a substituted or unsubstituted phenyl group, a substituted or unsubstituted biphenyl group, a substituted or unsubstituted terphenyl group, a substituted or unsubstituted naphthyl group, a substituted or unsubstituted anthracenyl group, a substituted or unsubstituted triphenylenyl group, a substituted or unsubstituted carbazolyl group, a substituted or unsubstituted dibenzothiophenyl group, a substituted or unsubstituted dibenzofuranyl group, or a substituted or unsubstituted fluorenyl group, and
R^{a1} to R^{a4}, R¹ and R² may each independently be hydrogen, deuterium, a cyano group, a substituted or unsubstituted phenyl group, a substituted or unsubstituted biphenyl group, a substituted or unsubstituted pyridinyl group, a substituted or unsubstituted carbazolyl group, a substituted or unsubstituted dibenzofuranyl group, or a substituted or unsubstituted dibenzothiophenyl group.

In an embodiment, R^{a1} to R^{a4}, R¹, and R² may each independently be hydrogen, deuterium, a cyano group, a substituted or unsubstituted phenyl group, a substituted or unsubstituted biphenyl group, a substituted or unsubstituted pyridinyl group, a substituted or unsubstituted carbazolyl group, a substituted or unsubstituted dibenzofuranyl group, or a substituted or unsubstituted dibenzothiophenyl group.

For example, R^{a1} to R^{a4}, R¹, and R² may each independently be hydrogen, deuterium, a cyano group, or a substituted or unsubstituted phenyl group, and
in a specific embodiment, R^{a1} to R^{a4}, R¹, and R² may each independently be hydrogen, deuterium,or a substituted or unsubstituted phenyl group.

As a specific example, the second compound may be represented by Chemical Formula 2C.

In an embodiment, L⁴-Ar⁴ and L⁵-Ar⁵ may each independently be one of the substituents listed in Group II.

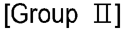

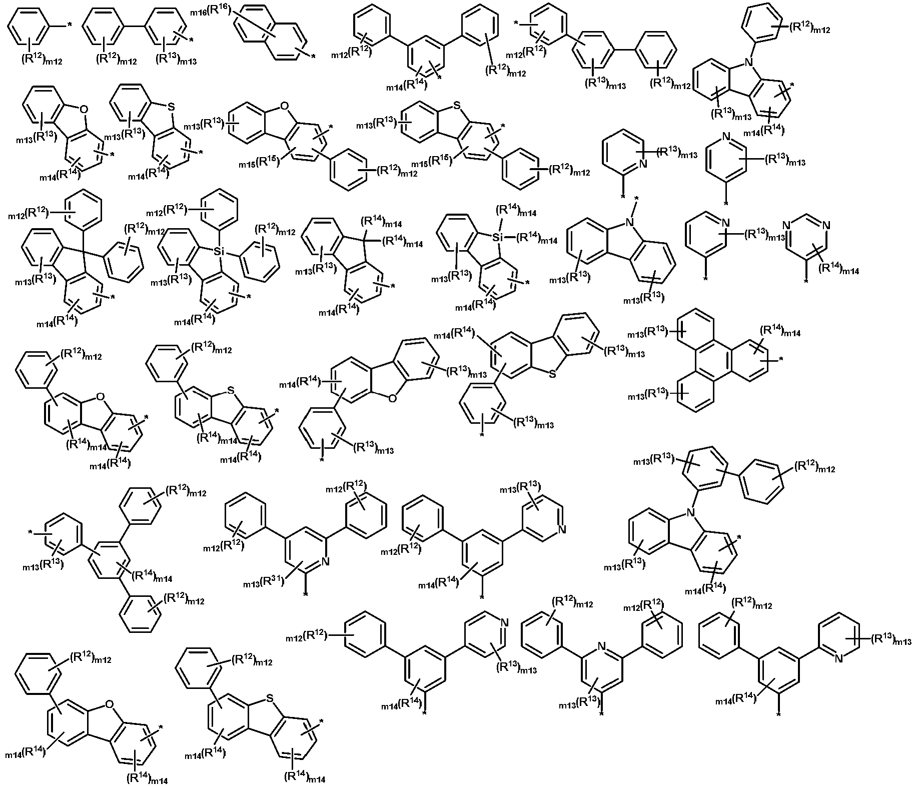

In Group II,
R¹² to R¹⁶ are each independently hydrogen, deuterium, a cyano group, C1 to C10 alkyl group or C6 to C12 aryl group,
m12 is one of integers of 1 to 5,
m13 is one of integers of 1 to 4,
m14 is one of integers of 1 to 3,
m15 is an integer of 1 or 2,
m16 is one of integers of 1 to 7, and
* is a linking point.

When m12 is 2 or more, each R¹² may be the same or different from each other.

When m13 is 2 or more, each R¹³ may be the same or different from each other.

When m14 is 2 or more, each R¹⁴ may be the same or different from each other.

When m15 is 2, each R¹⁵ may be the same or different from each other.

When m16 is 2 or more, each R¹⁶ may be the same or different from each other.

For example, the second compound may be represented by Chemical Formula 2c.

In another specific embodiment of the present invention, L^{a1} to L^{a4} may each be a single bond, L⁴ and L⁵ may each independently be a single bond or a substituted or unsubstituted C6 to C12 arylene group, R¹, R², and R^{a1} to R^{a4} may each be hydrogen, deuterium, or a phenyl group, and Ar⁴ and Ar⁵ may each independently be a substituted or unsubstituted phenyl group, a substituted or unsubstituted biphenyl group, a substituted or unsubstituted pyridinyl group, a substituted or unsubstituted carbazolyl group, a substituted or unsubstituted dibenzofuranyl group, or a substituted or unsubstituted dibenzothiophenyl group.

For example, L^{a1} to L^{a4} may be a single bond, R¹, R², and R^{a1} to R^{a4} may each independently be hydrogen, deuterium, or a C6 to C12 aryl group, and L⁴-Ar⁴ and L⁵-Ar⁵ may each independently be one of the substituents listed in Group II.

In a most specific embodiment, the second compound represented by a combination of Chemical Formula 2 and Chemical Formula 3 may be one selected from the compounds listed in Group 2, but is not limited thereto.

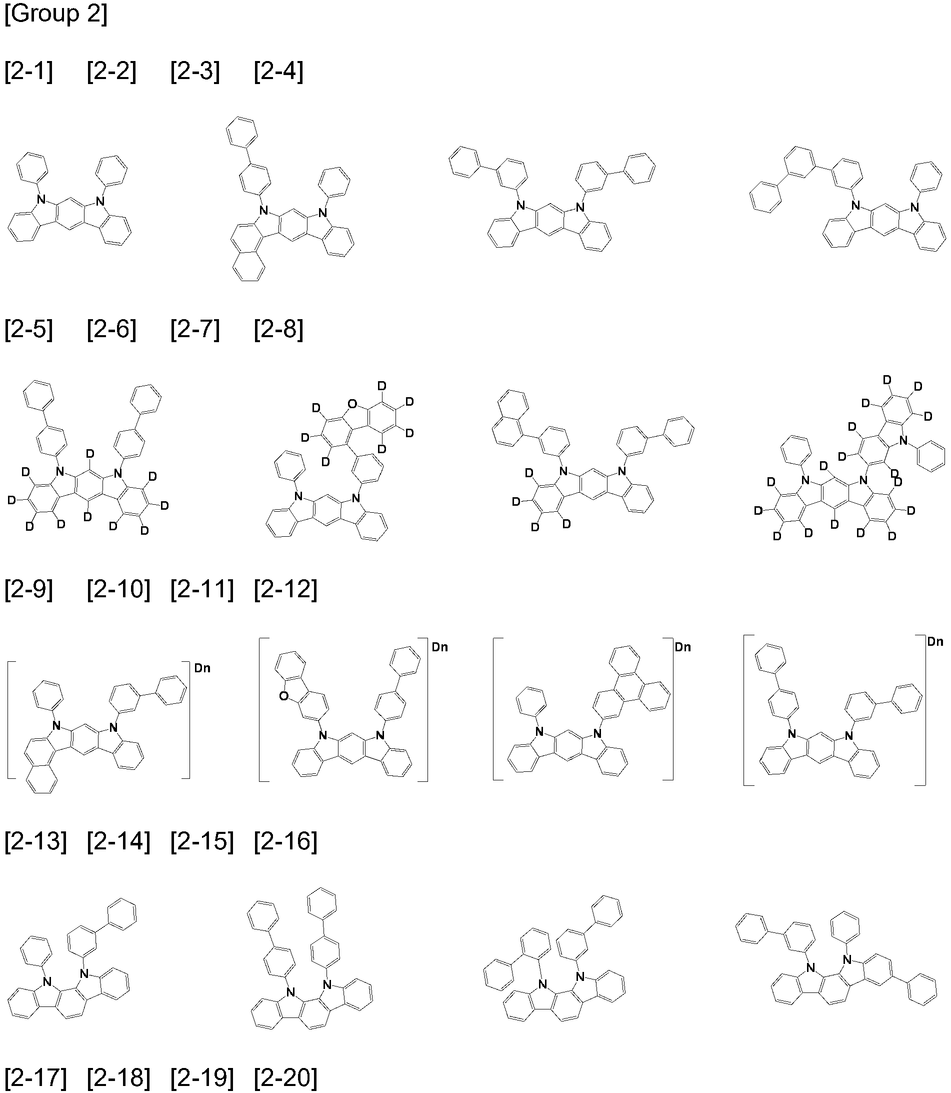

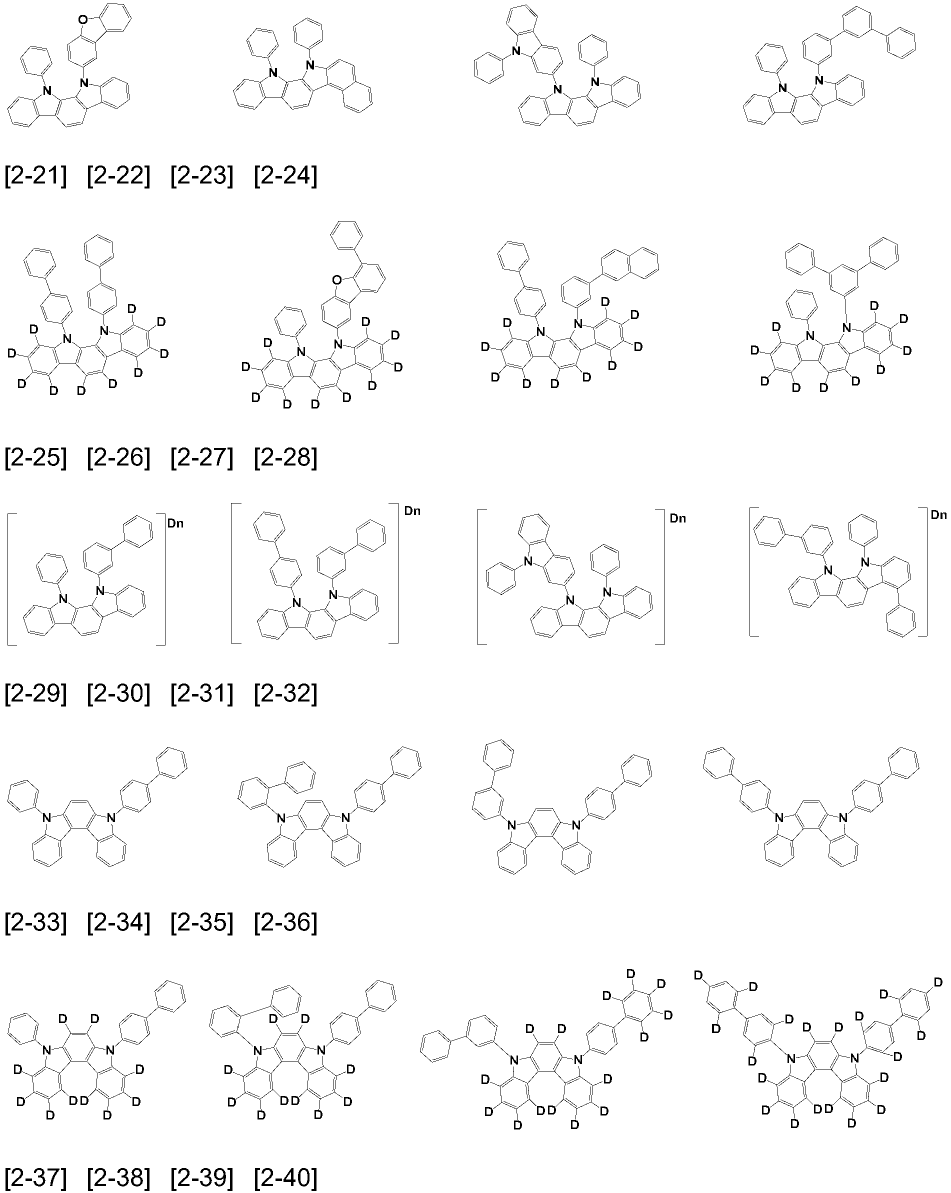

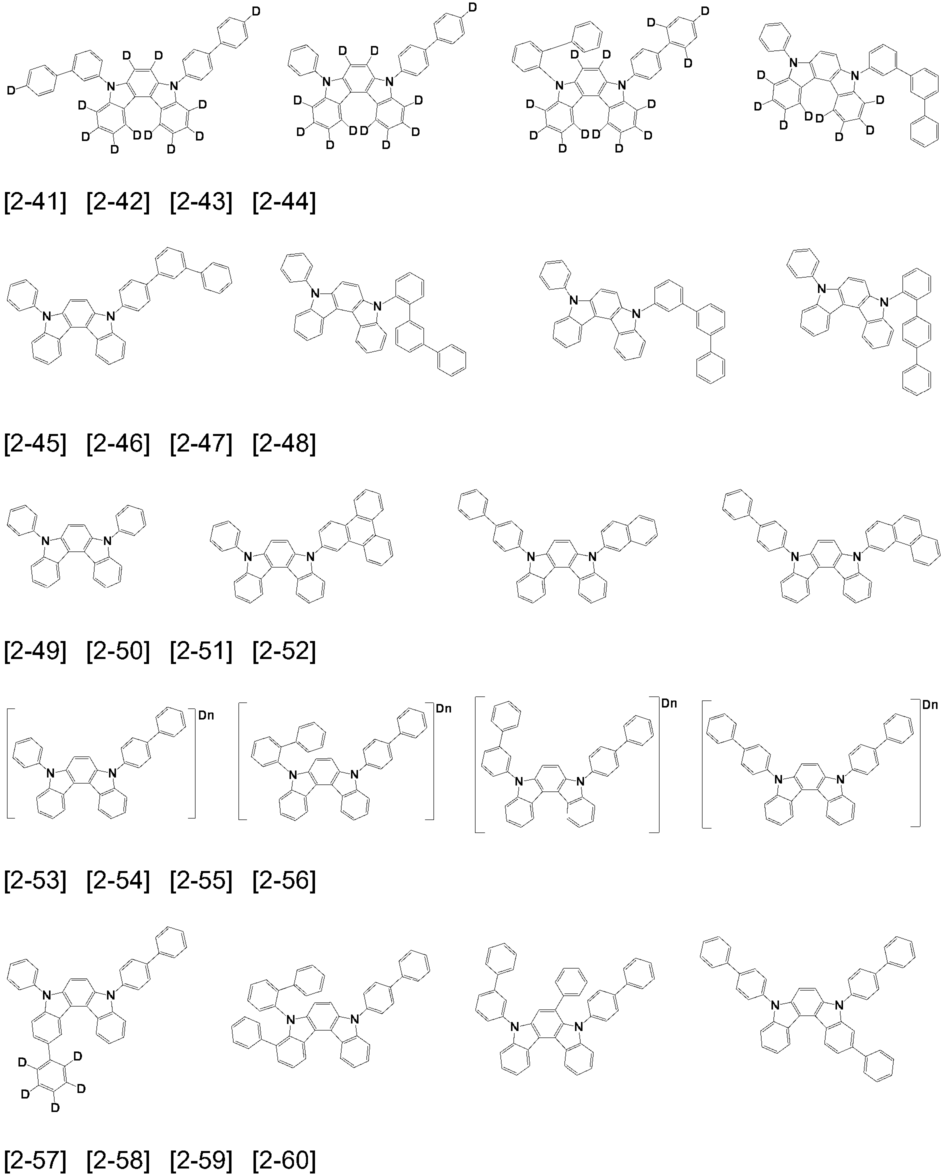

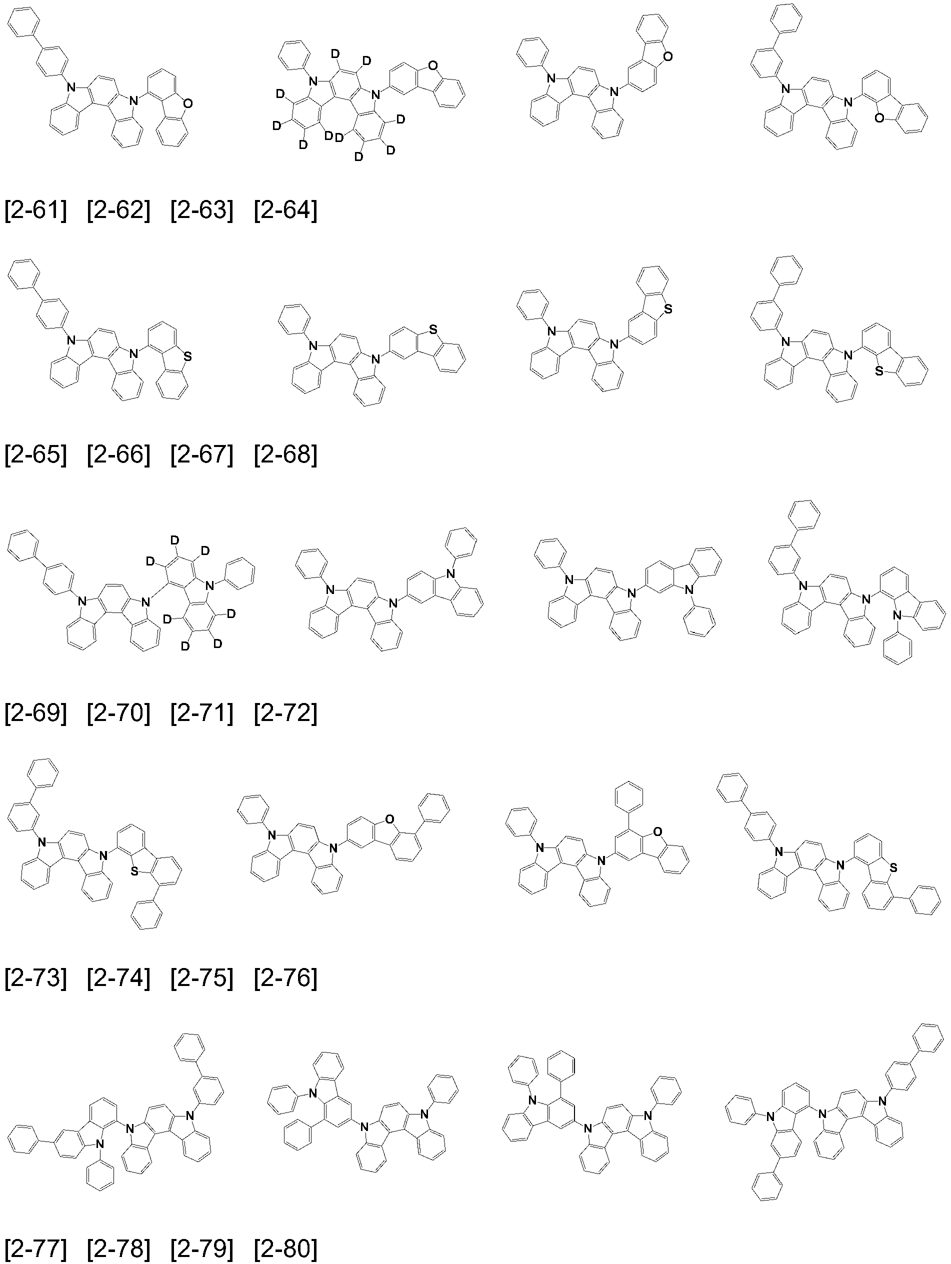

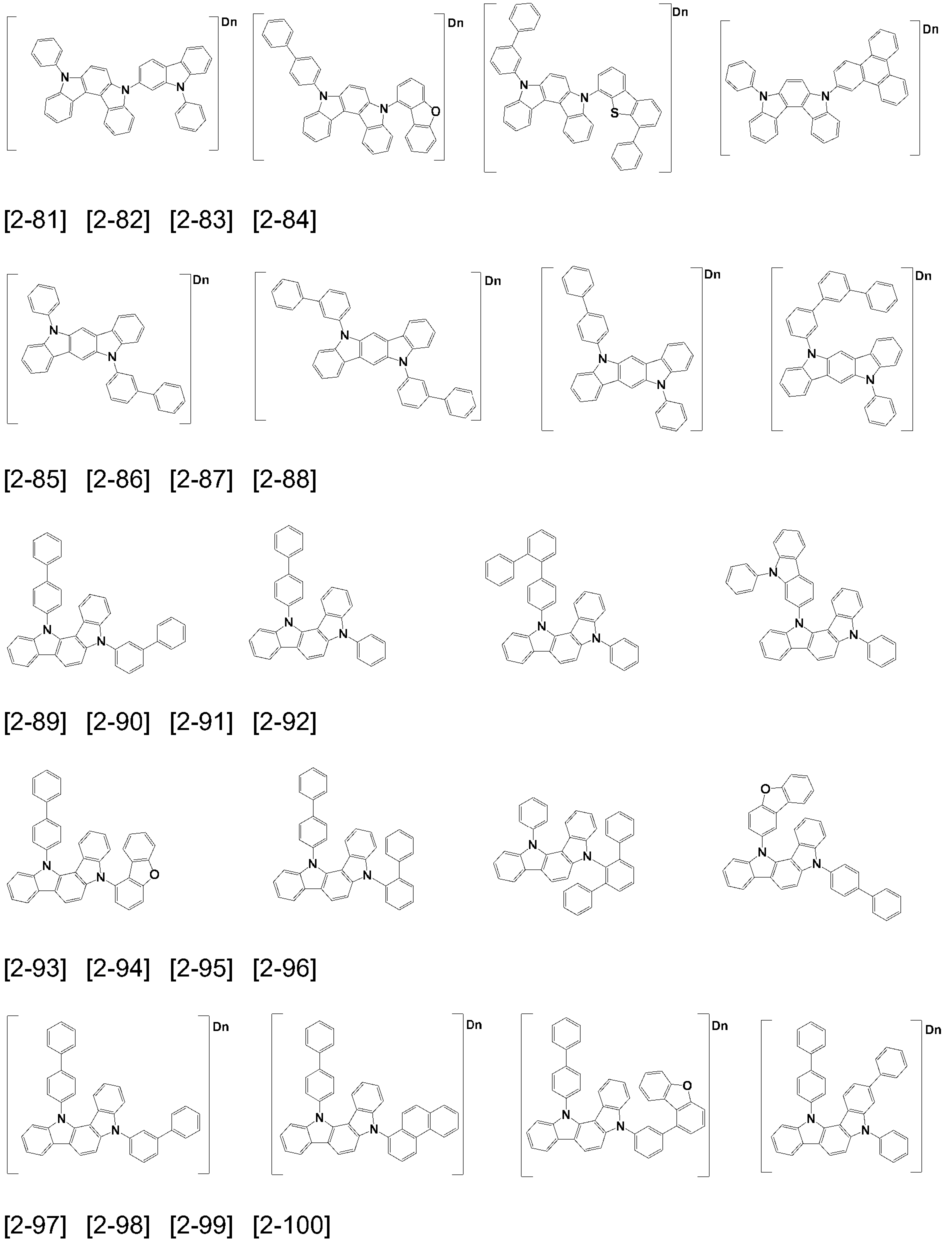

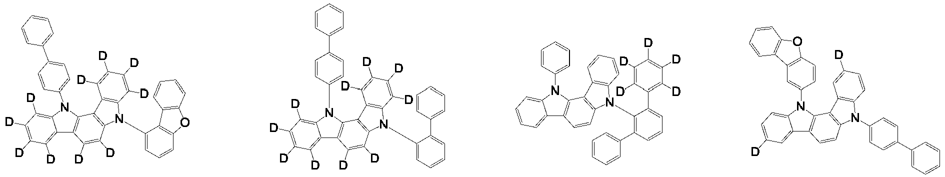

The first compound and the second compound may be included in a weight ratio of, for example, 1:99 to 99:1. Within the above range, an appropriate weight ratio may be adjusted using electron transport ability of the first compound and hole transport ability of the second compound to implement bipolar characteristics, thereby improving efficiency and life-span. Within the above range, they may be included in a weight ratio of, for example, about 10:90 to 90:10, about 20:80 to 80:20, and for example, they may be included in a weight ratio of, for example, about 20:80 to about 70:30, about 20:80 to about 60:40, and about 30:70 to about 60:40. As a specific example, they may be included in a weight ratio of 40:60, 50:50, or 60:40.

The dopant may be, for example, a phosphorescent dopant, for example a red, green or blue phosphorescent dopant, for example a red or green phosphorescent dopant.

The dopant is a material mixed with the compound or composition for the organic optoelectronic device in a small amount to cause light emission and may be generally a material such as a metal complex that emits light by multiple excitation into a triplet or more. The dopant may be, for example an inorganic, organic, or organic/inorganic compound, and one or more types thereof may be used.

Examples of the dopant may be a phosphorescent dopant and examples of the phosphorescent dopant may be an organic metal compound including Ir, Pt, Os, Ti, Zr, Hf, Eu, Tb, Tm, Fe, Co, Ni, Ru, Rh, Pd, or a combination thereof. The phosphorescent dopant may be, for example a compound represented by Chemical Formula Z, but is not limited thereto.

[Chemical Formula Z] L⁶MX²

In Chemical Formula Z, M is a metal, and L⁶ and X² are the same or different, and are ligands to form a complex compound with M.

The M may be for example Ir, Pt, Os, Ti, Zr, Hf, Eu, Tb, Tm, Fe, Co, Ni, Ru, Rh, Pd, or a combination thereof, and L⁶ and X² may be, for example bidentate ligands.

Examples of ligands represented by L⁶ and X² may be selected from the chemical formulas listed in Group A, but are not limited thereto.

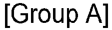

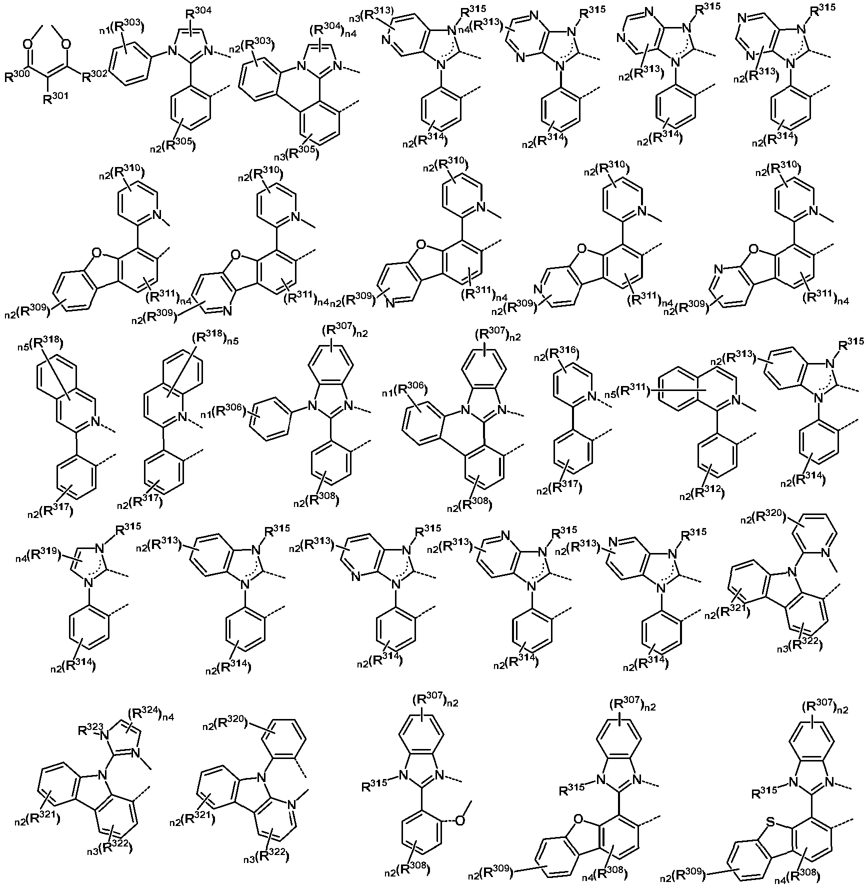

In Group A,
R³⁰⁰ to R³⁰² are each independently hydrogen, deuterium, a C1 to C30 alkyl group that is substituted or unsubstituted with a halogen, a C6 to C30 aryl group that is substituted or unsubstituted with a C1 to C30 alkyl, or a halogen, and
R³⁰³ to R³²⁴ are each independently hydrogen, deuterium, halogen, a substituted or unsubstituted C1 to C30 alkyl group, a substituted or unsubstituted C1 to C30 alkoxy group, a substituted or unsubstituted C3 to C30 cycloalkyl group, a substituted or unsubstituted C2 to C30 alkenyl group, a substituted or unsubstituted C6 to C30 aryl group, a substituted or unsubstituted C1 to C30 heteroaryl group, a substituted or unsubstituted C1 to C30 amino group, a substituted or unsubstituted C6 to C30 arylamino group, SF₅, a trialkylsilyl group having a substituted or unsubstituted C1 to C30 alkyl group, a dialkylarylsilyl group having a substituted or unsubstituted C1 to C30 alkyl group and a C6 to C30 aryl group, or a triarylsilyl group having a substituted or unsubstituted C6 to C30 aryl group.

In an embodiment, the dopant may be an iridium complex, and may be represented by Chemical Formula 6-1 or Chemical Formula 6-2.

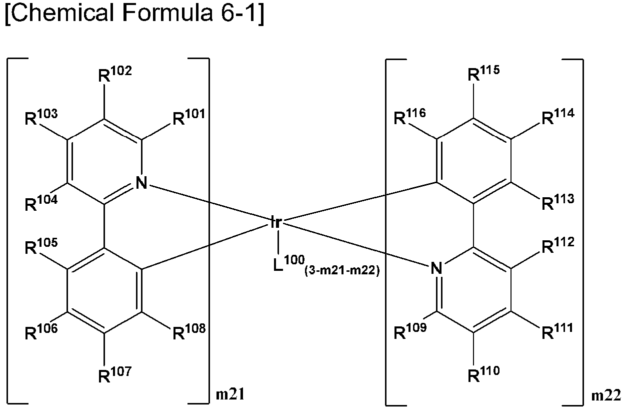

In Chemical Formula 6-1,
R¹⁰¹ to R¹¹⁶ are each independently hydrogen, deuterium, a substituted or unsubstituted C1 to C10 alkyl group, a substituted or unsubstituted C6 to C20 aryl group, or -SiR¹³²R¹³³R¹³⁴,
R¹³² to R¹³⁴ are each independently a substituted or unsubstituted C1 to C6 alkyl group,
one or more of R¹⁰¹ to R¹¹⁶ is a functional group represented by Chemical Formula V-1,
L¹⁰⁰ is a bidentate ligand of a monovalent anion, and is a ligand that coordinates to iridium through a lone pair of carbons or heteroatoms, and
m21 and m22 are each independently any one of integers of 0 to 3, and m21 + m22 is any one of integers of 1 to 3, 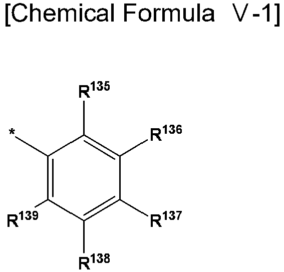
wherein, in Chemical Formula V-1,
R¹³⁵ to R¹³⁹ are each independently hydrogen, deuterium, a substituted or unsubstituted C1 to C10 alkyl group, a substituted or unsubstituted C6 to C20 aryl group, or -SiR¹³²R¹³³R¹³⁴, and
* refers to a portion linked to a carbon atom.

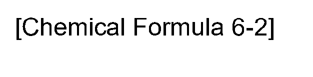

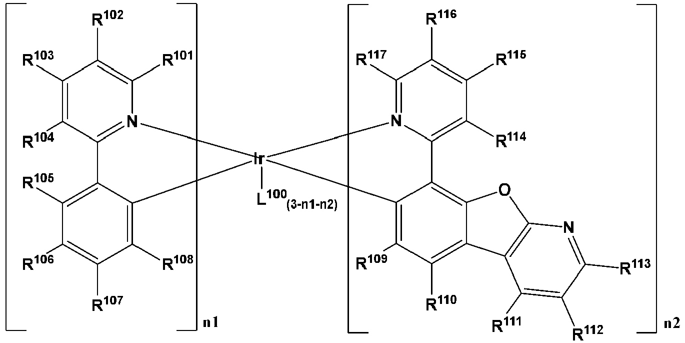

In Chemical Formula 6-2,
R¹⁰¹ to R¹¹⁷ are each independently hydrogen, deuterium, a substituted or unsubstituted C1 to C10 alkyl group, a substituted or unsubstituted C6 to C20 aryl group, or -Si R¹³³R¹³⁴R¹³⁵,
R¹³³ to R¹³⁵ are each independently a substituted or unsubstituted C1 to C6 alkyl group,
L¹⁰⁰ is a bidentate ligand of a monovalent anion, and is a ligand that coordinates to iridium through a lone pair of carbons or heteroatoms, and
n1 and n2 are independently any integer from 0 to 3, and n1 + n2 is any one of integers of 1 to 3.

In another embodiment, the dopant may be a platinum complex, and may be for example represented by Chemical Formula Z-1.

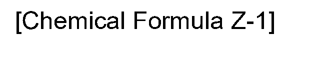

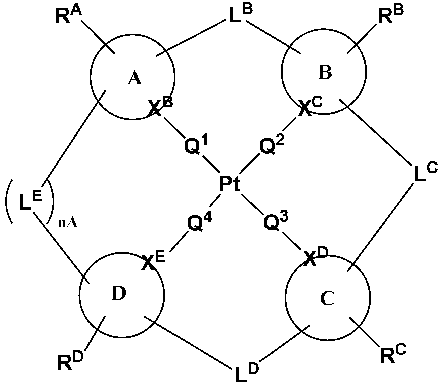

In Chemical Formula Z-1, rings A, B, C, and D independently represent a 5-membered or 6-membered carbocyclic or heterocyclic ring;
R^{A}, R^{B}, R^{C}, and R^{D} independently represent mono-, di-, tri-, or tetra-substitution, or unsubstitution;
L^{B}, L^{C}, and L^{D} are each independent selected from a direct bond, BR, NR, PR, O, S, Se, C=O, S=O, SO₂, CRR', SiRR', GeRR', and a combination thereof;
when nA is 1, L^{E} is selected from a direct bond, BR, NR, PR, O, S, Se, C=O, S=O, SO₂, CRR', SiRR', GeRR', and a combination thereof; when nA is 0, L^{E} does not exist; and
R^{A}, R^{B}, R^{C}, R^{D}, R, and R' are each independently selected from hydrogen, deuterium, a halogen, alkyl group, a cycloalkyl group, a heteroalkyl group, an arylalkyl group, an alkoxy group, an aryloxy group, an amino group, a silyl group, an alkenyl group, a cycloalkenyl group, a heteroalkenyl group, an alkynyl group, an aryl group, a heteroaryl group, an acyl group, a carbonyl group, a carboxylic acid group, an ester group, a nitrile group, an isonitrile group, a sulfanyl group, a sulfinyl group, a sulfonyl group, a phosphino group, and a combination thereof; any adjacent R^{A}, R^{B}, R^{C}, R^{D}, R, and R' are optionally linked to each other to provide a ring; X^{B}, X^{C}, X^{D}, and X^{E} are each independently selected from carbon and nitrogen; and Q¹, Q², Q³, and Q⁴ each represent oxygen or a direct bond.

The platinum complex may be represented, for example, by Chemical Formula 7-1 or Chemical Formula 7-2.

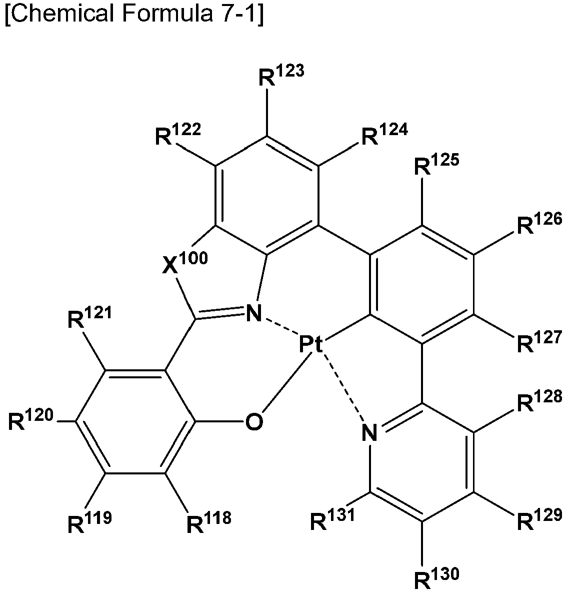

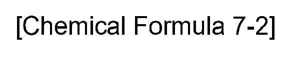

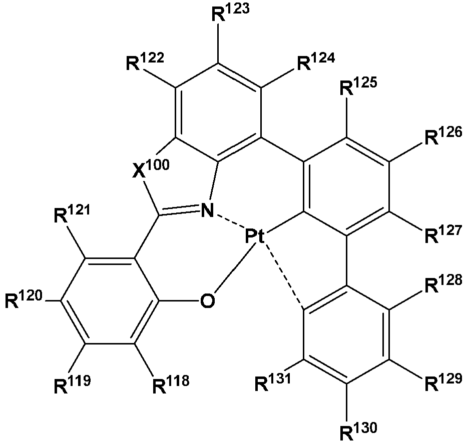

In Chemical Formula 7-1 and Chemical Formula 7-2,
X¹⁰⁰ is selected from O, S, and NR¹³²,
R¹¹⁸ to R¹³² are each independently hydrogen, deuterium, a substituted or unsubstituted C1 to C10 alkyl group, a substituted or unsubstituted C6 to C20 aryl group, or - SiR¹³³R¹³⁴R¹³⁵,
R¹³³ to R¹³⁵ are each independently a substituted or unsubstituted C1 to C6 alkyl group,
one or more of R¹¹⁸ to R¹³² is -SiR¹³³R¹³⁴R¹³⁵ or a tert-butyl group, and
R¹³³ to R¹³⁵ are each independently a substituted or unsubstituted C1 to C6 alkyl group.

The organic layer may further include a charge transport region in addition to the light emitting layer.

The charge transport region may be, for example, a hole transport region 140.

The hole transport region 140 may further increase hole injection and/or hole mobility between the anode 120 and the light emitting layer 130 and block electrons.

Specifically, the hole transport region 140 may include a hole transport layer between the anode 120 and the light emitting layer 130, and a hole transport auxiliary layer between the light emitting layer 130 and the hole transport layer, and one or more of the compounds listed in Group B may be included in at least one layer of the hole transport layer and the hole transport auxiliary layer. 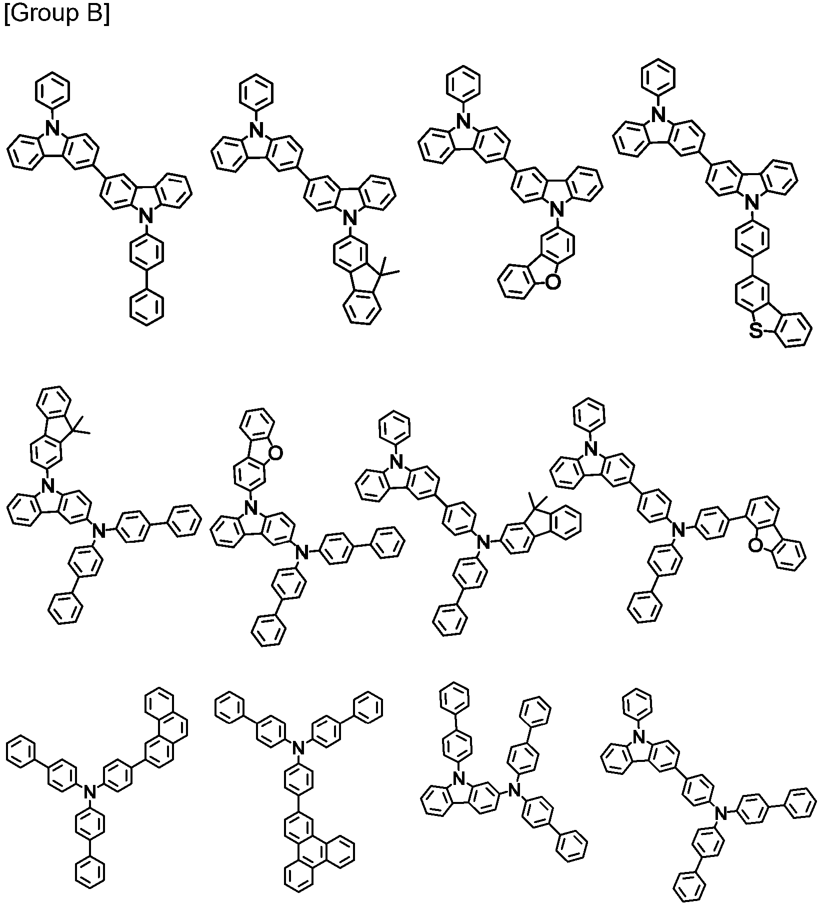 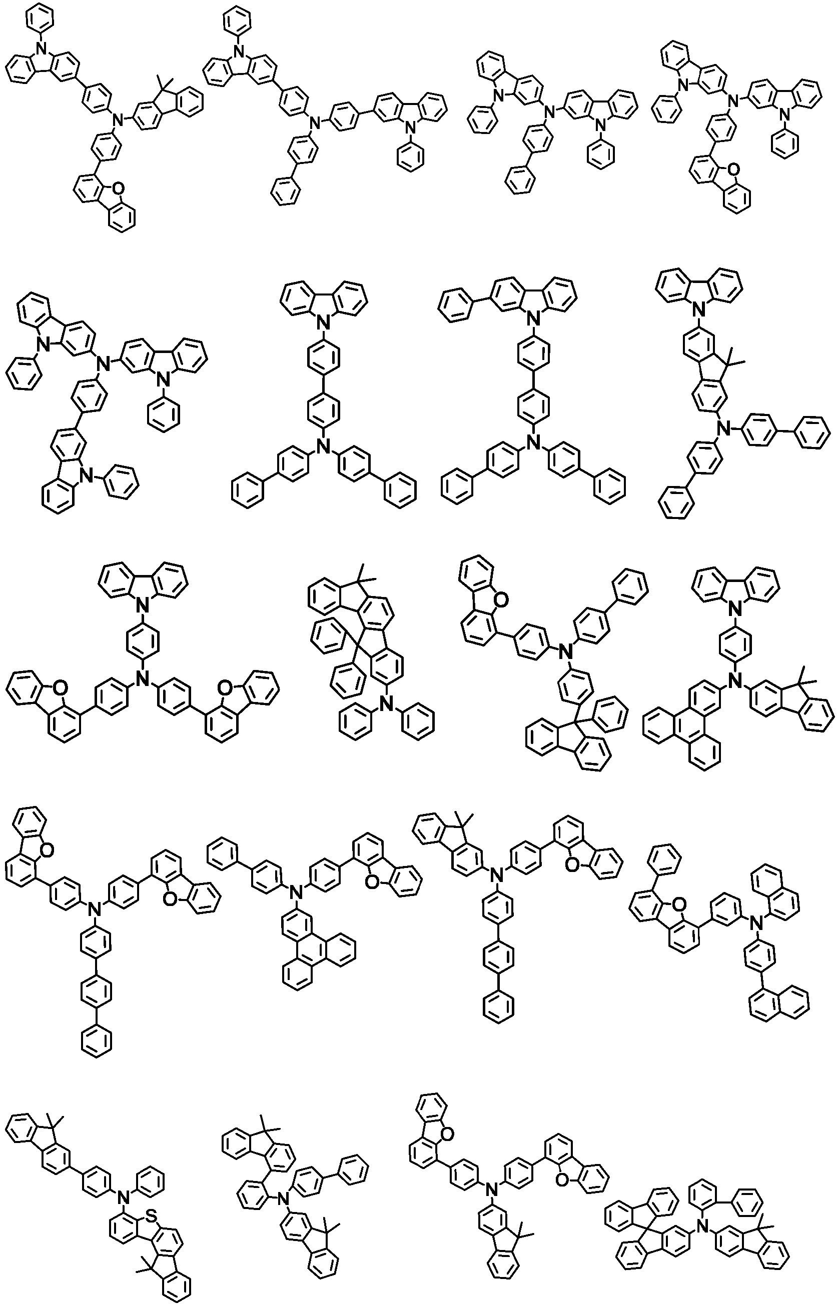 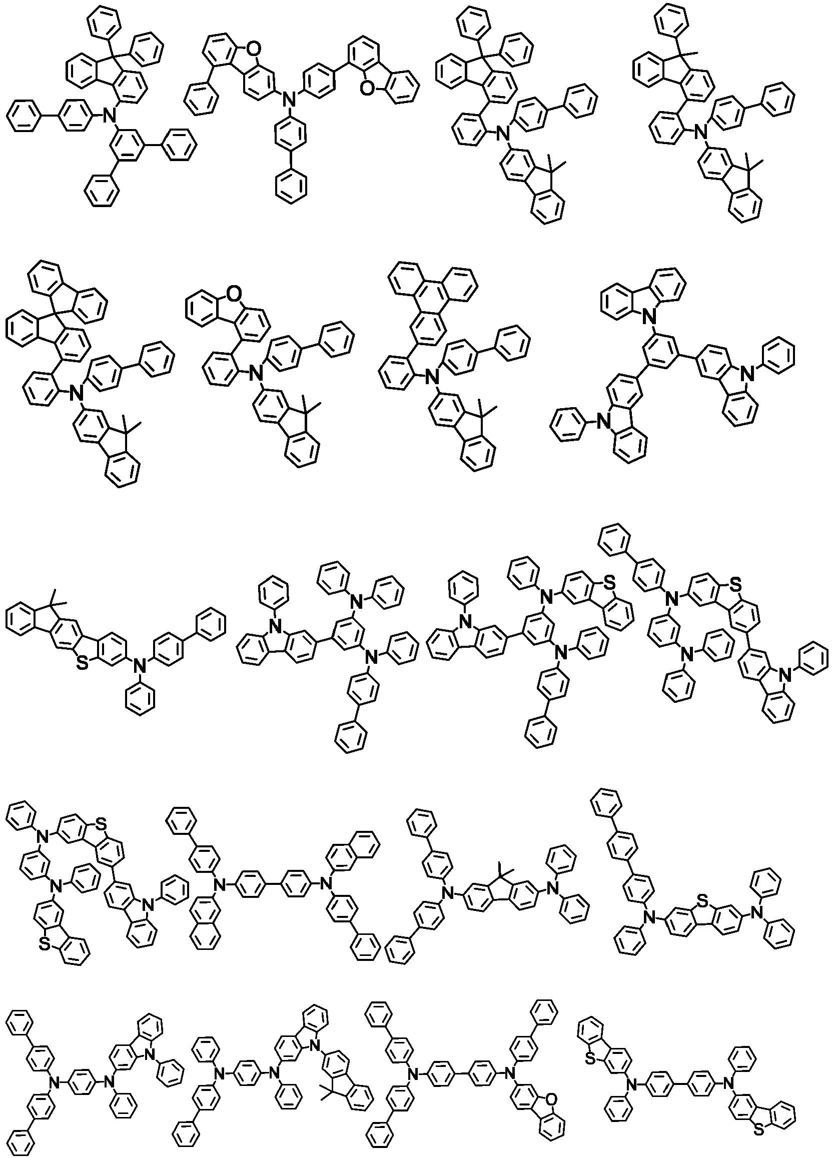 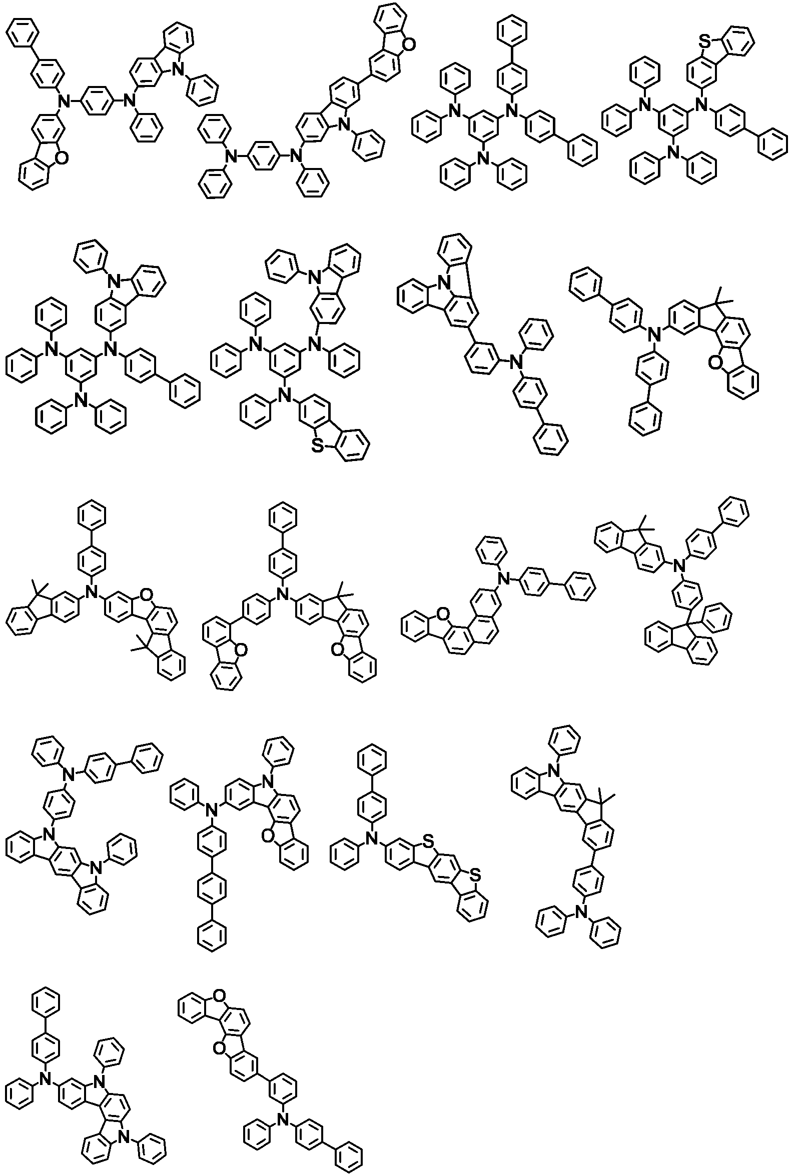 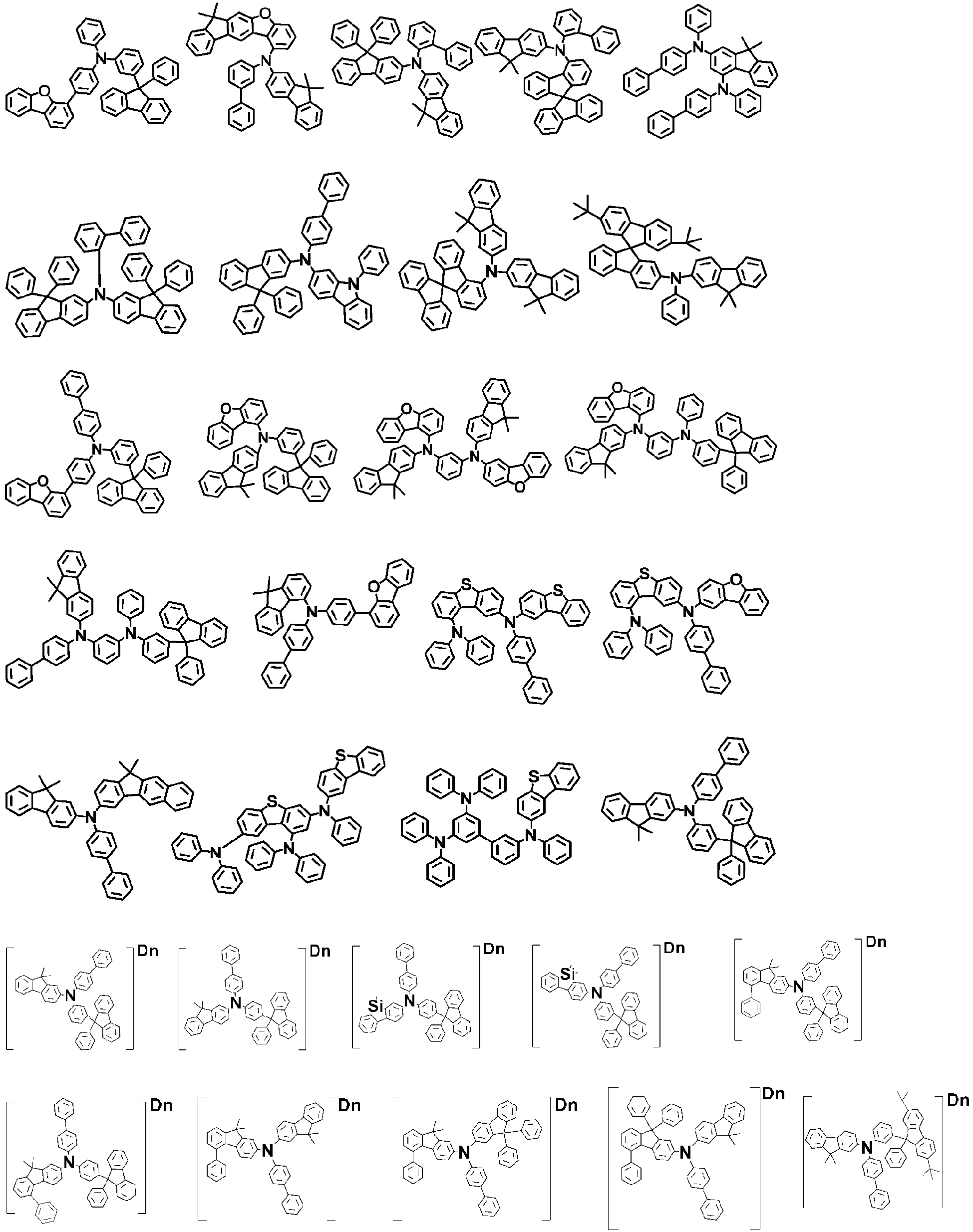 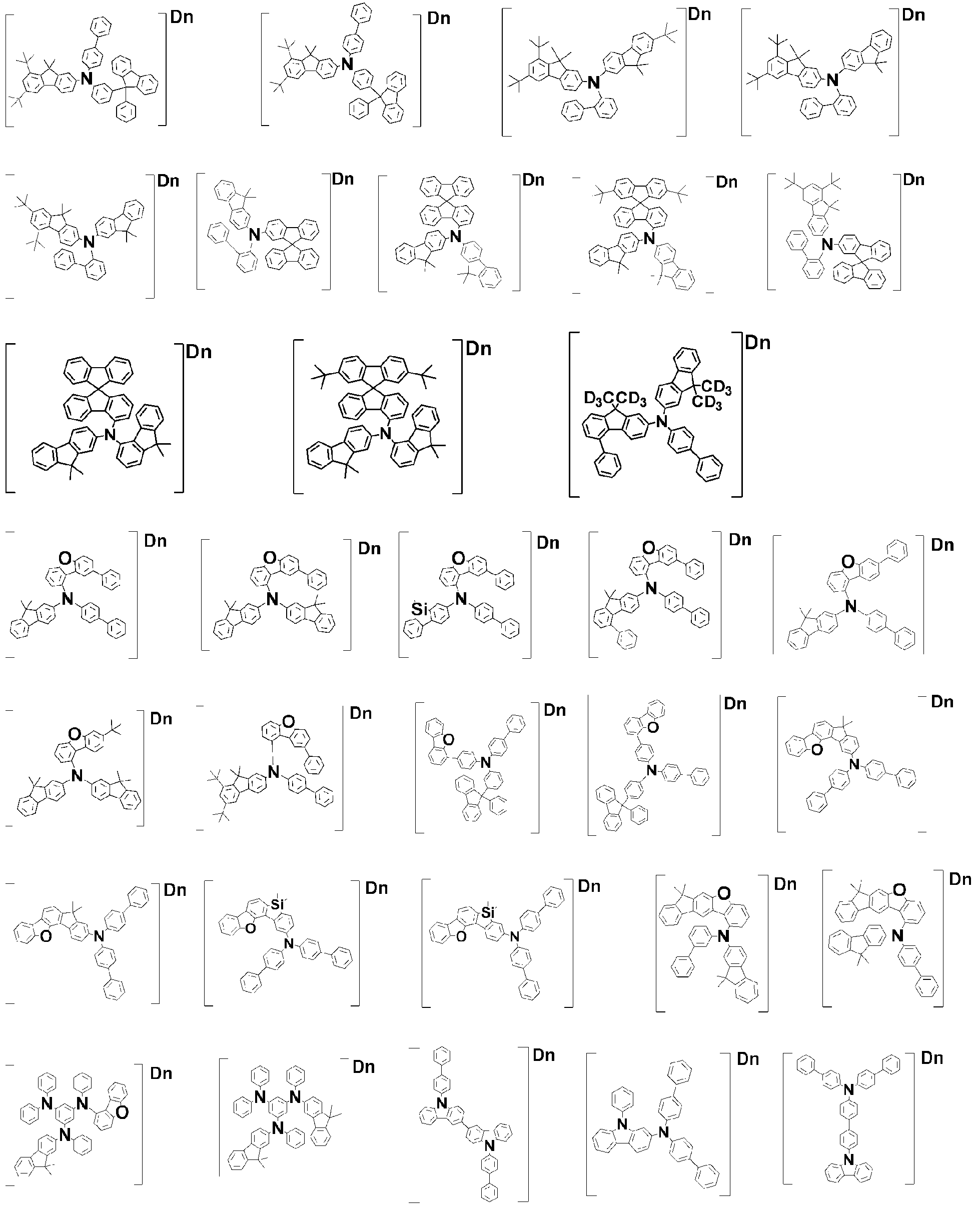 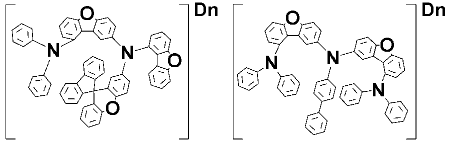 (Dn refers to the number of deuterium substitutions and indicates a structure substituted with one or more deuteriums)

In the hole transport region 140, in addition to the compounds described above, known compounds disclosed in US5061569A, JP1993-009471A, WO1995-009147A1, JP1995-126615A, JP1998-095973A, etc. and compounds having a similar structure may also be used.

Also, the charge transport region may be, for example, the electron transport region 150.

The electron transport region 150 may further increase electron injection and/or electron mobility and block holes between the cathode 110 and the light emitting layer 130.

Specifically, the electron transport region 150 may include an electron transport layer between the cathode 110 and the light emitting layer 130, and an electron transport auxiliary layer between the light emitting layer 130 and the electron transport layer.

The electron transport layer may include a third compound represented by Chemical Formula 4.

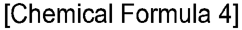

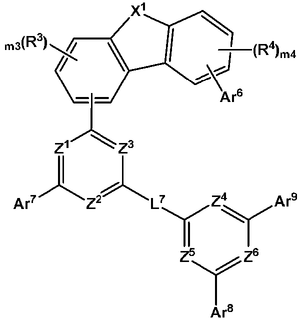

In Chemical Formula 4,
X¹ is O or S,
Z¹ to Z⁶ are each independently N or CR^{b},
at least two of Z¹ to Z³ are N,
at least two of Z⁴ to Z⁶ are N,
L⁷ is a substituted or unsubstituted phenylene group or a substituted or unsubstituted biphenylene group,
Ar⁶ to Ar⁹ are each independently a substituted or unsubstituted C6 to C30 aryl group,
R^{b} and R³ to R⁶ are each independently hydrogen, deuterium, a cyano group, a halogen, a substituted or unsubstituted C1 to C30 alkyl group, a substituted or unsubstituted C6 to C30 aryl group, or a substituted or unsubstituted C2 to C30 heterocyclic group,
m3 and m4 are each independently one of integers of 1 to 3, and
m5 and m6 are each independently one of integers of 1 to 4.

For example, Ar⁶ may be a substituted or unsubstituted phenyl group, and Ar⁷ to Ar⁹ may each independently be a substituted or unsubstituted C6 to C12 aryl group.

L⁷ may be one selected from the linking groups listed in Group III.

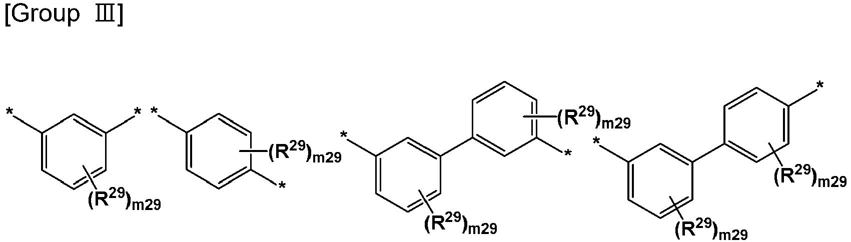

In Group III,
R²⁹ is hydrogen, deuterium, a cyano group, a substituted or unsubstituted C1 to C10 alkyl group, a substituted or unsubstituted C6 to C12 aryl group, or a substituted or unsubstituted C2 to C20 heteroaryl group,
m29 is one of integers of 1 to 4,
* is a linking point.

When m29 is 2 or more, each R²⁹ may be the same or different form each other.

In a most specific embodiment, the third compound represented by Chemical Formula 4 may be one selected from the compounds listed in Group 3, but is not limited thereto.

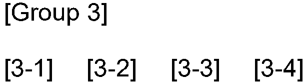

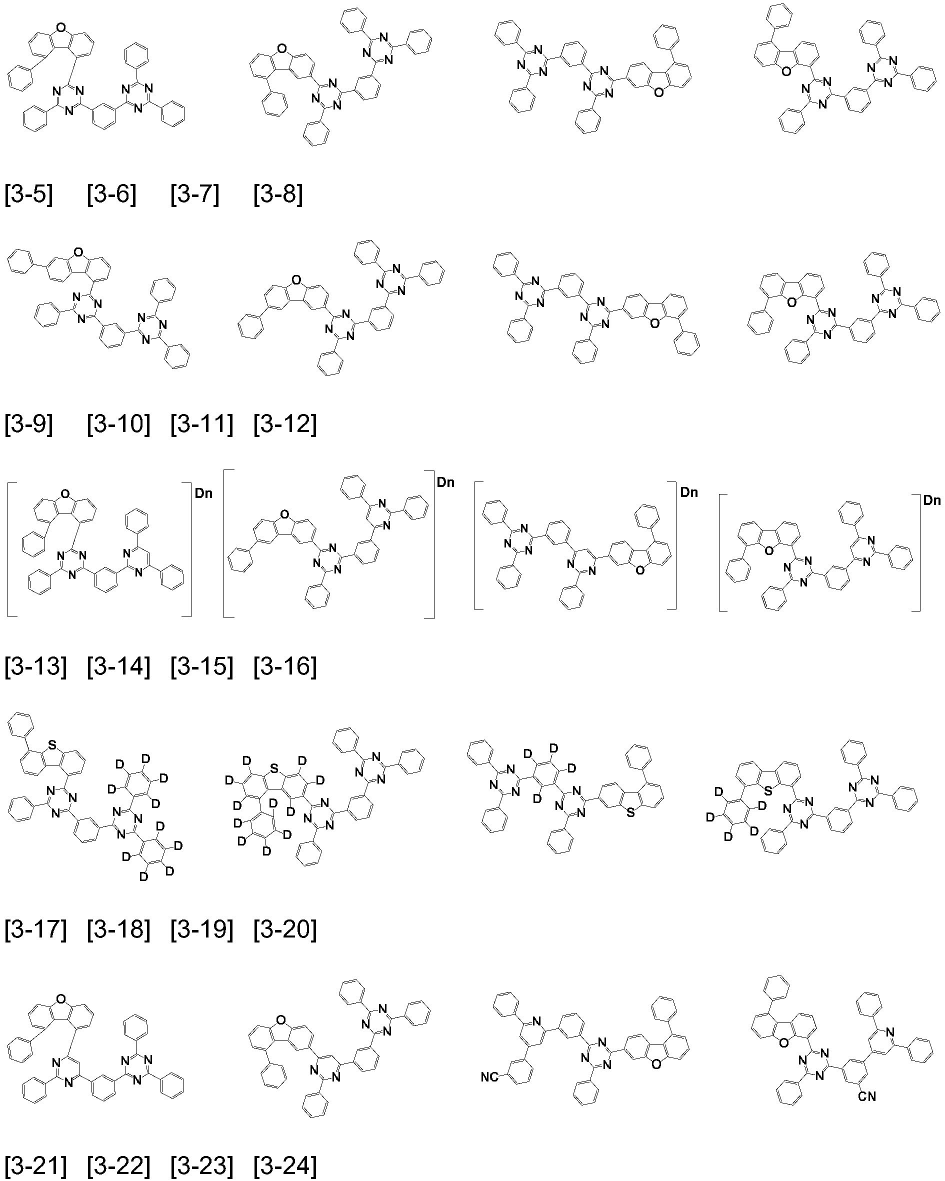

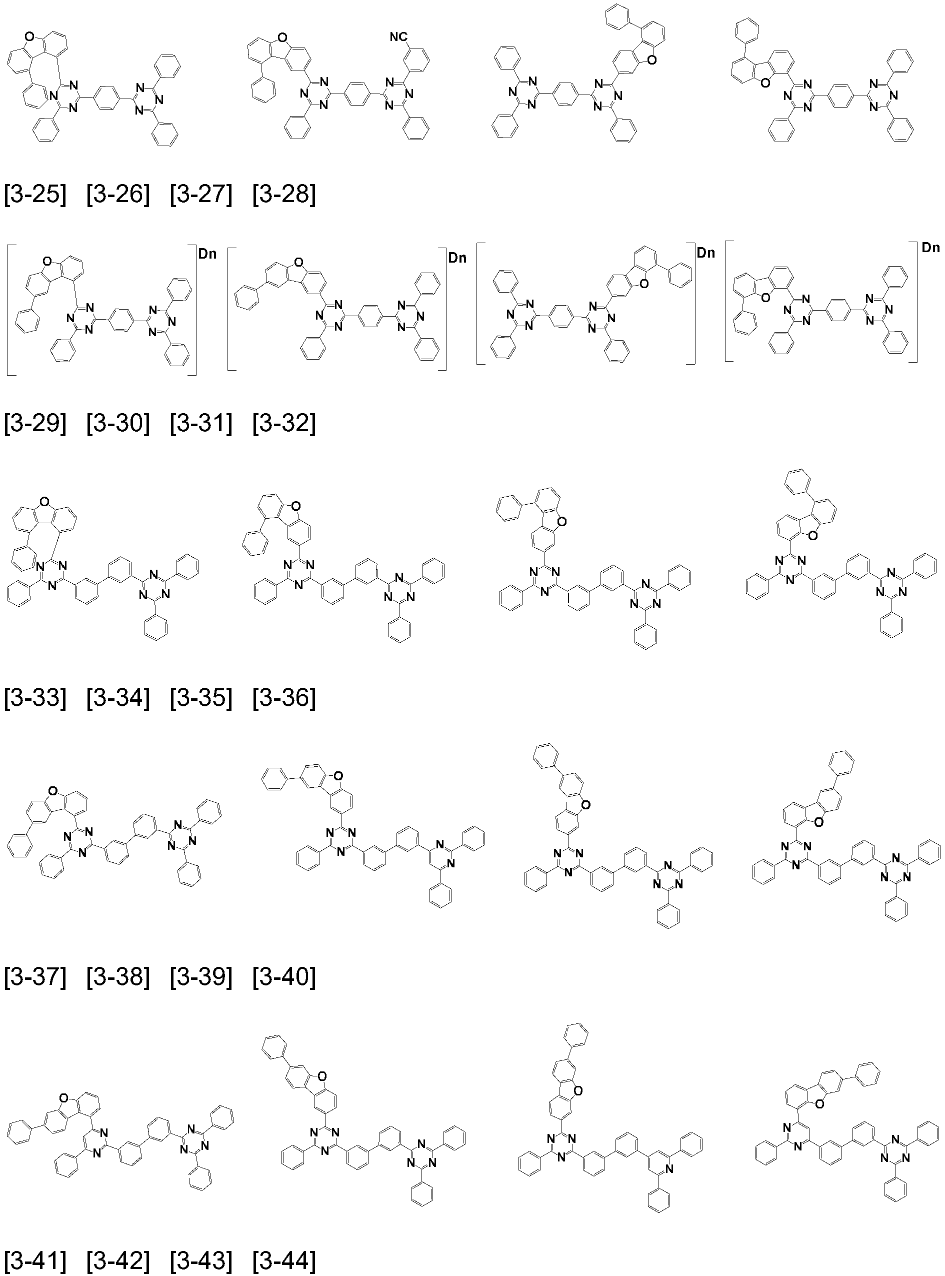

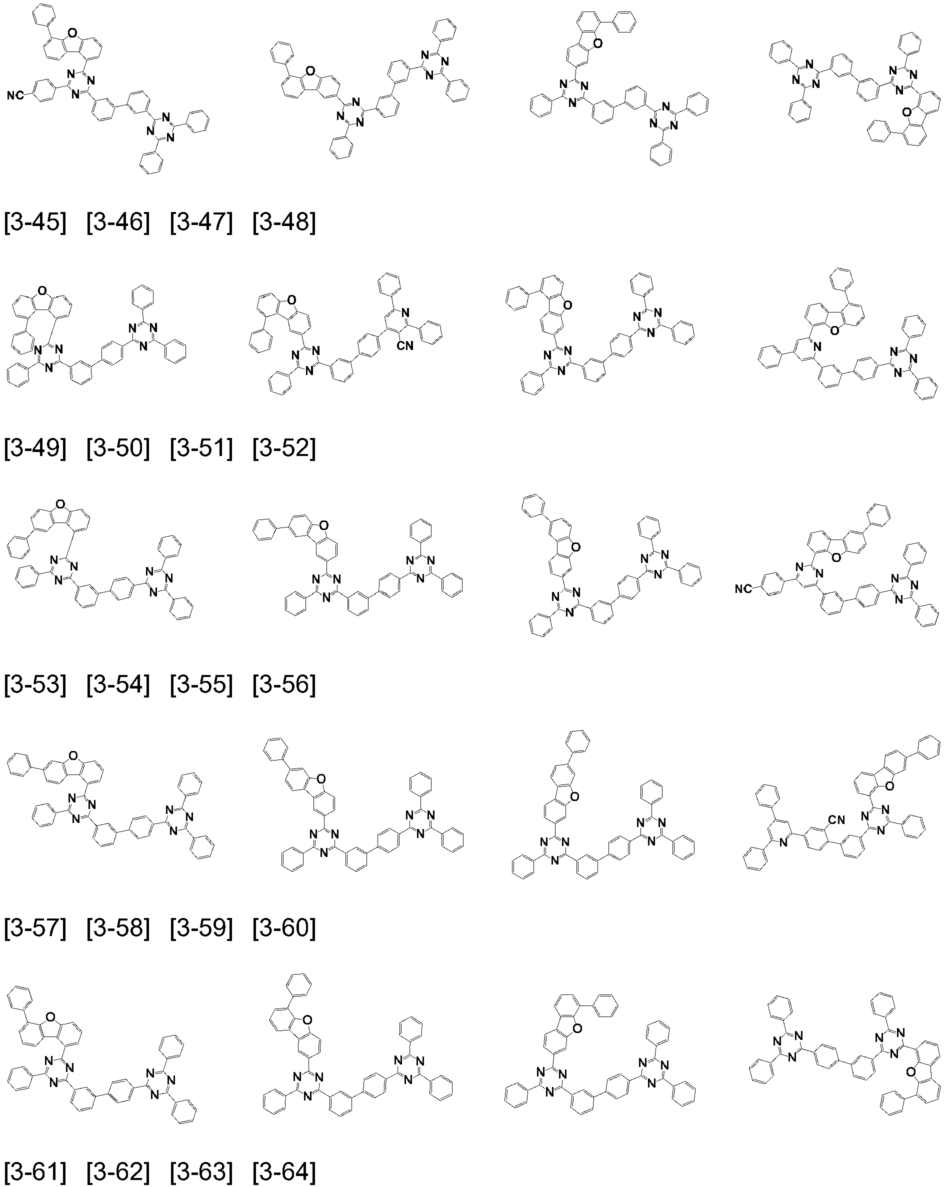

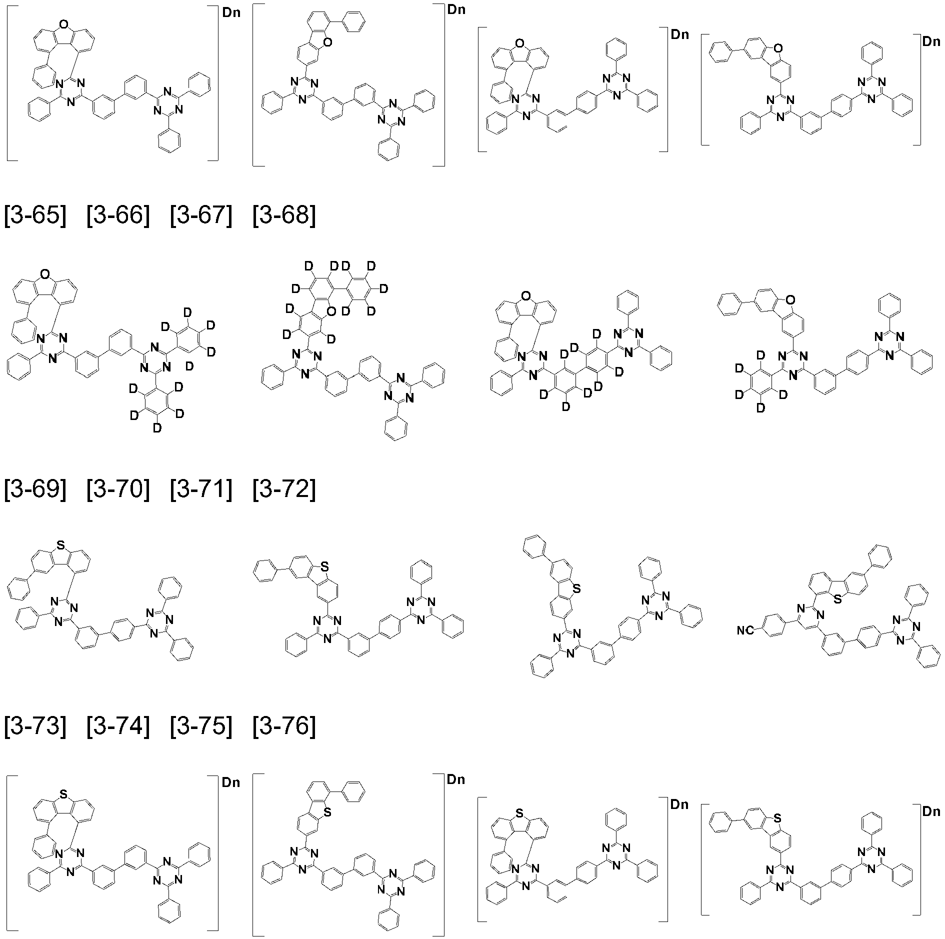

Because the third compound represented by Chemical Formula 4 has a relatively high T1 energy, when included in the electron transport layer, it may effectively prevent back-energy transfer to effectively inhibit excitons formed in the light emitting layer. Further, by having a DBX substituent, LUMO electron clouds are stably distributed, thereby increasing molecular stability when used as the electron transport layer. When such a compound is used as the electron transport layer, electron transport effectively occurs, so that device characteristics may be improved. In particular, the molecular structure itself is stable and excitons of the light emitting layer may be effectively inhibited, so that life-span characteristics may be improved.

Meanwhile, the second compound represented by a combination of Chemical Formula 2 and Chemical Formula 3 has a shallow HOMO energy level, so hole injection and transport capability are increased, thereby improving device characteristics when used in the light emitting layer together with the first compound. Because the second compound has excellent hole injection and transport capability, the emission zone moves relatively toward the electron transport layer, and thus there is a possibility that the device life-span may be reduced due to interface degradation between the light emitting layer and the electron transport layer. When used in combination with the third compound in the electron transport layer, interface degradation may be effectively prevented to prevent life-span reduction while simultaneously improving low-driving and high-efficiency characteristics.

In a most specific embodiment, the first compound is represented by Chemical Formula 1-V, and the second compound may be represented by Chemical Formula 3C.

The electron transport auxiliary layer may include one or more of the compounds listed in Group C below.

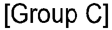

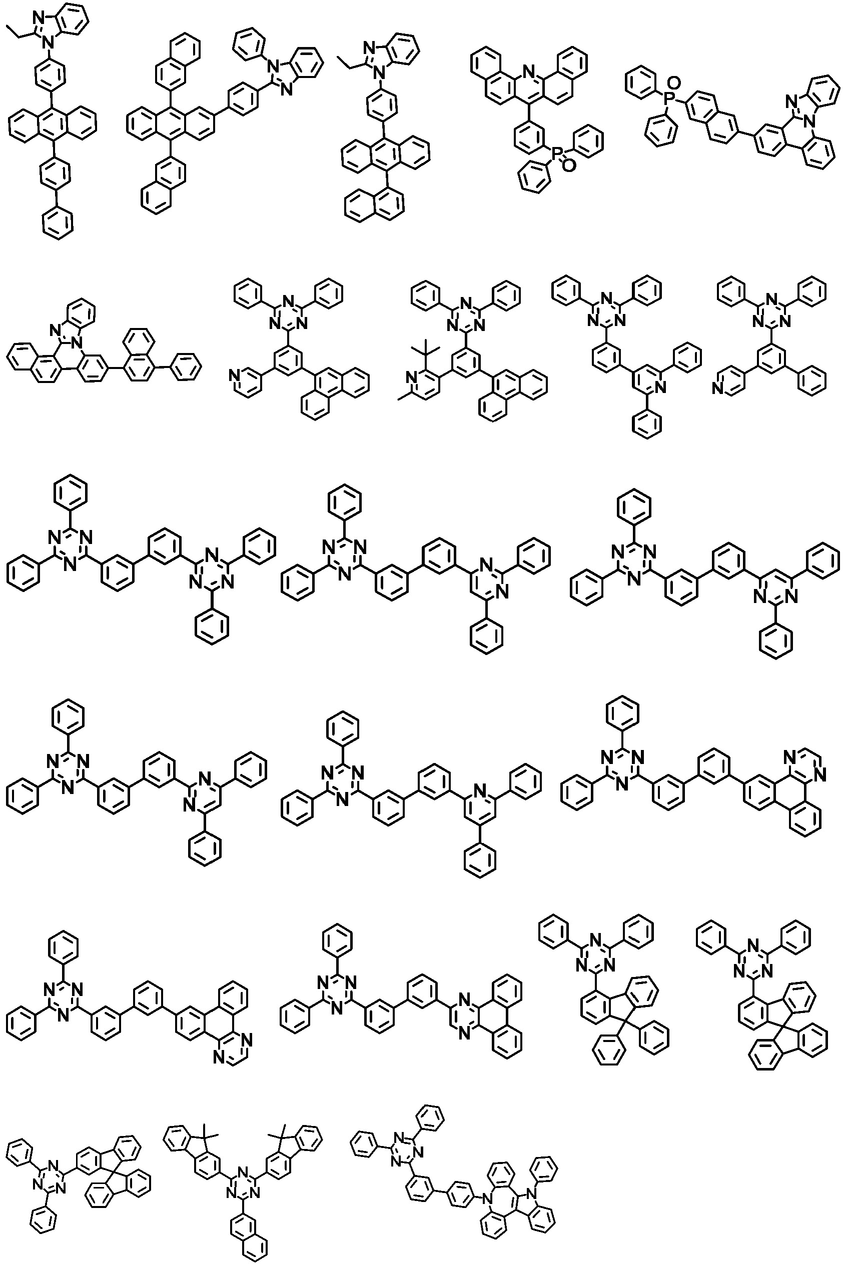

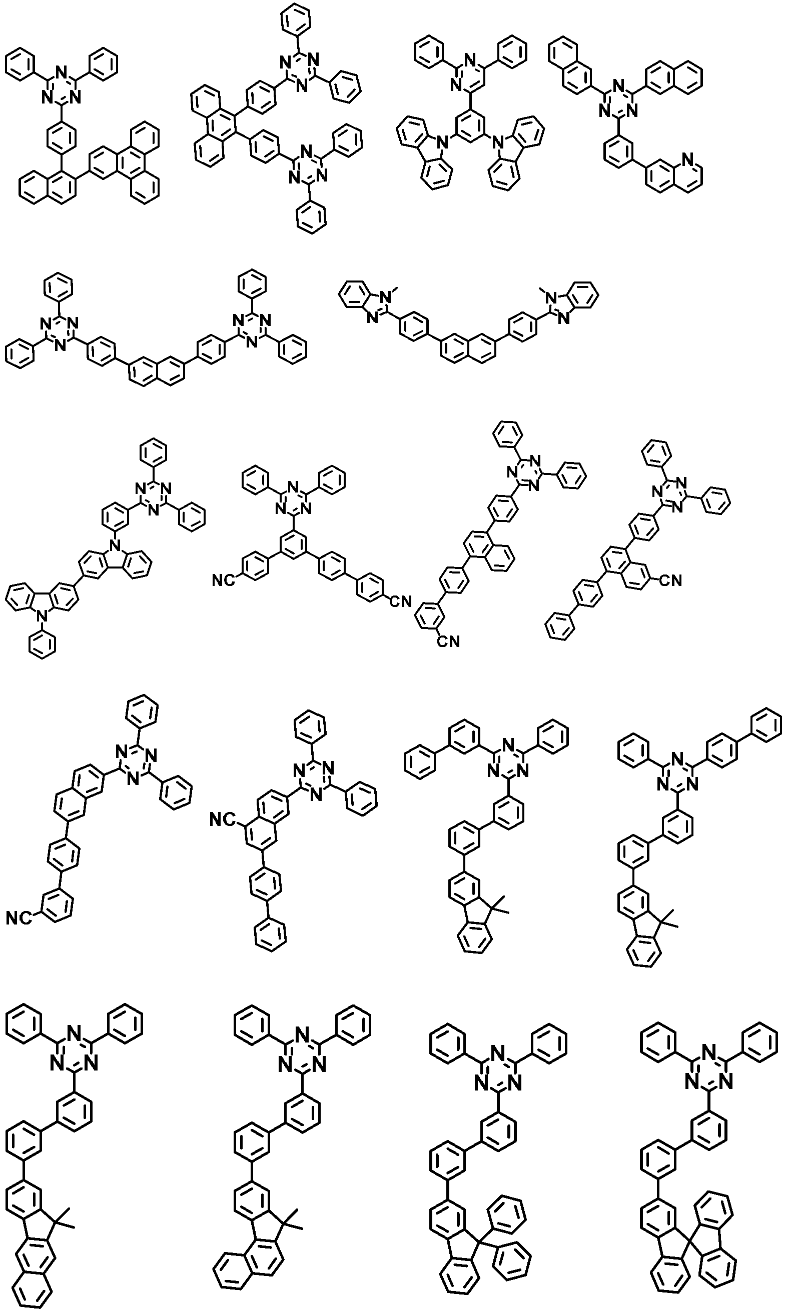

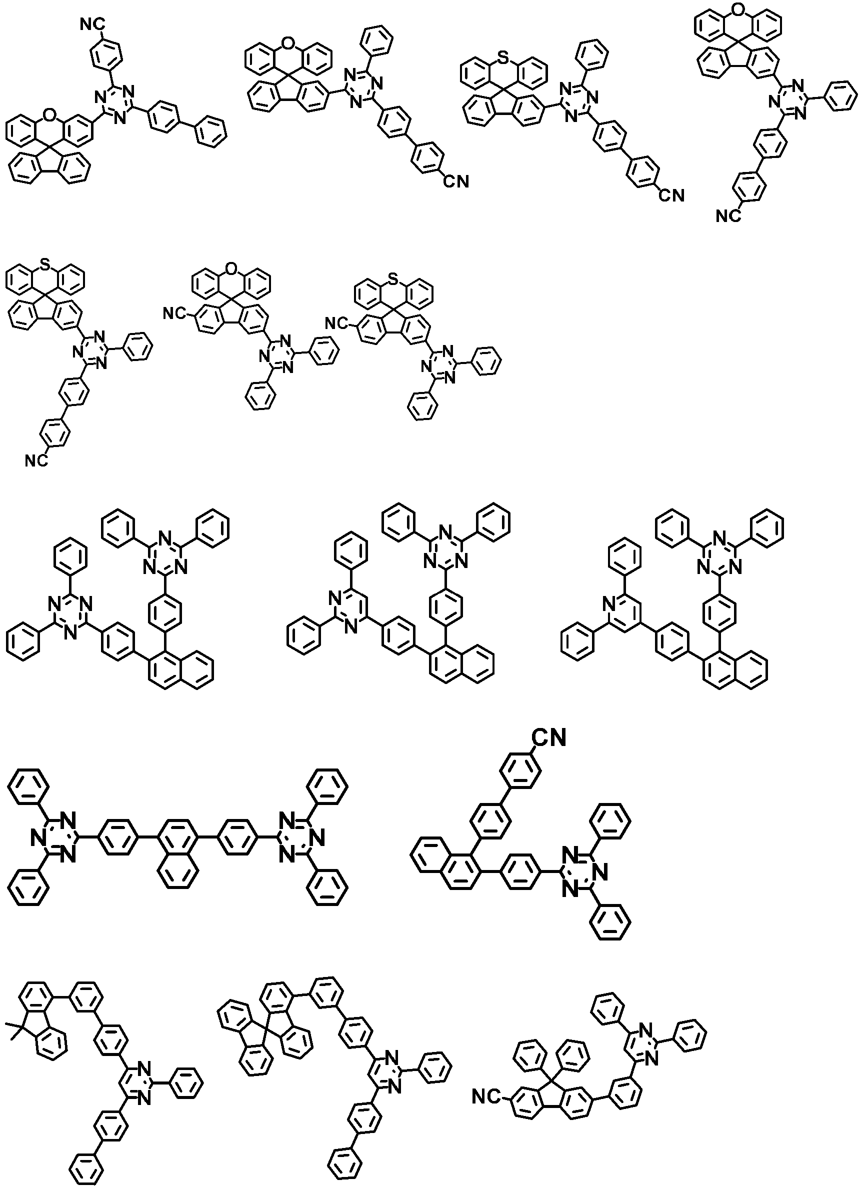

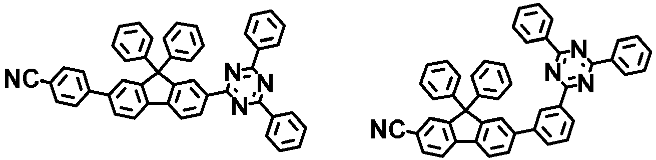

Another embodiment of the present invention may provide an organic light emitting diode including a hole transport region 140 and an electron transport region 150 in addition to the light emitting layer 130 as the organic layer 105, as shown in FIG. 1.

Meanwhile, an organic light emitting diode may further include an electron injection layer (not shown), a hole injection layer (not shown), etc. in addition to the light emitting layer as the organic layer.

The organic light emitting diodes 100 may be manufactured by forming an anode or a cathode on a substrate, and then forming an organic layer by a dry film method such as vacuum deposition, sputtering, plasma plating and ion plating, and forming a cathode or an anode thereon.

The organic light emitting diode may be applied to an organic light emitting display device.

### [Mode for Invention]

Hereinafter, the embodiments are illustrated in more detail with reference to examples. However, these examples are exemplary, and the present scope is not limited thereto.

Hereinafter, starting materials and reactants used in Examples and Synthesis Examples were purchased from Sigma-Aldrich Co. Ltd., TCI Inc., Tokyo chemical industry, or P&H tech as far as there is no particular comment or were synthesized by known methods.

### (Synthesis of Compound for Organic Optoelectronic Device)

### Synthesis of First Compound

### Synthesis Example 1: Synthesis of Compound 1-98

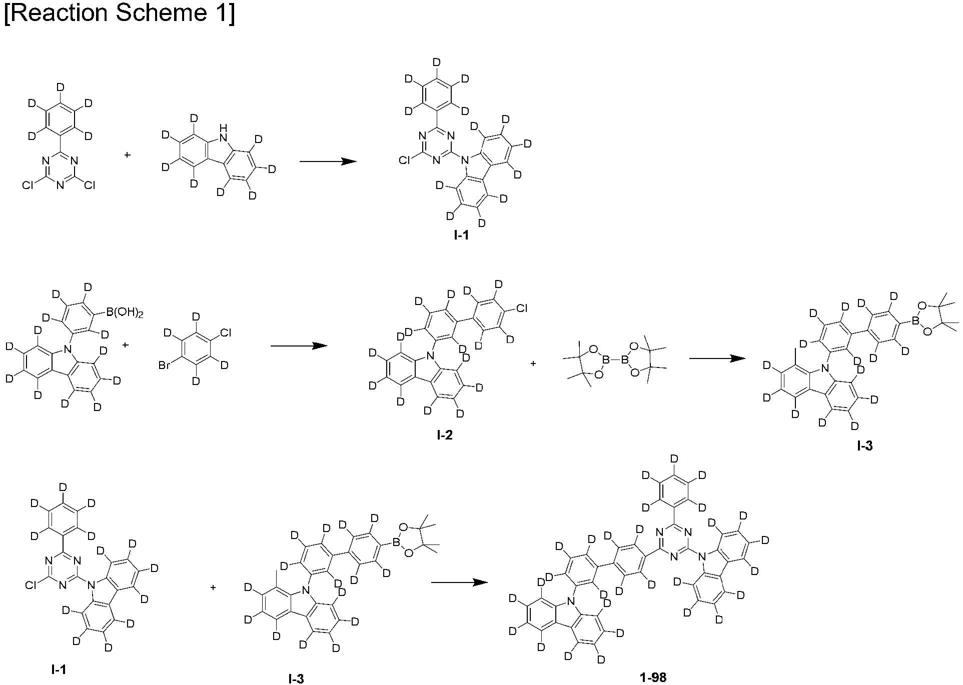

### 1st step: Synthesis of Intermediate I-1

Under nitrogen conditions, 2,4-dichloro-6-(phenyl-2,3,4,5,6-d5)-1,3,5-triazine (59.3 g, 256 mmol) and 9H-carbazole-1,2,3,4,5,6,7,8-d8 (30 g, 171 mmol) were dissolved in 500 ml of tetrahydrofuran, and then sodium tert-butoxide (18.1 g, 188 mmol) was slowly added at 0 °C and stirred. After 12 hours, water was added to the reaction solution and the mixture was filtered. The residue thus obtained was separated and purified by flash column chromatography to obtain Intermediate I-1 (50 g, 79%).

### 2nd step: Synthesis of Intermediate I-2

Under nitrogen conditions, (3-(9H-carbazol-9-yl-d8)phenyl-2,4,5,6-d4)boronic acid (30.6 g, 102 mmol) and 1-bromo-4-chlorobenzene-2,3,5,6-d4 (20 g, 102 mmol) were added and dissolved by adding 300 ml of tetrahydrofuran, and then 150 ml of an aqueous solution in which potassium carbonate (28.2 g, 204 mmol) was dissolved was added and stirred. After adding tetrakis(triphenylphosphine)palladium (3.54 g, 3.06 mmol) thereto, the mixture was heated and stirred under reflux at 80 °C for 12 hours. After completion of the reaction, the organic layer was extracted, moisture was removed with anhydrous magnesium sulfate, and the residue was filtered and concentrated under reduced pressure. The residue thus obtained was separated and purified by flash column chromatography to obtain Intermediate I-2 (35 g, 93%).

### 3rd step: Synthesis of Intermediate I-3

Under nitrogen conditions, Intermediate I-2 (35 g, 94.6 mmol) was dissolved in 500 ml of xylene, and then bis(pinacolato)diboron (28.8 g, 113 mmol), tris(dibenzylideneacetone)dipalladium(0) (0.87 g, 0.95 mmol), tricyclohexylphosphine (1.1 g, 3.8 mmol), and potassium acetate (27.8 g, 284 mmol) were added thereto, and the mixture was heated and stirred under reflux for 8 hours. After completion of the reaction, water was added to the reaction solution, extraction was performed with dichloromethane, moisture was removed with anhydrous magnesium sulfate, and the residue was filtered and concentrated under reduced pressure. The residue thus obtained was separated and purified by flash column chromatography to obtain Intermediate I-3 (30 g, 69%).

### 4th step: Synthesis of Intermediate I-4

Compound 1-98 (15 g, 83%) was obtained in the same manner as in Step 2 using Intermediate I-1 (10 g, 27 mmol) and Intermediate I-3 (12.5 g, 27 mmol).

### Synthesis Example 2: Synthesis of Compound 1-119

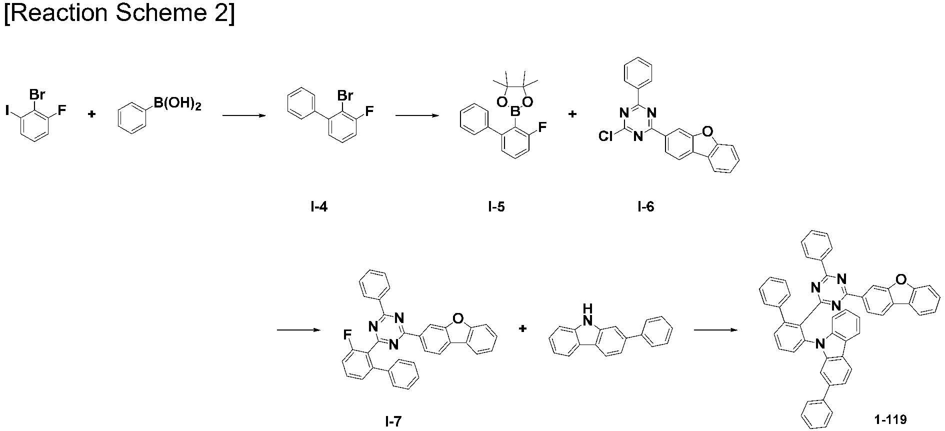

### 1st step: Synthesis of Intermediate I-4

Under nitrogen conditions, 2-bromo-1-fluoro-3-iodobenzene (50.0 g, 166.2 mmol), phenylboronic acid (22.3 g, 182.8 mmol), K₂CO₃ (45.9 g, 332.4 mmol), and Pd(PPh₃)₄ (9.6 g, 8.3 mmol) were placed in a round-bottom flask, dissolved in THF (350 ml) and distilled water (160 ml), and then stirred under reflux at 70°C for 6 hours. After the reaction was finished, the aqueous layer was removed and Intermediate I-4 (28.9 g, 69%) was obtained using column chromatography (Hexane:DCM (30%)).

### 2nd step: Synthesis of Intermediate I-5

Under nitrogen conditions, Intermediate I-4 (21.7 g, 105.0 mmol), bis(pinacolato)diboron (35.1 g, 138.1 mmol), potassium acetate (22.6 g, 230.2 mmol), and Pd(dppf)Cl₂ (4.7 g, 5.8 mmol) were placed in a round-bottom flask and dissolved in 380 ml of xylene. The mixture was stirred under reflux at 140 °C for 8 hours. After the reaction was finished, the mixture was cooled to room temperature, filtered to remove salt, and then an excess of DCM and distilled water were added and extraction was performed. Intermediate I-5 (20.6 g, 60%) was obtained using column chromatography (Hexane:DCM (30% to 50%)).

### 3rd step: Synthesis of Intermediate I-7

Under nitrogen conditions, Intermediate I-5 (20.6 g, 69.1 mmol), Intermediate I-6 (20.6 g, 57.6 mmol), K₂CO₃ (15.9 g, 115.2 mmol), and Pd(PPh₃)₄ (3.33 g, 2.88 mmol) were placed in a round-bottom flask, dissolved in THF (300 ml) and distilled water (60 ml), and then stirred under reflux at 70 °C for 6 hours. After the reaction was finished, the aqueous layer was removed and Intermediate I-7 (19.9 g, 70%) was obtained using column chromatography (Hexane:DCM (30%)).

### 4th step: Synthesis of Compound 1-119

Under nitrogen conditions, Intermediate I-7 (19.9 g, 40.3 mmol), 2-phenyl-9H-carbazole (19.6 g, 80.6 mmol), and K₃PO₄ (17.1 g, 80.6 mmol) were placed in a round-bottom flask, dissolved in DMF (130 ml), and then stirred under reflux at 150°C for 4 hours. After the reaction was finished, the reaction product was slowly added dropwise to an excess of water to precipitate a solid, and then the solid obtained by filtration was separated by column chromatography (Hexane:DCM (30%)) to obtain Compound 1-119 (17.9 g, 62%).

### Synthesis of Second Compound

### Synthesis Example 3: Synthesis of Compound 2-32

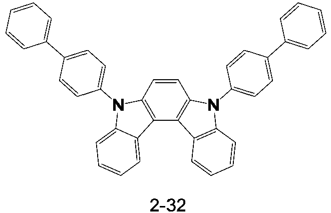

Compound 2-32 was synthesized by referring to the method disclosed in KR10-2072208.

### Synthesis Example 4: Synthesis of Compound R-1

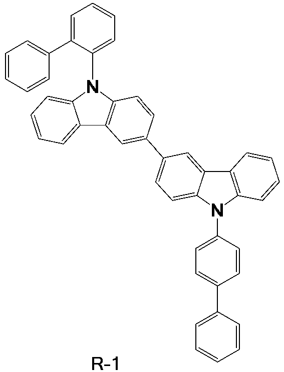

Compound R-1 was synthesized by referring to the method disclosed in KR10-1649683.

### Synthesis of Third Compound

### Synthesis Example 5: Synthesis of Compound 3-29

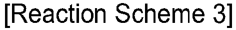

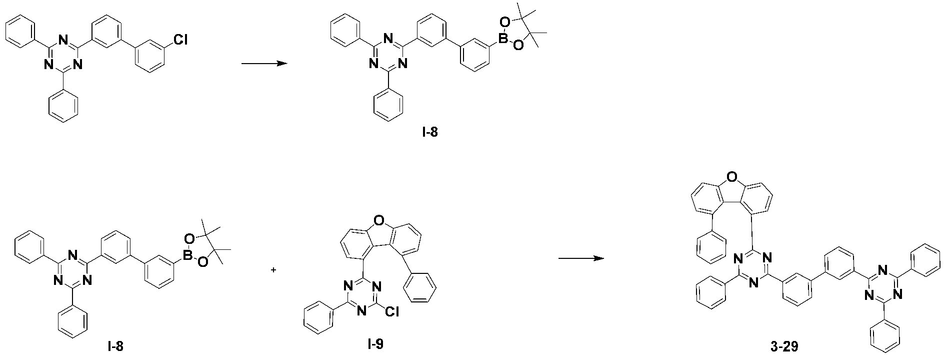

### 1st step: Synthesis of Intermediate I-8

Under nitrogen conditions, 2-(3'-chloro-[1,1'-biphenyl]-3-yl)-4,6-diphenyl-1,3,5-triazine (25 g, 59.54 mmol) was dissolved in 200 ml of xylene, and then bis(pinacolato)diboron (18.9 g, 74.42 mmol), Pd(dppf)Cl₂ (2.18 g, 2.98 mmol), tricyclohexylphosphine (3.34 g, 11.91 mmol), and potassium acetate (11.69 g, 119.07 mmol) were added thereto and the mixture was heated under reflux for 8 hours. After completion of the reaction, water was added to the reaction solution, extraction was performed with DCM, moisture was removed with MgSO4, and the residue was filtered and concentrated under reduced pressure. The residue thus obtained was separated and purified by flash column chromatography to obtain Intermediate I-8 (21.21 g, 80%).

### 2nd step: Synthesis of Compound I-9

Intermediate I-9 was synthesized by referring to the method disclosed in KR 10-2022-0032864.

### 3rd step: Synthesis of Compound 3-29

Under nitrogen conditions, Intermediate I-8 (21.21 g, 41.47 mmol), Intermediate I-9 (17.99 g, 41.47 mmol), K2CO3 (11.46 g, 82.94 mmol), and Pd(PPh3)4 (2.40 g, 2.07 mmol) were placed in a round-bottom flask, dissolved in THF (200 ml) and distilled water (60 ml), and then stirred under reflux at 60°C for 12 hours. After completion of the reaction, the aqueous layer was removed, and the organic solvent was removed under reduced pressure to obtain a solid. The solid obtained was dissolved in high-temperature MCB. After removing moisture with MgSO₄, the organic solvent was filtered using a silica gel pad, and then the filtrate was stirred. When a solid was formed, it was filtered and vacuum-dried to obtain Compound 3-29 (22.73 g, 70%).

### Synthesis Example 6: Synthesis of Compound R-2

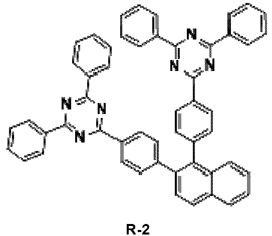

Compound R-2 was synthesized by referring to the method disclosed in KR 10-2086763.

### Synthesis Example 7: Synthesis of Compound R-3

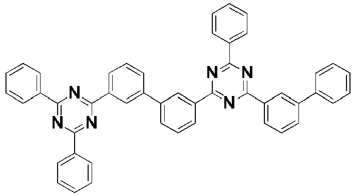

Compound R-3 was synthesized in the same manner as the synthesis method of Compound 3-29 using Intermediate I-8 and 2-([1,1'-biphenyl]-3-yl)-4-chloro-6-phenyl-1,3,5-triazine.

### Example 1: Manufacturing of Green Organic Light Emitting Diode

A glass substrate coated with a thin film of ITO (indium tin oxide) was ultrasonically cleaned with distilled water. After washing with the distilled water, the glass substrate was washed with a solvent such as isopropyl alcohol, acetone, methanol, and the like ultrasonically and dried and then, moved to a plasma cleaner, cleaned by using oxygen plasma for 10 minutes, and moved to a vacuum depositor. This prepared ITO transparent electrode was used as an anode, Compound E doped with 3% NDP-9 (Novaled GmbH) was vacuum-deposited on the ITO substrate to form a 100 Å-thick hole injection layer, and Compound A is deposited on the hole injection layer to form a 1350 Å-thick hole transport layer. On the hole transport layer, Cmpound B was deposited to to a thickness of 320 Å to form a hole transport auxiliary layer. On the hole transport auxiliary layer, Compound 1-119 and Compound 2-32 were simultaneously used as hosts in a weight ratio of 3:7 and doped with 7 wt% of IrGD as a dopant to form a 330 Å-thick light emitting layer by vacuum deposition. Subsequently, on the light emitting layer, Compound 3-29 was deposited to form a 50 Å-thick electron transport auxiliary layer, and Compound 3-29 and Liq in a weight ratio of 1:1 were simultaneously vacuum-deposited to form a 300 Å-thick electron transport layer. On the electron transport layer, a cathode was formed by sequentially vacuum-depositing 15 Å of LiQ and 1200 Å of Al, manufacturing an organic light emitting diode.

It was manufactured in a structure of ITO/Compound A (3% NDP-9 doping, 100 Å)/Compound B (1350 Å)/Compound F (320 Å)/EML [Host (Compound 1-119 : Compound 2-32 = 3 : 7 wt%/wt%) : IrGD = 93 wt% : 7 wt%] (330 Å)/Compound 3-29 (50 Å)/Compound 3-29:LiQ (300 Å)/LiQ (15 Å)/Al (1200 Å).
Compound A: N-(9,9-diphenyl-9H-fluoren-2-yl)-N,9-diphenyl-9H-carbazol-2-amine
Compound B: N-([1,1'-biphenyl]-4-yl)-9,9-dimethyl-N-(3-(9-phenyl-9H-fluoren-9-yl)phenyl)-9H-fluoren-2-amine

### [IrGD]

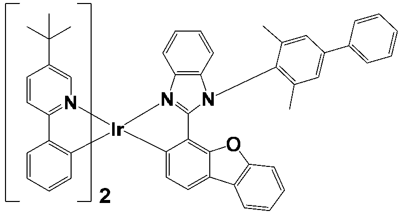

### Example 2 and Comparative Examples 1 to 8

Organic light emitting diodes were manufactured in the same manner as in Example 1, except that the compositions were changed to those listed in Tables 1 to 5.

### Evaluation

Driving voltage and life-span characteristics of the organic light emitting diodes according to Example 1, Example 2, and Comparative Examples 1 to 8 were evaluated.

Specific measurement methods are as follows, and results are as shown in Tables 1 to 5.

### (1) Measurement of Current Density Change Depending on Voltage Change

The obtained organic light emitting diodes were measured regarding a current value flowing in the unit diode, while increasing the voltage from 0 V to 10 V using a current-voltage meter (Keithley 2400), and the measured current value was divided by area to provide the results.

### (2) Measurement of Luminance Change Depending on Voltage Change

Luminance was measured by using a luminance meter (Minolta Cs-1000A), while the voltage of the organic light emitting diodes was increased from 0 V to 10 V.

### (3) Measurement of Life-span

The results were obtained by measuring the time when the current efficiency (cd/A) decreased to 97% while maintaining the luminance (cd/m²) at 30000 cd/m².

The life-span measurement values were calculated as relative values based on the life-span measurement values of Example 1 or Example 2 and are listed in Table 3 to Table 5.

### (4) Measurement of Driving Voltage

The driving voltage of each device was measured at 15 mA/cm² using a current-voltmeter (Keithley 2400) to obtain results.

The driving voltage was calculated as a relative value based on the driving voltage of Example 1 or Example 2 and is listed in Table 1, Table 2, and Table 5.

**(Table 1)**

| No. | Host | | Electron transport auxiliary layer and electron transport layer | Driving voltage (%) |
|---|---|---|---|---|
| | First compound | Second compound | Third compound | |
| Example 1 | Compound 1-119 | Compound 2-32 | Compound 3-29 | 100 |
| Comparative Example 1 | Compound 1-119 | Compound R-1 | Compound 3-29 | 108 |

**(Table 2)**

| No. | Host | | Electron transport auxiliary layer and electron transport layer | Driving voltage (%) |
|---|---|---|---|---|
| | First compound | Second compound | Third compound | |
| Example 2 | Compound 1-98 | Compound 2-32 | Compound 3-29 | 100 |
| Comparative Example 2 | Compound 1-98 | Compound R-1 | Compound 3-29 | 109 |

**(Table 3)**

| No. | Host | | Electron transport auxiliary layer and electron transport layer | Life-span (%) |
|---|---|---|---|---|
| | First compound | Second compound | Third compound | |
| Example 1 | Compound 1-119 | Compound 2-32 | Compound 3-29 | 100 |
| Comparative Example 3 | Compound 1-119 | Compound 2-32 | Compound R-2 | 89 |
| Comparative Example 4 | Compound 1-119 | Compound 2-32 | Compound R-3 | 84 |

**(Table 4)**

| No. | Host | | Electron transport auxiliary layer and electron transport layer | Life-span (%) |
|---|---|---|---|---|
| | First compound | Second compound | Third compound | |
| Example 2 | Compound 1-98 | Compound 2-32 | Compound 3-29 | 100 |
| Comparative Example 5 | Compound 1-98 | Compound 2-32 | Compound R-2 | 87 |
| Comparative Example 6 | Compound 1-98 | Compound 2-32 | Compound R-3 | 80 |

**(Table 5)**

| No. | Host | | Electron transport auxiliary layer and electron transport layer | Driving voltage (%) | Life-span (%) |
|---|---|---|---|---|---|
| | First compound | Second compound | Third compound | | |
| Example 2 | Compound 1-98 | Compound 2-32 | Compound 3-29 | 100 | 100 |
| Comparative Example 7 | Compound 1-98 | Compound R-1 | Compound R-2 | 109 | 21 |
| Comparative Example 8 | Compound 1-98 | Compound R-1 | Compound R-3 | 113 | 21 |

Referring to Tables 1 and 2, it may be confirmed that the organic light emitting diodes according to Examples 1 and 2 exhibited significantly improved driving voltages compared to the organic light emitting diodes according to Comparative Examples 1 and 2. Further, referring to Tables 3 and 4, it may be confirmed that the organic light emitting diodes according to Examples 1 and 2 exhibited significantly improved life-span compared to the organic light emitting diodes according to Comparative Examples 3 and 4.

Referring to Table 5, it may be confirmed that the organic light emitting diode according to Example 1 has significantly improved driving voltage and life-span compared to the organic light emitting diodes according to Comparative Examples 7 and 8. In particular, it may be confirmed that the life-span characteristics are significantly improved.

While this invention has been described in connection with what is presently considered to be practical example embodiments, it is to be understood that the invention is not limited to the disclosed embodiments. On the contrary, it is intended to cover various modifications and equivalent arrangements included within the spirit and scope of the appended claims.

## Claims

1. An organic optoelectronic device, comprising
an anode and a cathode facing each other,
a light emitting layer between the anode and the cathode, and
an electron transport layer between the light emitting layer and the cathode,
wherein the light emitting layer includes a first compound represented by Chemical Formula 1 and a second compound represented by a combination of Chemical Formula 2 and Chemical Formula 3, and
the electron transport layer includes a third compound represented by Chemical Formula 4: 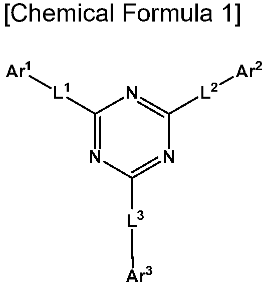
wherein, in Chemical Formula 1,
Ar¹ to Ar³ are each independently a substituted or unsubstituted C6 to C30 aryl group, or a substituted or unsubstituted C2 to C30 heterocyclic group, and
L¹ to L³ are each independently a single bond, a substituted or unsubstituted C6 to C20 arylene group, or a substituted or unsubstituted C2 to C30 heteroarylene group; 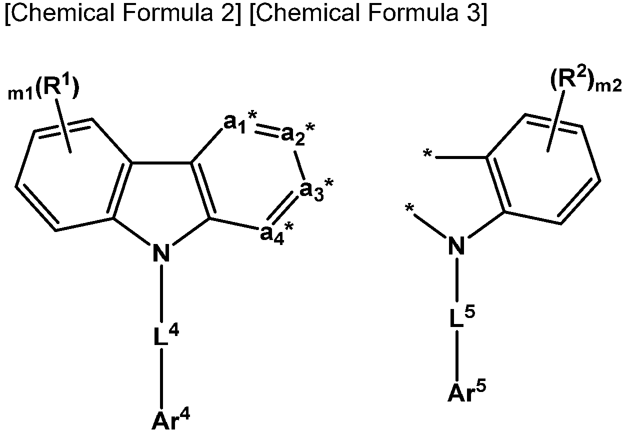
wherein, in Chemical Formula 2 and Chemical Formula 3,
among a₁* to a₄* in Chemical Formula 2, two adjacent ones are each a linking carbon (C) that is linked to * in Chemical Formula 3,
among a₁* to a₄* of Chemical Formula 2, the remaining two that are not linked to Chemical Formula 3 are C-L^{a}-R^{a},
L^{a}, L⁴, and L⁵ are each independently a single bond or a substituted or unsubstituted C6 to C20 arylene group,
R^{a}, R¹, and R² are each independently hydrogen, deuterium, a cyano group, a halogen, a substituted or unsubstituted amine group, a substituted or unsubstituted C1 to C30 alkyl group, a substituted or unsubstituted C6 to C30 aryl group, or a substituted or unsubstituted C2 to C30 heterocyclic group,
Ar⁴ and Ar⁵ are each independently a substituted or unsubstituted C6 to C20 aryl group or a substituted or unsubstituted C2 to C30 heterocyclic group,
m1 and m2 are each independently one of integers of 1 to 4,
when m1 is 2 or more, each R¹ is the same or different from each other, and
when m2 is 2 or more, each R² is the same or different from each other; 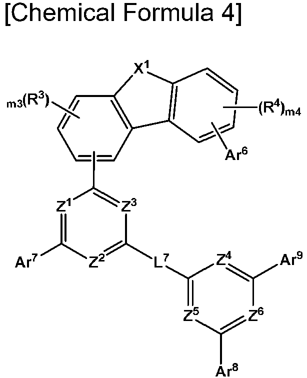
wherein, in Chemical Formula 4,
X¹ is O or S,
Z¹ to Z⁶ are each independently N or CR^{b},
at least two of Z¹ to Z³ are N,
at least two of Z⁴ to Z⁶ are N,
L⁷ is a substituted or unsubstituted phenylene group or a substituted or unsubstituted biphenylene group,
Ar⁶ to Ar⁹ are each independently a substituted or unsubstituted C6 to C30 aryl group,
R^{b}, R³, and R⁴ are each independently hydrogen, deuterium, a cyano group, a halogen, a substituted or unsubstituted C1 to C30 alkyl group, a substituted or unsubstituted C6 to C30 aryl group, or a substituted or unsubstituted C2 to C30 heterocyclic group,
m3 and m4 are each independently one of integers of 1 to 3,
when m3 is 2 or more, each R³ is the same or different from each other, and
when m4 is 2 or more, each R⁴ is the same or different from each other.

2. The organic optoelectronic device as claimed in claim 1, wherein
Ar¹ to Ar³ are each independently a substituted or unsubstituted phenyl group, a substituted or unsubstituted biphenyl group, a substituted or unsubstituted terphenyl group, a substituted or unsubstituted naphthyl group, a substituted or unsubstituted anthracenyl group, a substituted or unsubstituted phenanthrenyl group, a substituted or unsubstituted fluorenyl group, a substituted or unsubstituted triphenylene group, a substituted or unsubstituted pyridinyl group, a substituted or unsubstituted pyrimidinyl group, a substituted or unsubstituted triazinyl group, a substituted or unsubstituted benzothiophenepyrimidinyl group, a substituted or unsubstituted benzofuranpyrimidinyl group, a substituted or unsubstituted dibenzofuranyl group, a substituted or unsubstituted dibenzothiophenyl group, a substituted or unsubstituted carbazolyl group, a substituted or unsubstituted benzocarbazolyl group, a substituted or unsubstituted oxazolocarbazolyl group, a substituted or unsubstituted indolocarbazolyl group, a substituted or unsubstituted indolofluorenyl group, a substituted or unsubstituted benzofuranocarbazolyl group, substituted or unsubstitutedbenzothienocarbazolyl group, or a substituted or unsubstituted dibenzosilolyl group.

3. The organic optoelectronic device as claimed in claim 1, wherein
the first compound is represented by any one of Chemical Formula 1-I, Chemical Formula 1-II, Chemical Formula 1-III and Chemical Formula 1-IV: 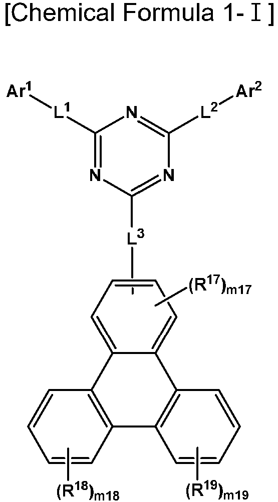
wherein, in Chemical Formula 1-I, L¹ to L³ are the same as described above,
Ar¹ and Ar² are each independently a substituted or unsubstituted phenyl group, a substituted or unsubstituted biphenyl group, a substituted or unsubstituted terphenyl group, a substituted or unsubstituted naphthyl group, a substituted or unsubstituted anthracenyl group, a substituted or unsubstituted phenanthrenyl group, a substituted or unsubstituted fluorenyl group, a substituted or unsubstituted triphenylene group, a substituted or unsubstituted dibenzofuranyl group, a substituted or unsubstituted dibenzothiophenyl group or a substituted or unsubstituted dibenzosilolyl group,
R¹⁷ to R¹⁹ are each independently hydrogen, deuterium, a cyano group, a halogen, a substituted or unsubstituted C1 to C30 alkyl group, or a substituted or unsubstituted C6 to C30 aryl group,
m17 is one of integers of 1 to 3,
m18 and m19 are each independently one of integers of 1 to 4,
when m17 is 2 or more, each R¹⁷ is the same or different from each other,
when m18 is 2 or more, each R¹⁸ is the same or different from each other, and
when m19 is 2 or more, each R¹⁹ is the same or different from each other; 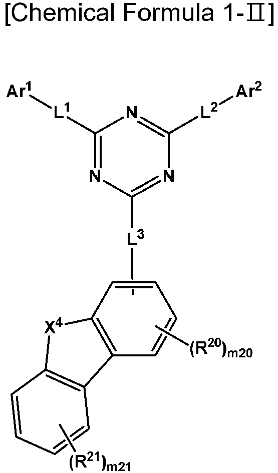
wherein, in Chemical Formula 1-II, L¹ to L³ are the same as described above,
X⁴ is O or S,
Ar¹ and Ar² are each independently a substituted or unsubstituted phenyl group, a substituted or unsubstituted biphenyl group, a substituted or unsubstituted terphenyl group, a substituted or unsubstituted naphthyl group, a substituted or unsubstituted anthracenyl group, a substituted or unsubstituted phenanthrenyl group, a substituted or unsubstituted fluorenyl group, a substituted or unsubstituted dibenzofuranyl group, a substituted or unsubstituted dibenzothiophenyl group or a substituted or unsubstituted dibenzosilolyl group,
R²⁰ to R²¹ are each independently hydrogen, deuterium, a cyano group, a halogen, a substituted or unsubstituted C1 to C30 alkyl group, a substituted or unsubstituted C6 to C30 aryl group, or a substituted or unsubstituted C2 to C30 heterocyclic group,
m20 is one of integers of 1 to 3,
m21 is one of integers of 1 to 4,
wherein, in m20 is 2 or more, each R²⁰ is the same or different from each other, and
wherein, in m21 is 2 or more, each R²¹ is the same or different from each other; 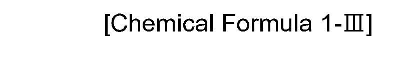 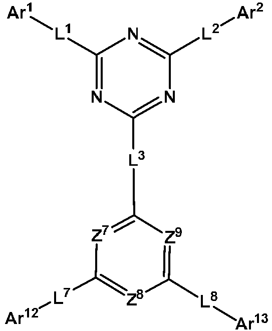
wherein, in Chemical Formula 1-III, L¹ to L³ are the same as described above,
Z⁷ to Z⁹ are each independently N or CR^{f},
at least two of Z⁷ to Z⁹ are N, and
Ar¹ and Ar² are each independently a substituted or unsubstituted phenyl group, a substituted or unsubstituted biphenyl group, a substituted or unsubstituted terphenyl group, a substituted or unsubstituted naphthyl group, a substituted or unsubstituted anthracenyl group, a substituted or unsubstituted phenanthrenyl group, a substituted or unsubstituted fluorenyl group, a substituted or unsubstituted triphenylene group, a substituted or unsubstituted dibenzofuranyl group, a substituted or unsubstituted dibenzothiophenyl group, a substituted or unsubstituted carbazolyl group, a substituted or unsubstituted benzocarbazolyl group, a substituted or unsubstituted oxazolocarbazolyl group, a substituted or unsubstituted indolocarbazolyl group, a substituted or unsubstituted indolofluorenyl group, a substituted or unsubstituted benzofuranocarbazolyl group, substituted or unsubstitutedbenzothienocarbazolyl group, or a substituted or unsubstituted dibenzosilolyl group; 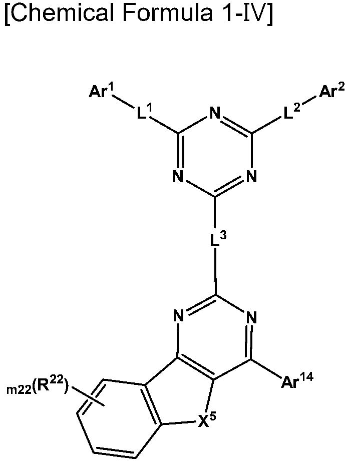
wherein, in Chemical Formula 1-IV, L¹ to L³ are the same as described above,
X⁵ is O or S,
Ar¹ and Ar² are each independently a substituted or unsubstituted phenyl group, a substituted or unsubstituted biphenyl group, a substituted or unsubstituted terphenyl group, a substituted or unsubstituted naphthyl group, a substituted or unsubstituted anthracenyl group, a substituted or unsubstituted phenanthrenyl group, a substituted or unsubstituted fluorenyl group, or a substituted or unsubstituted triphenylene group,
Ar¹⁴ is a substituted or unsubstituted C6 to C30 aryl group,
R²² is hydrogen, deuterium, a cyano group, a halogen, a substituted or unsubstituted C1 to C30 alkyl group, a substituted or unsubstituted C6 to C30 aryl group, or a substituted or unsubstituted C2 to C30 heterocyclic group,
d, and
when m22 is 2 or more, each R²² is the same or different from each other.

4. The organic optoelectronic device as claimed in claim 1, wherein
the first compound is represented by Chemical Formula 1-V or Chemical Formula 1-VI: 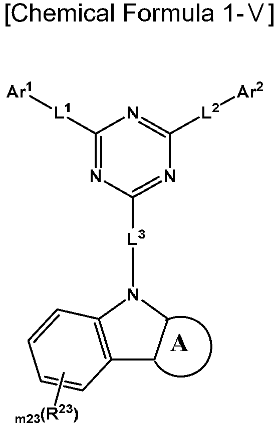
wherein, in Chemical Formula 1-V, L¹ to L³ are the same as described above,
ring A is a substituted or unsubstituted phenyl, a substituted or unsubstituted naphthyl, or a substituted or unsubstituted benzoxazole,
Ar¹ and Ar² are each independently a substituted or unsubstituted phenyl group, a substituted or unsubstituted biphenyl group, a substituted or unsubstituted terphenyl group, a substituted or unsubstituted naphthyl group, a substituted or unsubstituted anthracenyl group, a substituted or unsubstituted phenanthrenyl group, a substituted or unsubstituted fluorenyl group, a substituted or unsubstituted triphenylene group, a substituted or unsubstituted dibenzofuranyl group, a substituted or unsubstituted dibenzothiophenyl group, a substituted or unsubstituted carbazolyl group, a substituted or unsubstituted benzocarbazolyl group, a substituted or unsubstituted oxazolocarbazolyl group, or a substituted or unsubstituted dibenzosilolyl group,
R²³ is hydrogen, deuterium, a cyano group, a halogen, a substituted or unsubstituted C1 to C30 alkyl group, a substituted or unsubstituted C6 to C30 aryl group, or a substituted or unsubstituted C2 to C30 heterocyclic group,
m23 is one of integers of 1 to 4, and
when m23 is 2 or more, each R²³ is the same or different from each other; 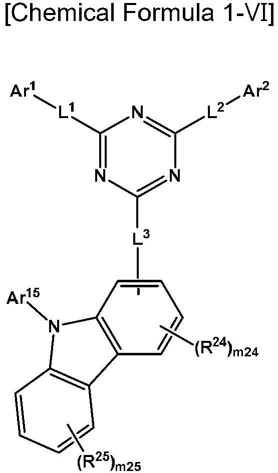
wherein, in Chemical Formula 1-VI, L¹ to L³ are the same as described above,
Ar¹⁵ is a substituted or unsubstituted C6 to C30 aryl group,
Ar¹ and Ar² are each independently a substituted or unsubstituted phenyl group, a substituted or unsubstituted biphenyl group, a substituted or unsubstituted terphenyl group, a substituted or unsubstituted naphthyl group, a substituted or unsubstituted anthracenyl group, a substituted or unsubstituted phenanthrenyl group, a substituted or unsubstituted fluorenyl group, a substituted or unsubstituted triphenylene group, a substituted or unsubstituted dibenzofuranyl group, a substituted or unsubstituted dibenzothiophenyl group, a substituted or unsubstituted carbazolyl group, a substituted or unsubstituted benzocarbazolyl group, a substituted or unsubstituted oxazolocarbazolyl group, or a substituted or unsubstituted dibenzosilolyl group,
R²⁴ and R²⁵ are each independently hydrogen, deuterium, a cyano group, a halogen, a substituted or unsubstituted C1 to C30 alkyl group, a substituted or unsubstituted C6 to C30 aryl group, or a substituted or unsubstituted C2 to C30 heterocyclic group,
m24 is one of integers of 1 to 3,
m25 is one of integers of 1 to 4,
when m24 is 2 or more, each R²⁴ is the same or different from each other, and
when m25 is 2 or more, each R²⁵ is the same or different from each other.

5. The organic optoelectronic device as claimed in claim 1, wherein
the first compound is represented by any one of Chemical Formula 1-VII, Chemical Formula 1-VIII, Chemical Formula 1-IX, Chemical Formula 1-X, Chemical Formula 1-X I and Chemical Formula 1-XII: 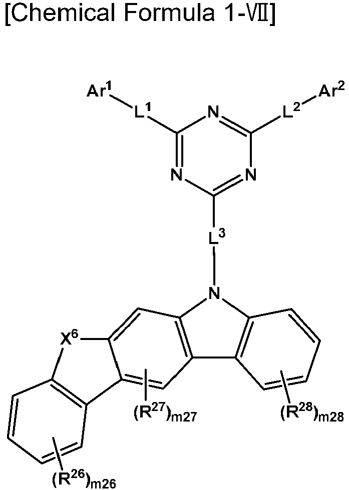 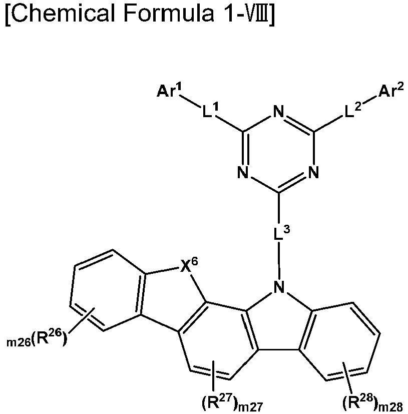 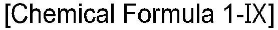 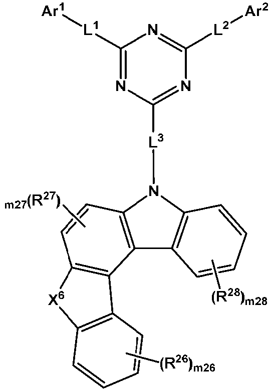 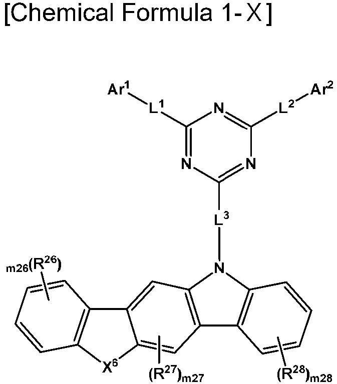 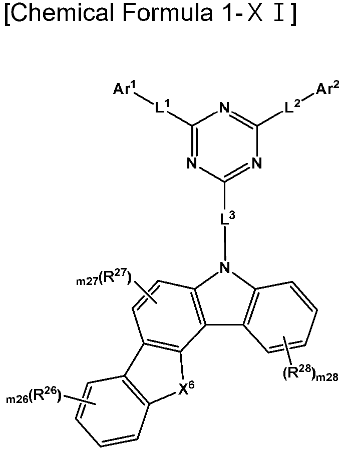 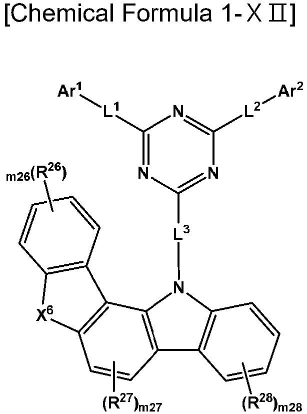
wherein, in Chemical Formula 1-VII, Chemical Formula 1-VIII, Chemical Formula 1-IX, Chemical Formula 1-X, Chemical Formula 1-X I, and Chemical Formula 1-XII, L¹ to L³ are the same as described above,
X⁶ is O, S, NR^{g}, or CR^{h}Rⁱ,
Ar¹ and Ar² are each independently a substituted or unsubstituted phenyl group, a substituted or unsubstituted biphenyl group, a substituted or unsubstituted terphenyl group, a substituted or unsubstituted naphthyl group, a substituted or unsubstituted anthracenyl group, a substituted or unsubstituted phenanthrenyl group, a substituted or unsubstituted fluorenyl group, a substituted or unsubstituted triphenylene group, a substituted or unsubstituted dibenzofuranyl group, a substituted or unsubstituted dibenzothiophenyl group, a substituted or unsubstituted carbazolyl group, or a substituted or unsubstituted dibenzosilolyl group,
R^{g}, R^{g}, Rⁱ, and R²⁶ to R²⁸ are each independently hydrogen, deuterium, a cyano group, a halogen, a substituted or unsubstituted C1 to C30 alkyl group, a substituted or unsubstituted C6 to C30 aryl group, or a substituted or unsubstituted C2 to C30 heterocyclic group,
m26 and m28 are each independently one of integers of 1 to 4,
m27 is an integer of 1 or 2,
when m26 is 2 or more, each R²⁶ is the same or different from each other,
when m27 is 2 or more, each R²⁷ is the same or different from each other, and
when m28 is 2 or more, each R²⁸ is the same or different from each other.

6. The organic optoelectronic device as claimed in claim 1, wherein
one or more of Ar¹ to Ar³ is a 9-carbazolyl group.

7. The organic optoelectronic device as claimed in claim 1, wherein
L¹-Ar¹, L²-Ar², and L³-Ar³ are each independently selected from substituents listed in Group I : 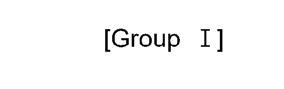 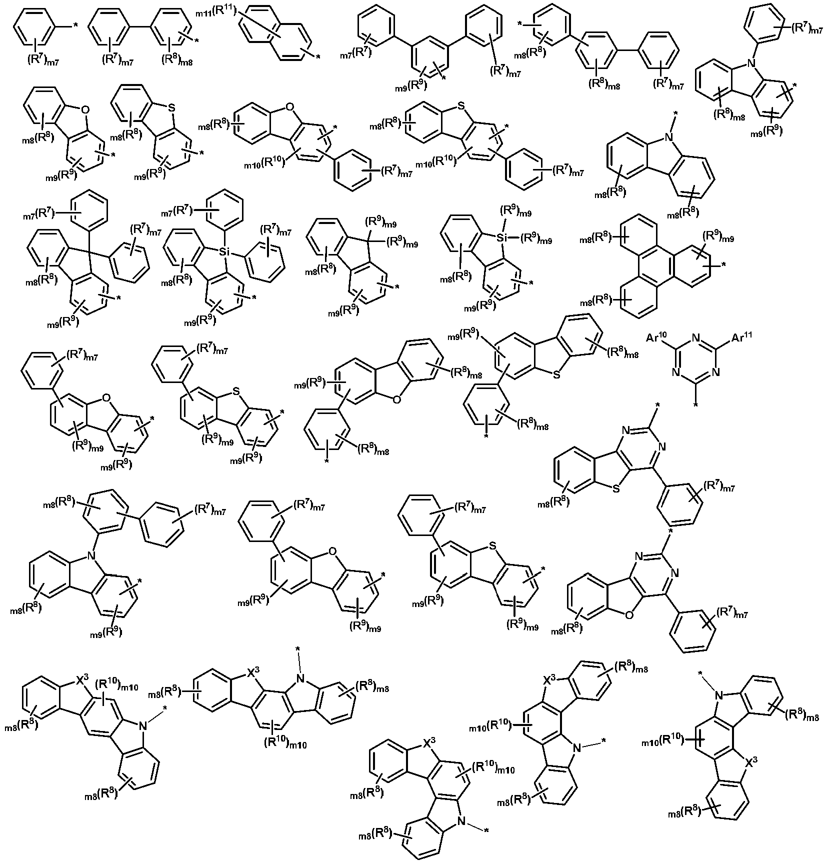
wherein, in Group I ,
X³ is O, S, NR^{c}, or CR^{d}R^{e},
R^{c}, R^{d}, R^{e}, and R⁷ to R¹¹ are each independently hydrogen, deuterium, a cyano group, a substituted or unsubstituted C1 to C10 alkyl group, a substituted or unsubstituted C6 to C12 aryl group, or a substituted or unsubstituted C2 to C20 heteroaryl group,
Ar¹⁰ and Ar¹¹ are each independently a substituted or unsubstituted C6 to C20 aryl group,
m7 is one of integers of 1 to 5,
m8 is one of integers of 1 to 4,
m9 is one of integers of 1 to 3,
m10 is an integer of 1 or 2,
m11 is one of integers of 1 to 7, and
* is a linking point.

8. The organic optoelectronic device as claimed in claim 1, wherein
the first compound is one selected from compounds listed in Group 1-1 to Group 1-3: 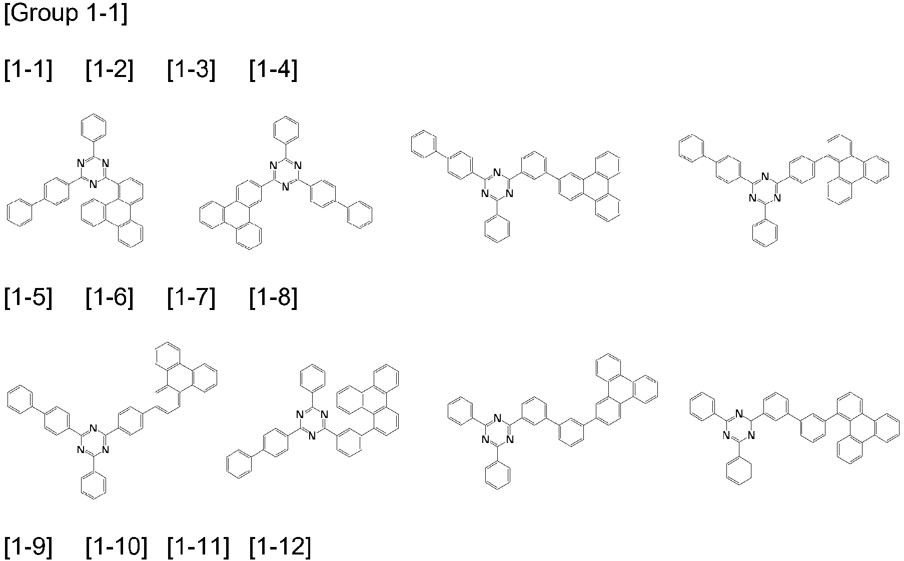 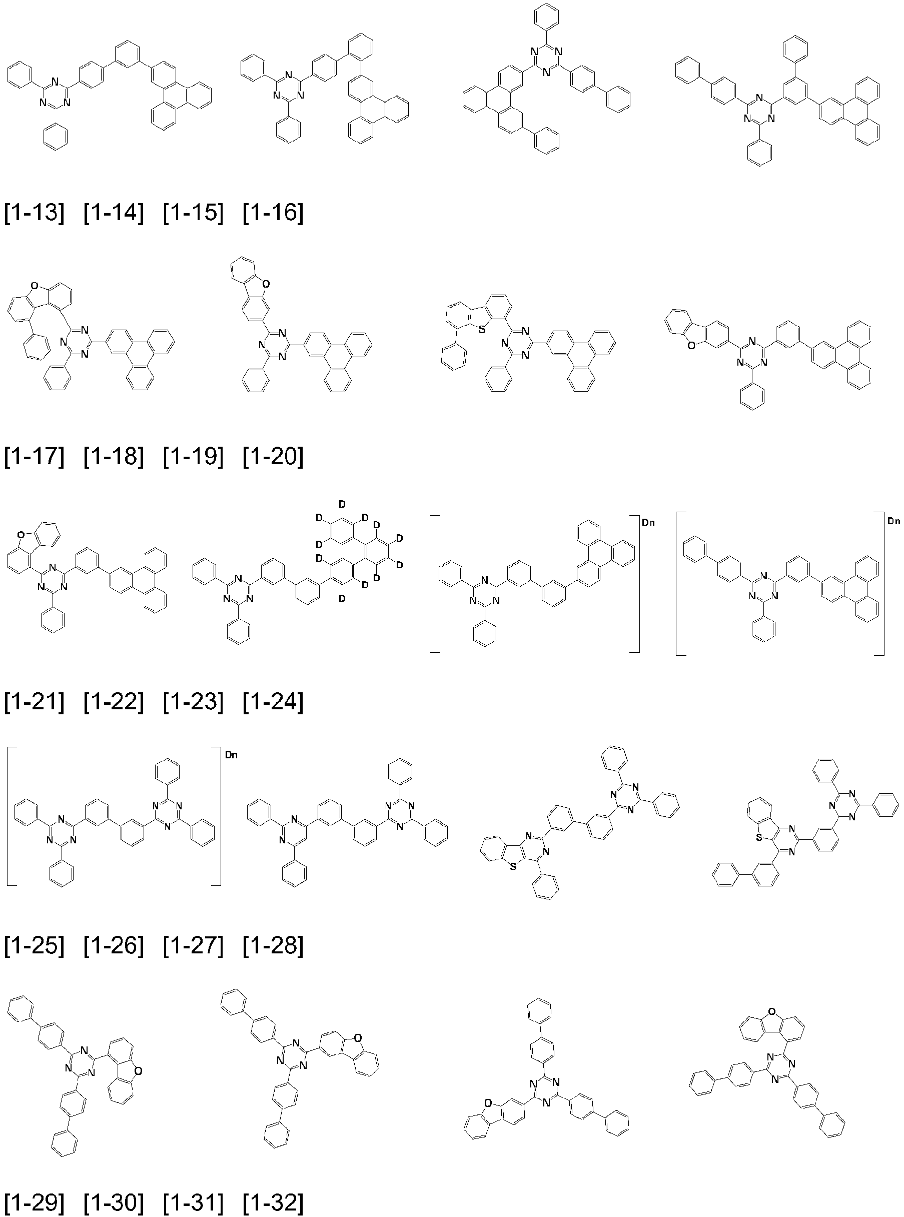 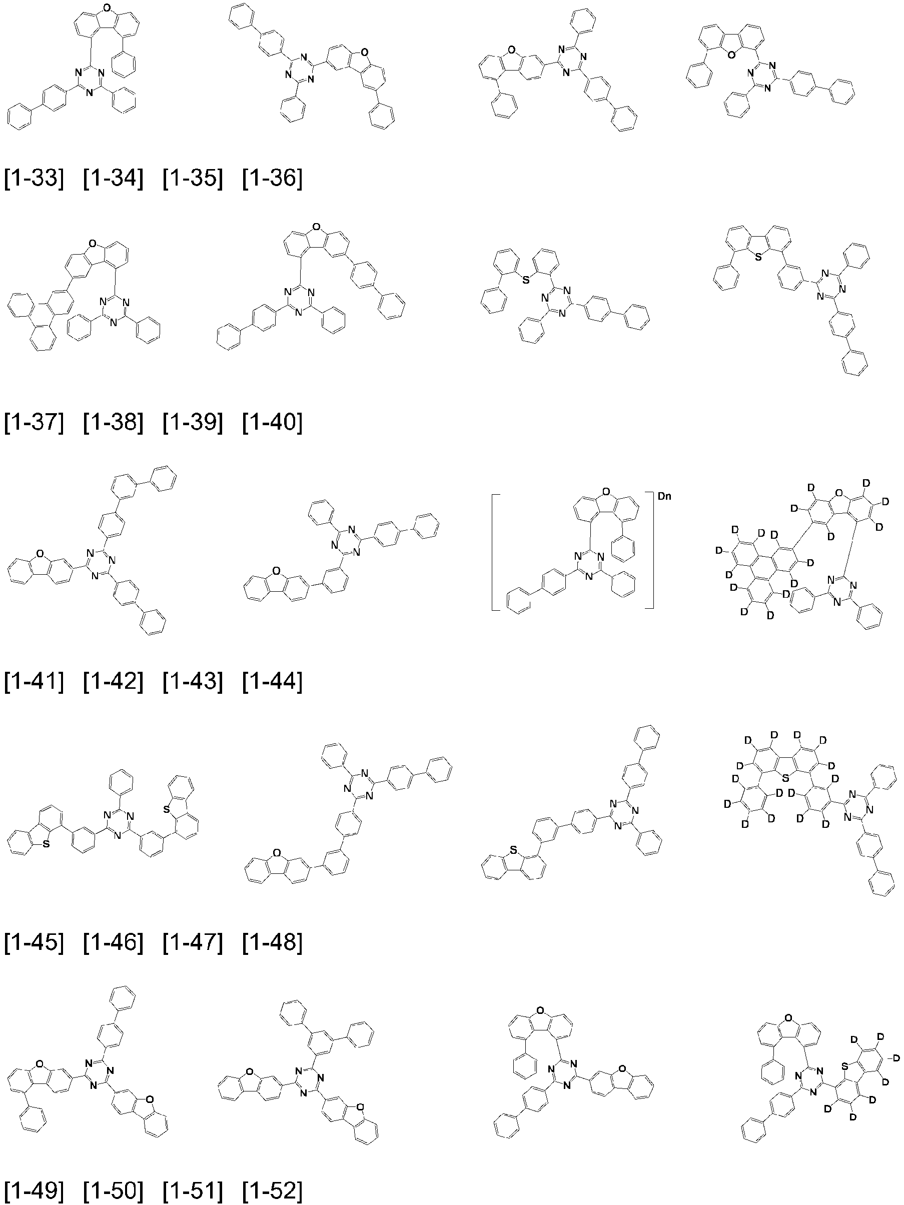 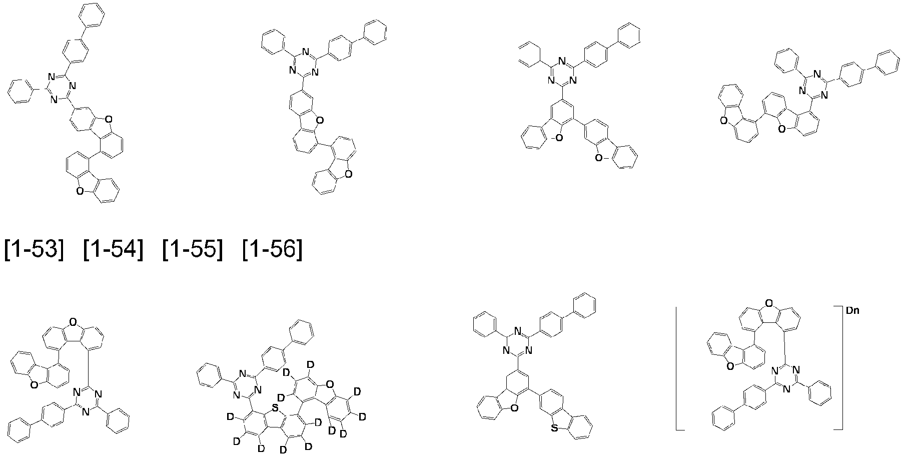 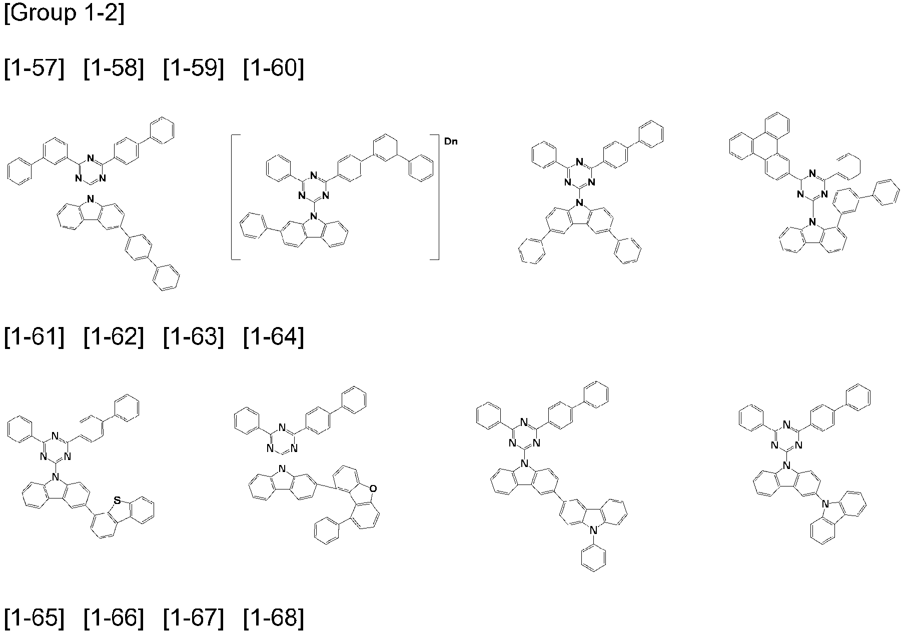 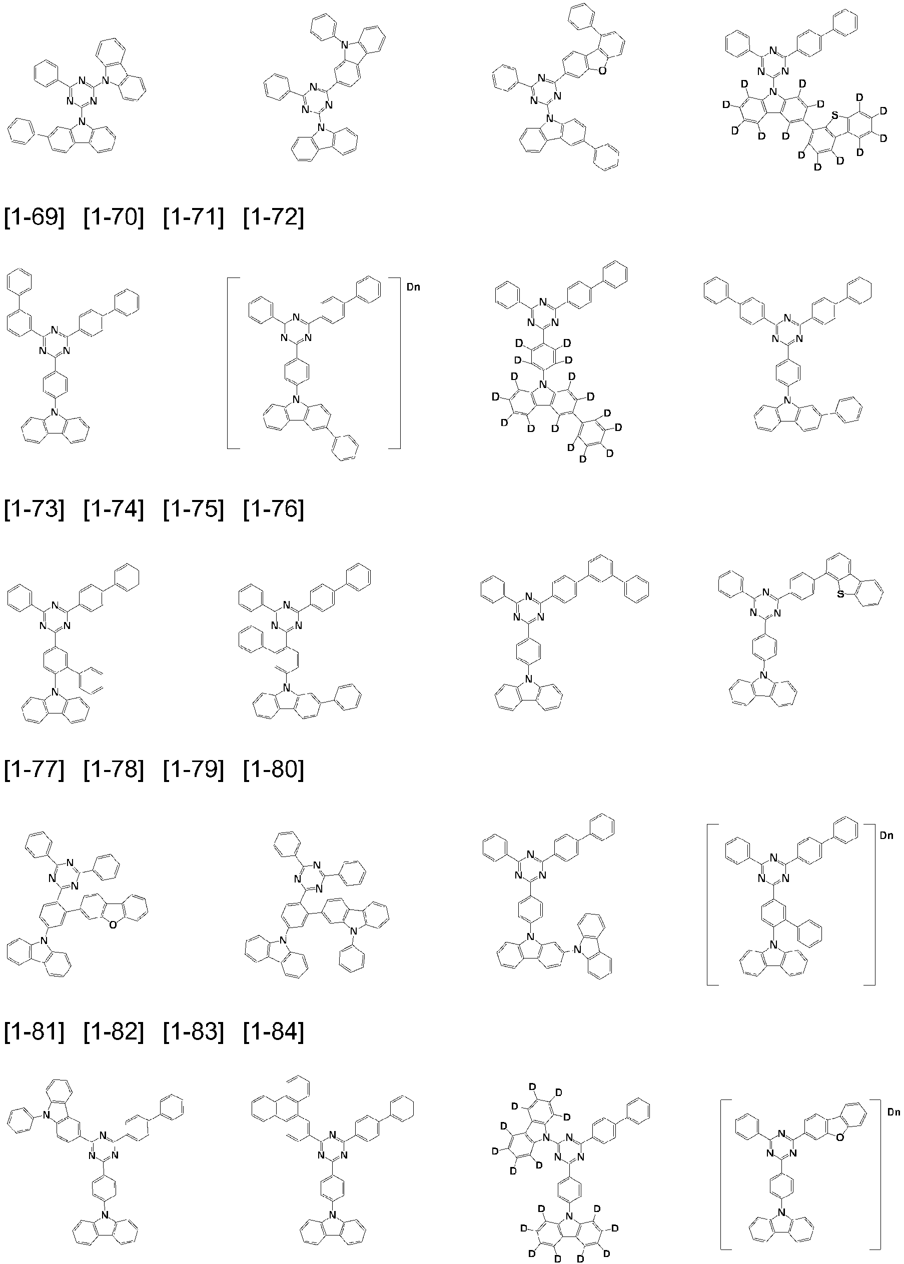 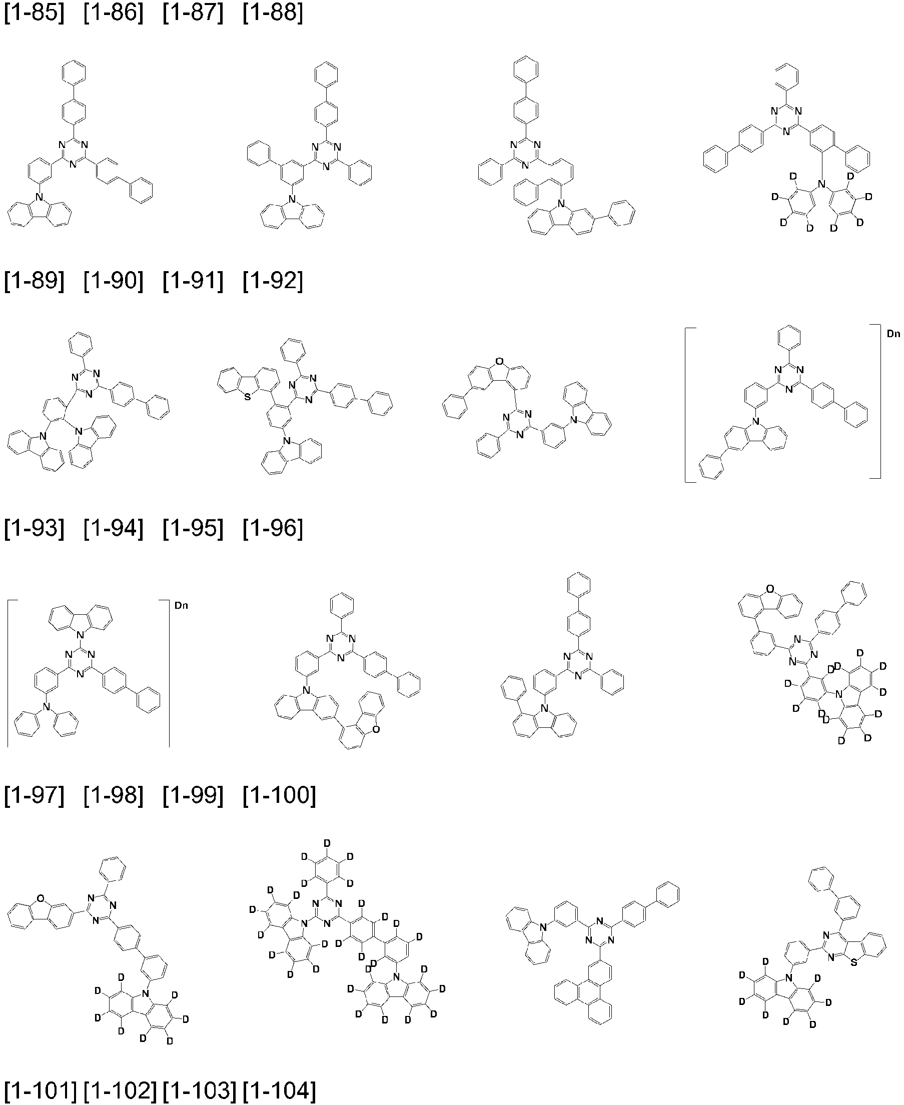 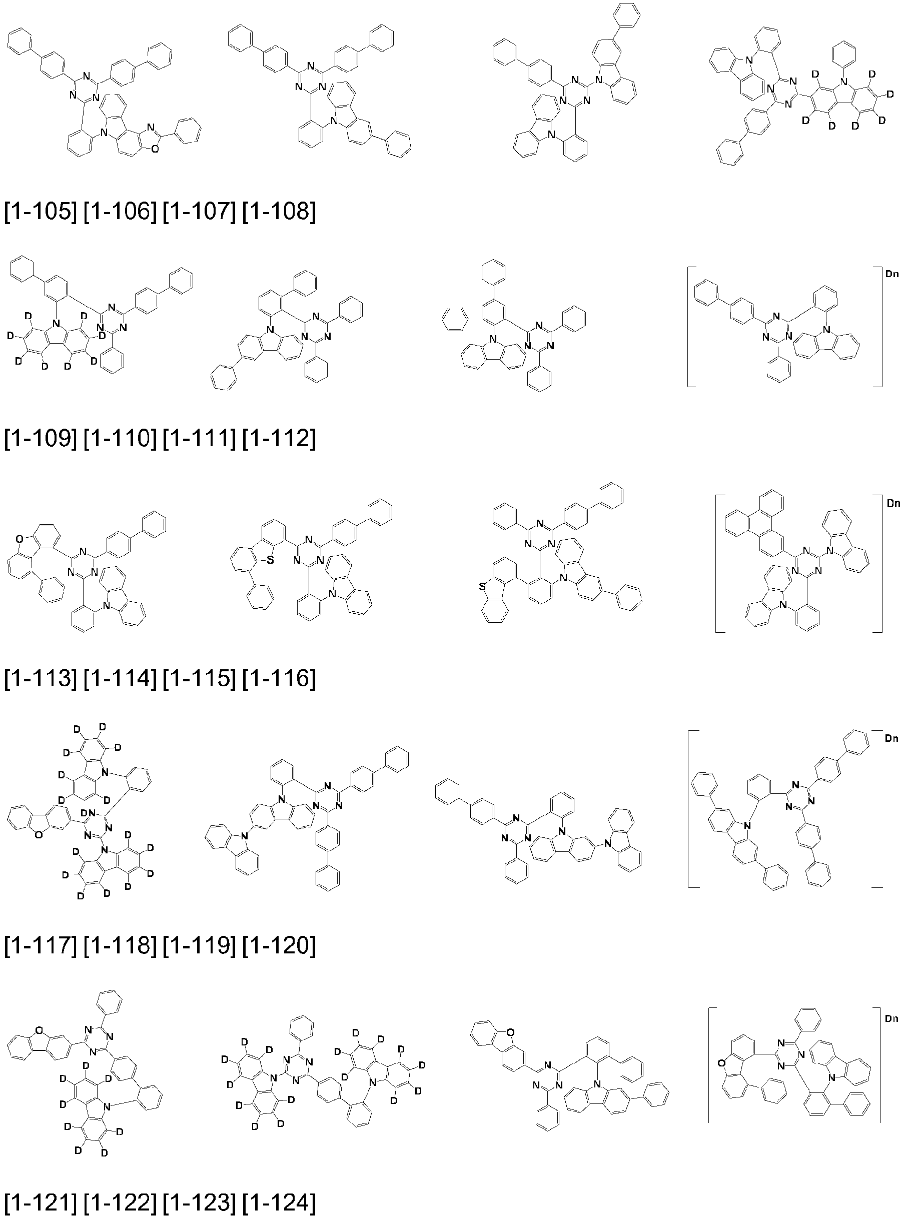 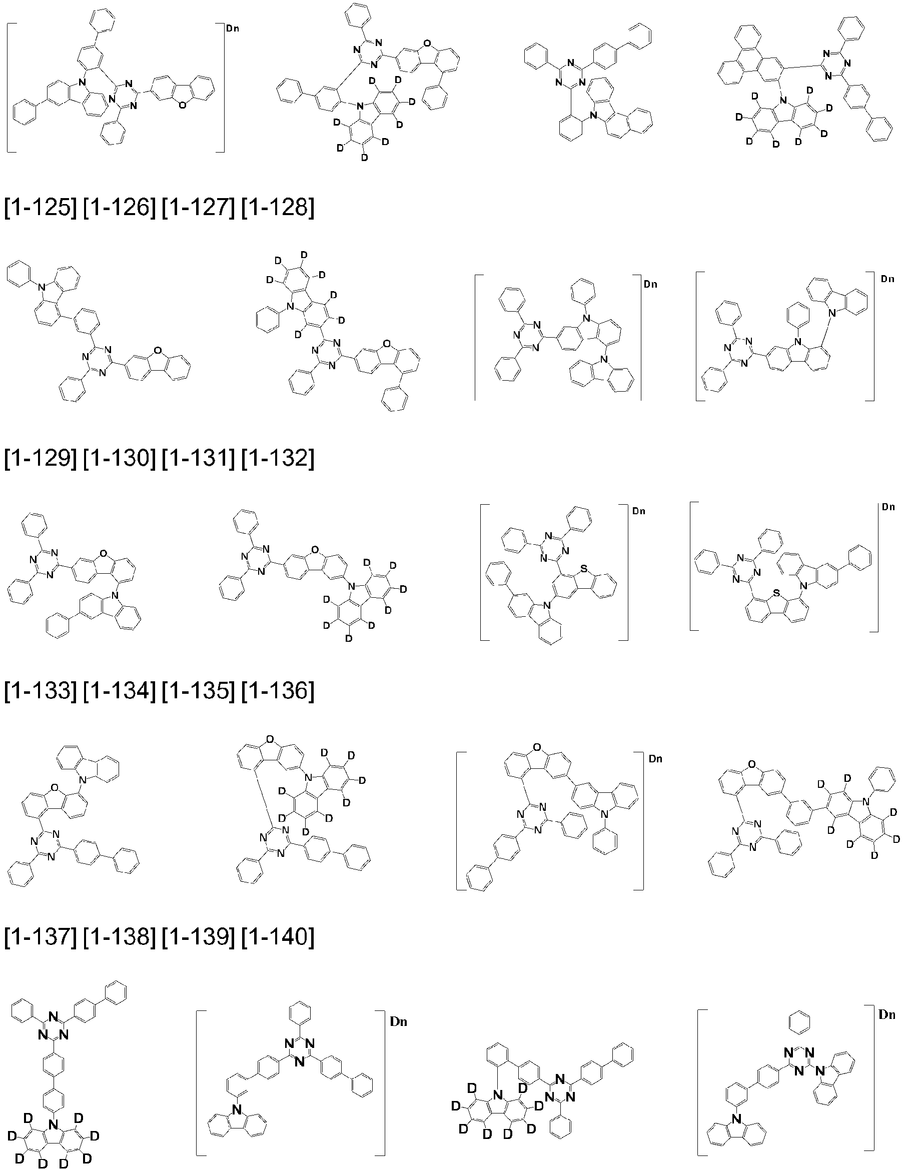 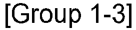 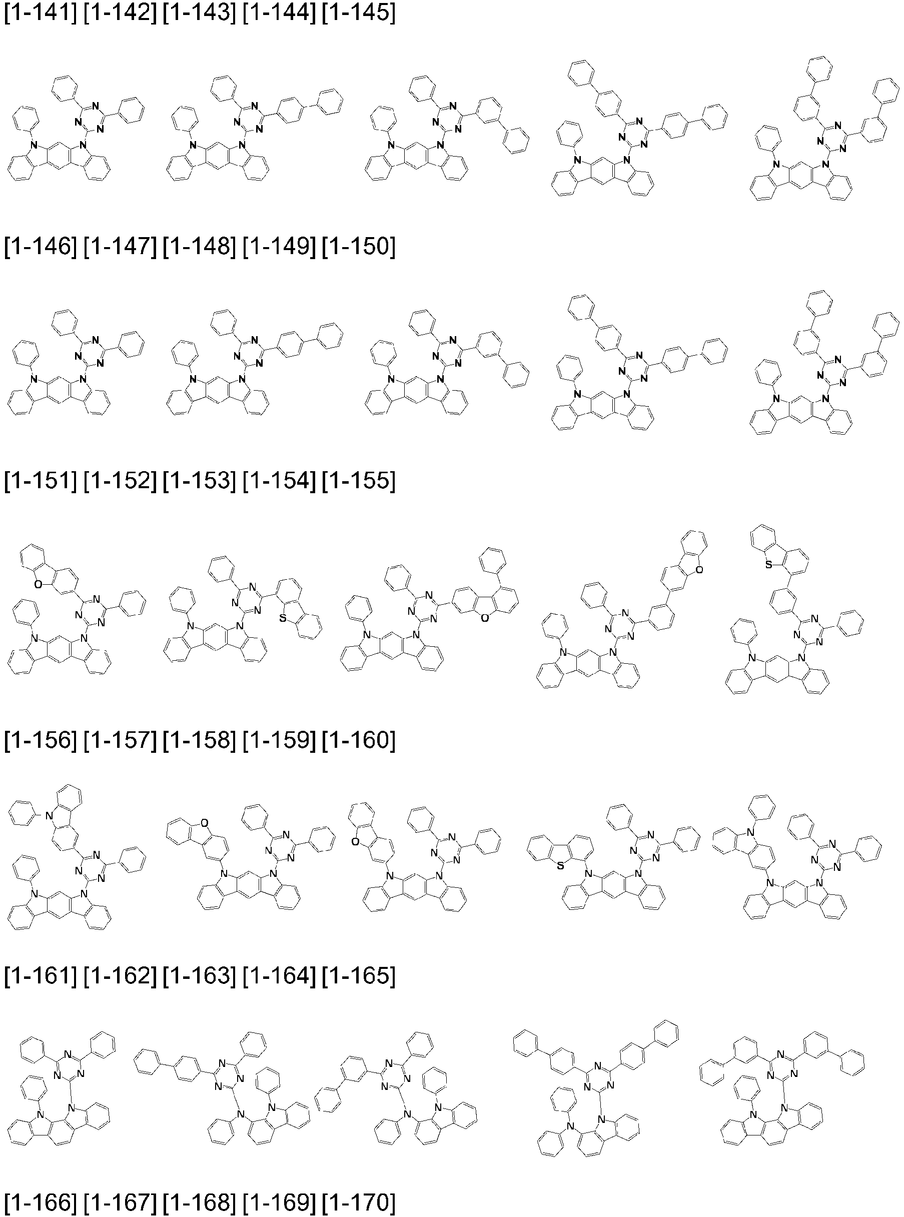 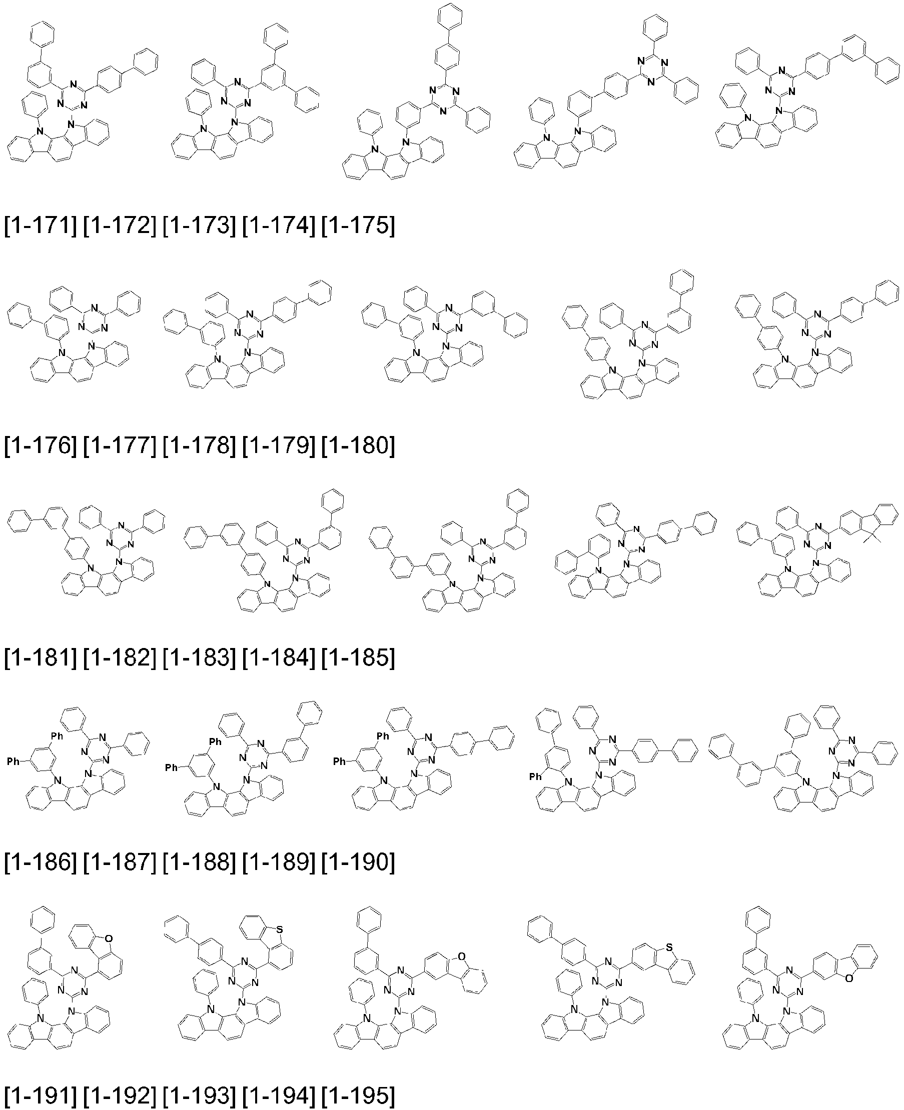 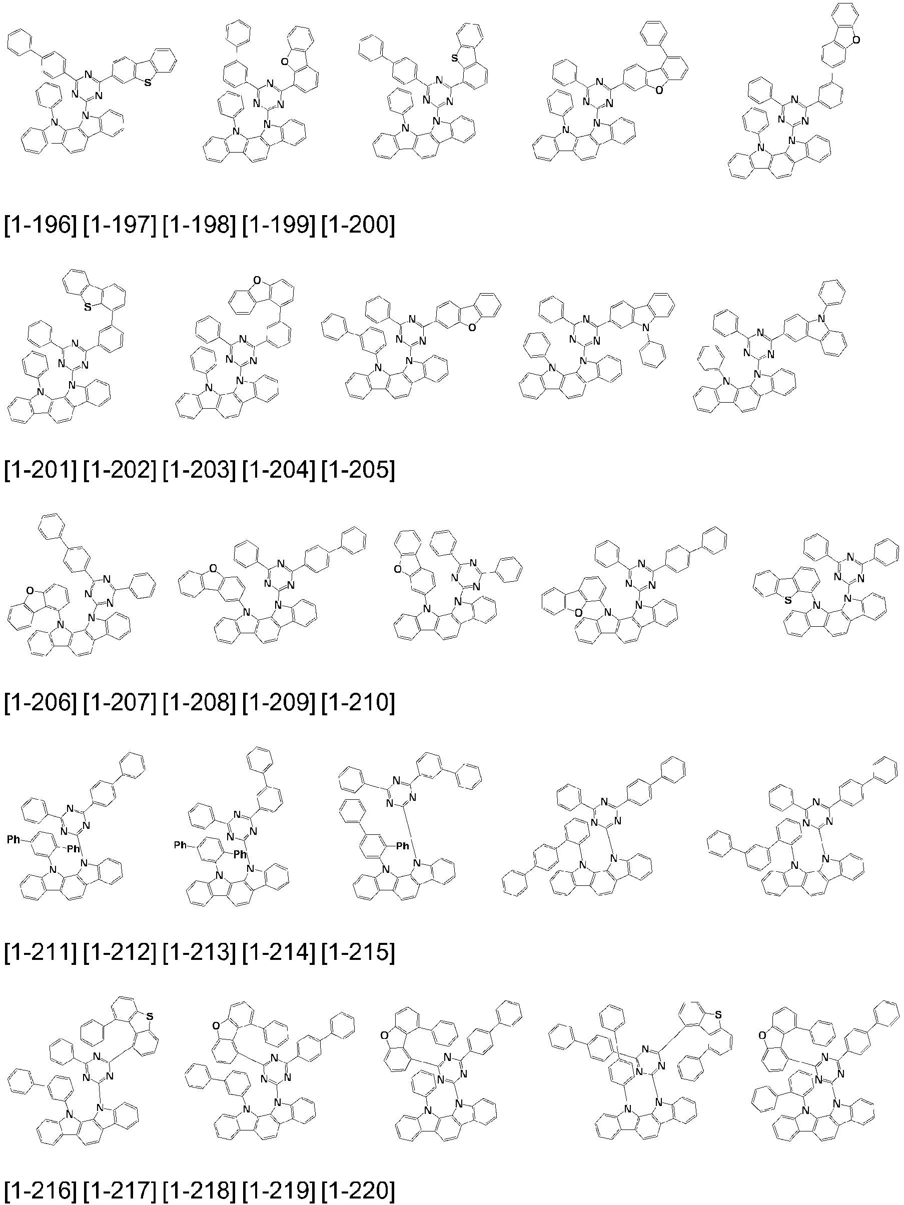 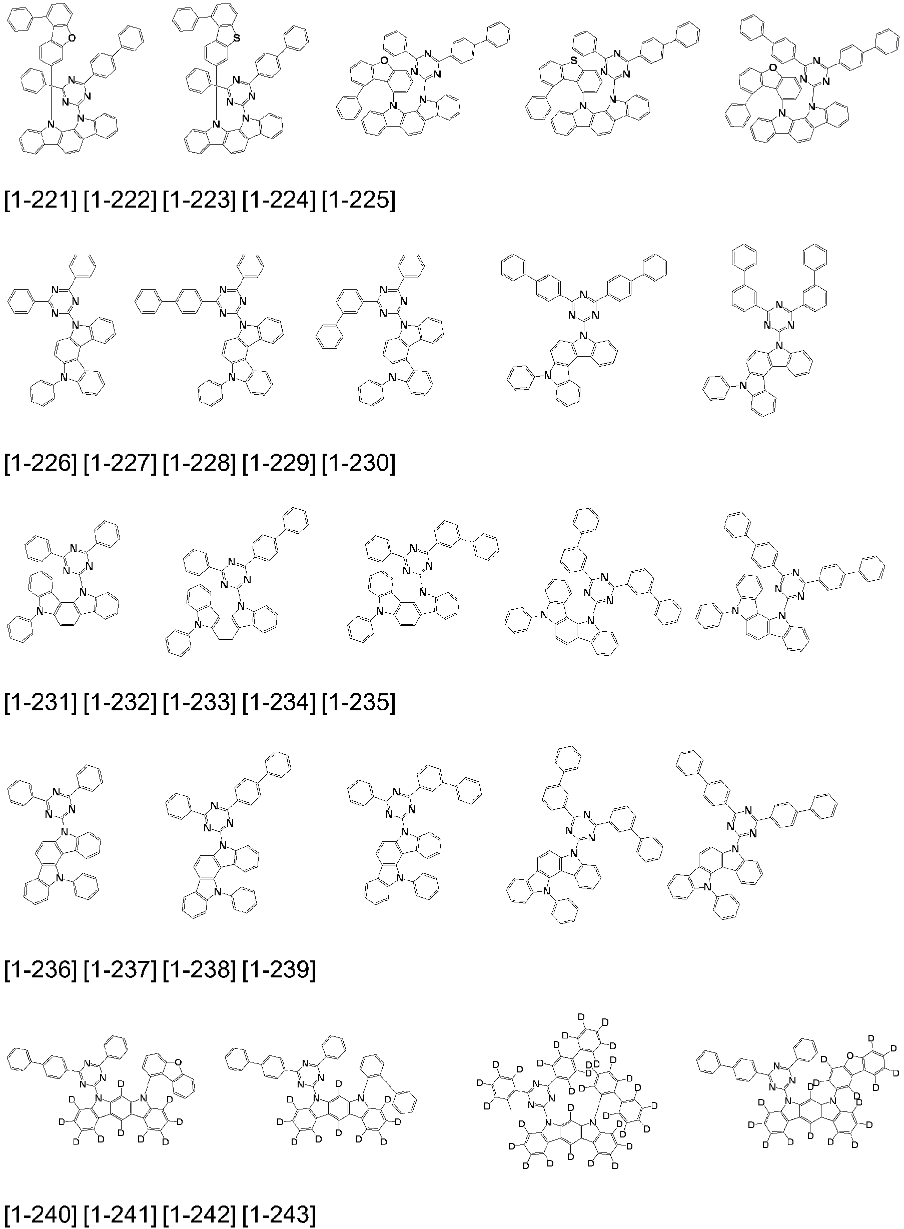 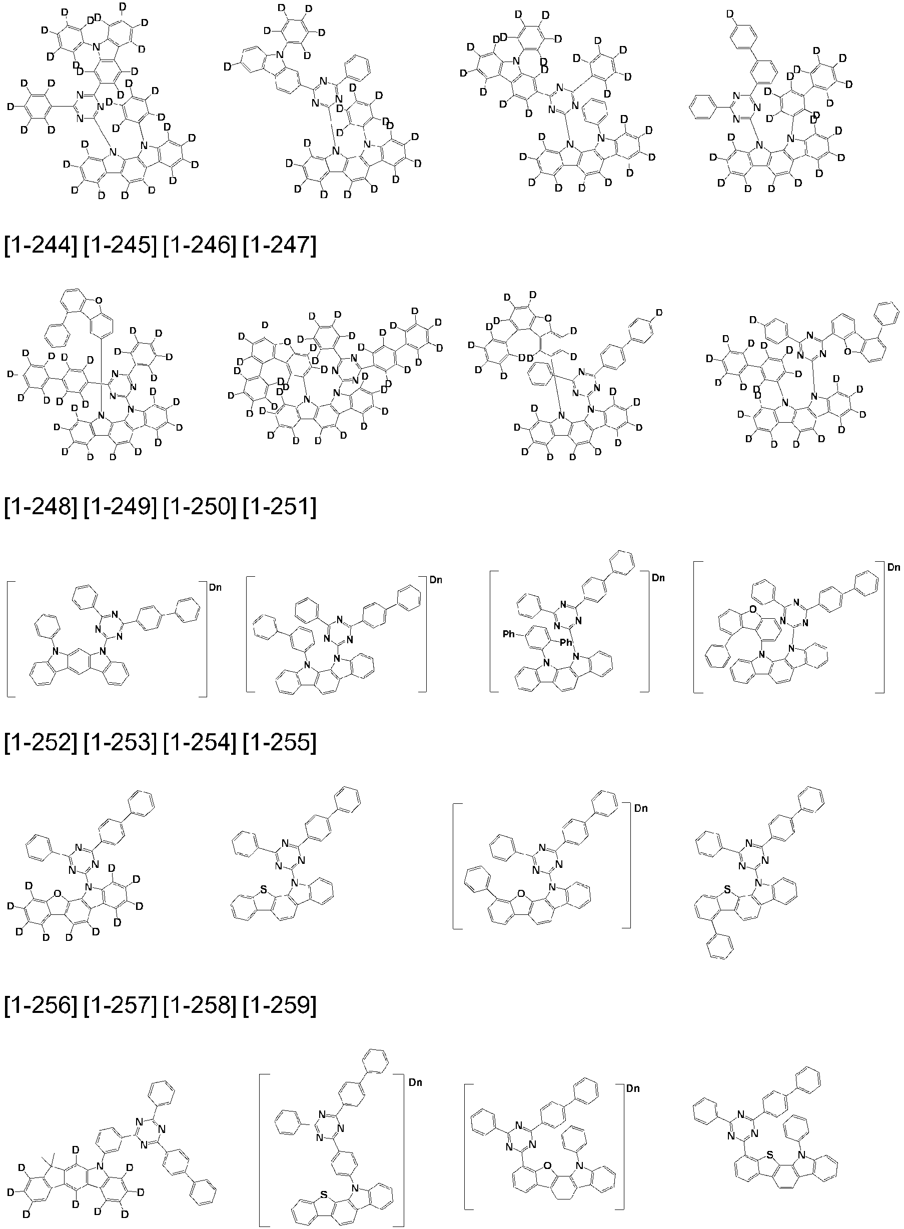
(Dn means the number of substituted deuteriums and indicates a structure in which one or more deuteriums are substituted).

9. The organic optoelectronic device as claimed in claim 1, wherein
the second compound is represented by any one of Chemical Formula 2A, Chemical Formula 2B, Chemical Formula 2C, Chemical Formula 2D, and Chemical Formula 2E: 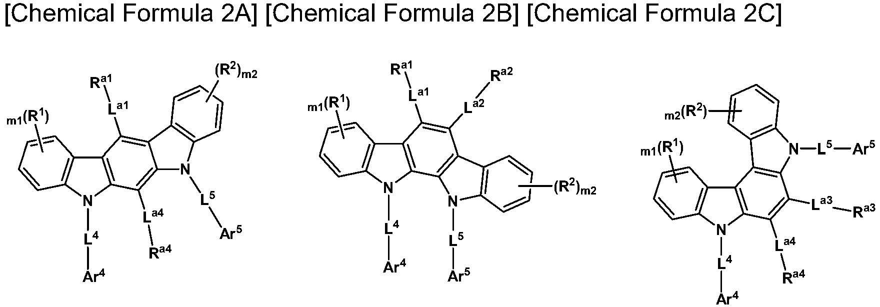 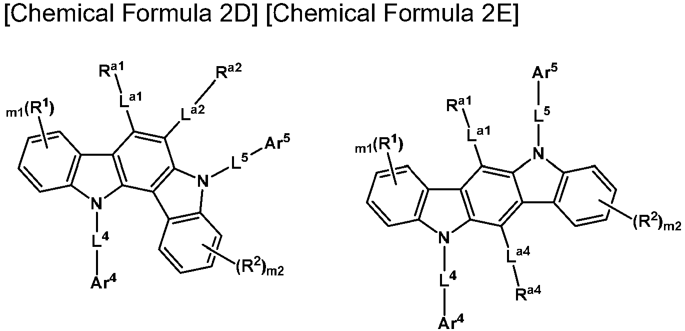
wherein, in Chemical Formula 2A, Chemical Formula 2B, Chemical Formula 2C, Chemical Formula 2D, and Chemical Formula 2E,
L^{a1} to L^{a4}, L⁴, and L⁵ are each independently a single bond or a substituted or unsubstituted C6 to C20 arylene group,
R^{a1} to R^{a4}, R¹, and R² are each independently hydrogen, deuterium, a cyano group, a halogen, a substituted or unsubstituted amine group, a substituted or unsubstituted C1 to C30 alkyl group, a substituted or unsubstituted C6 to C30 aryl group, or a substituted or unsubstituted C2 to C30 heterocyclic group,
Ar⁴ and Ar⁵ are each independently a substituted or unsubstituted C6 to C20 aryl group or a substituted or unsubstituted C2 to C30 heterocyclic group, and
m1 and m2 are each independently one of integers of 1 to 4.

10. The organic optoelectronic device as claimed in claim 9, wherein
the second compound is represented by Chemical Formula 2C.

11. The organic optoelectronic device as claimed in claim 9, wherein
L⁴-Ar⁴ and L⁵-Ar⁵ are each independently one of substituents listed in Group II: 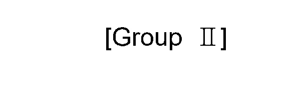 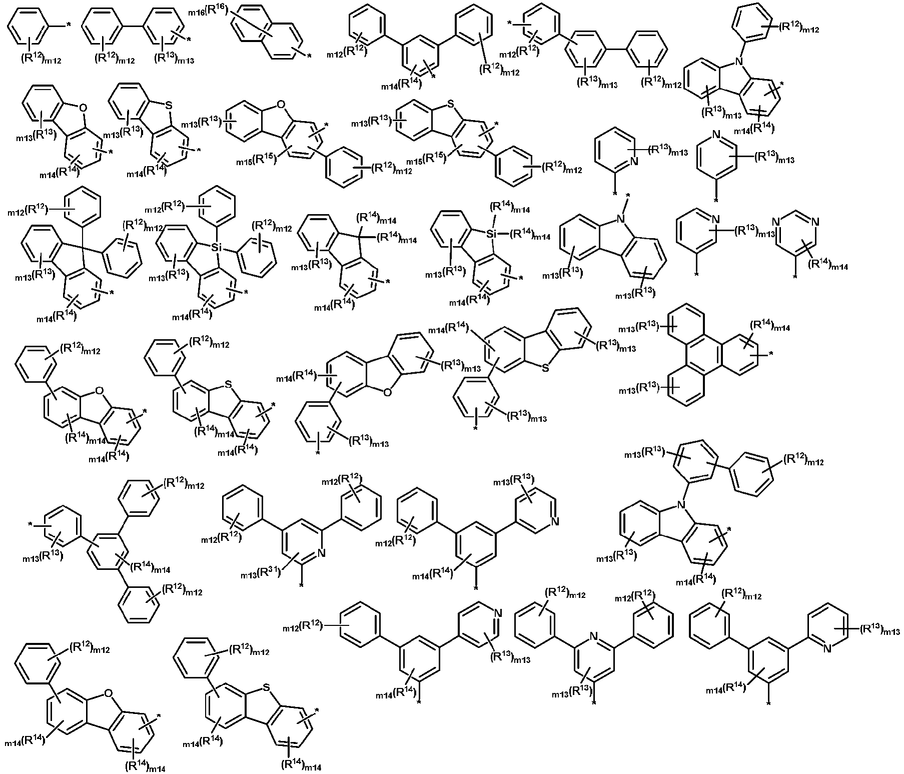
wherein, in Group II,
R¹² to R¹⁶ are each independently hydrogen, deuterium, a cyano group, C1 to C10 alkyl group or C6 to C12 aryl group,
m12 is one of integers of 1 to 5,
m13 is one of integers of 1 to 4,
m14 is one of integers of 1 to 3,
m15 is an integer of 1 or 2,
m16 is one of integers of 1 to 7, and
* is a linking point.

12. The organic optoelectronic device as claimed in claim 1, wherein
the second compound is one selected from compounds listed in Group 2:

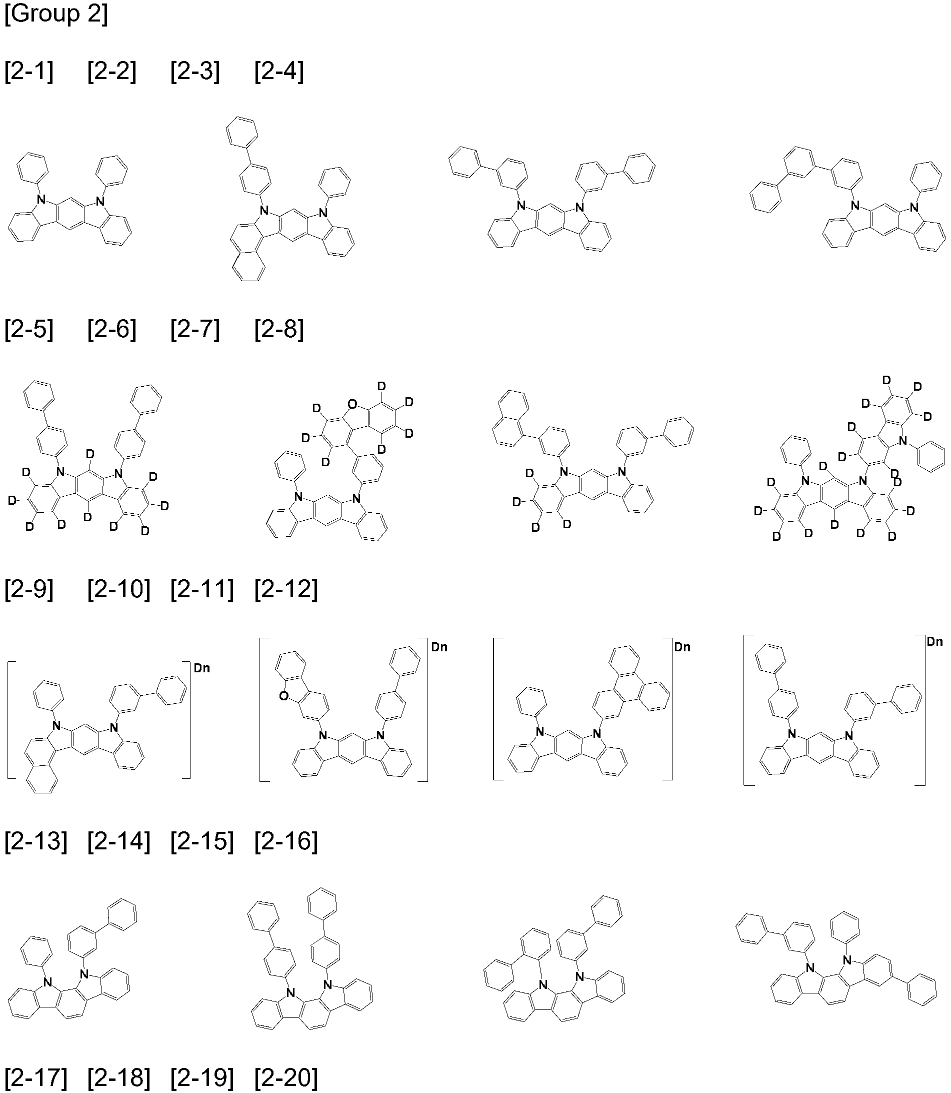

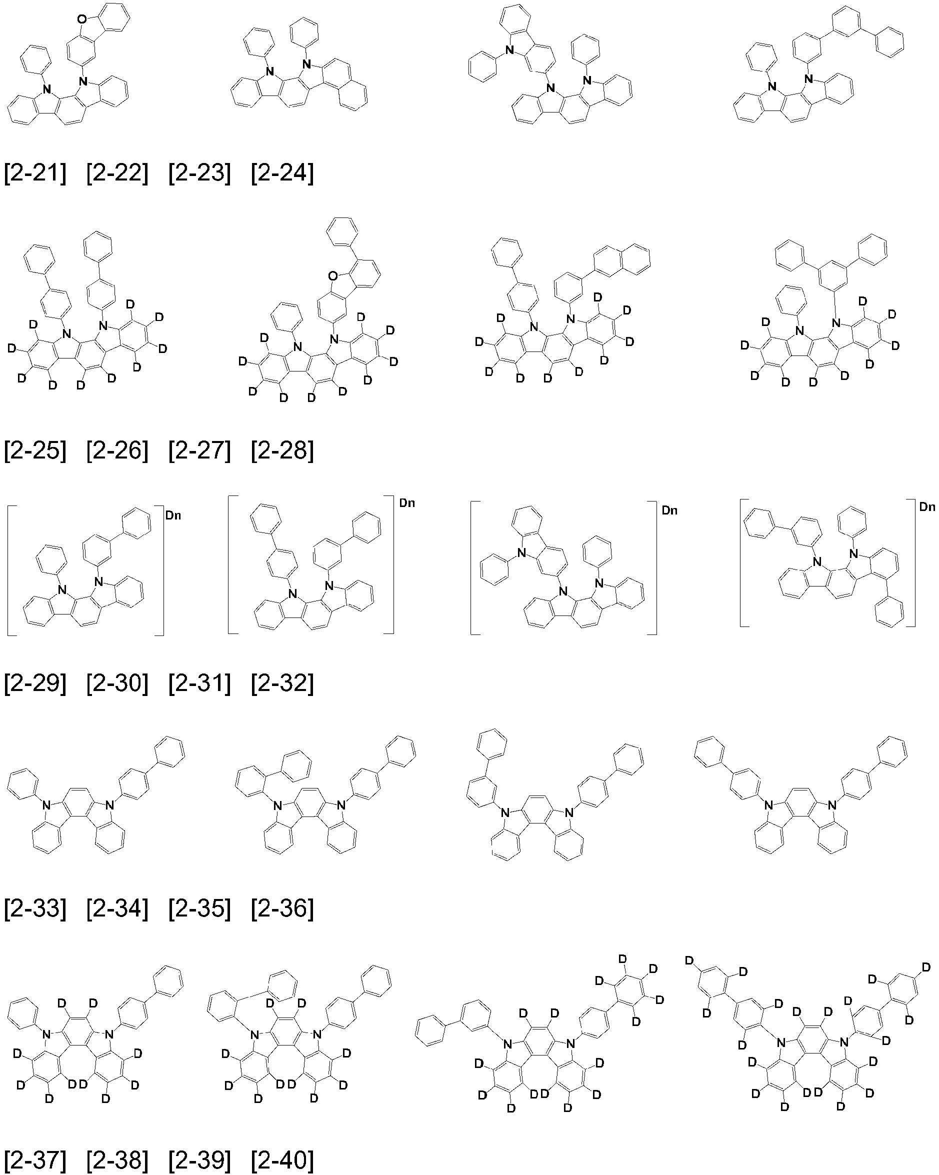

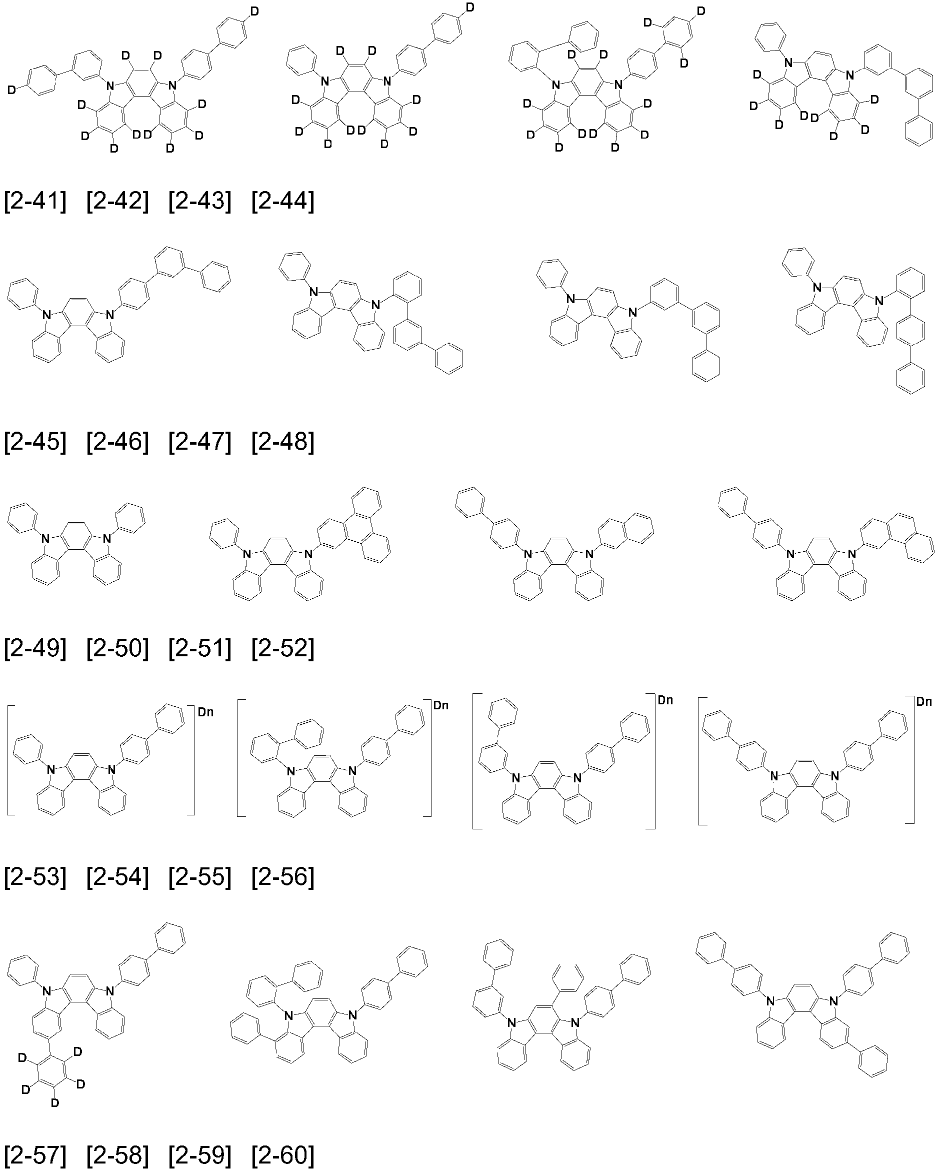

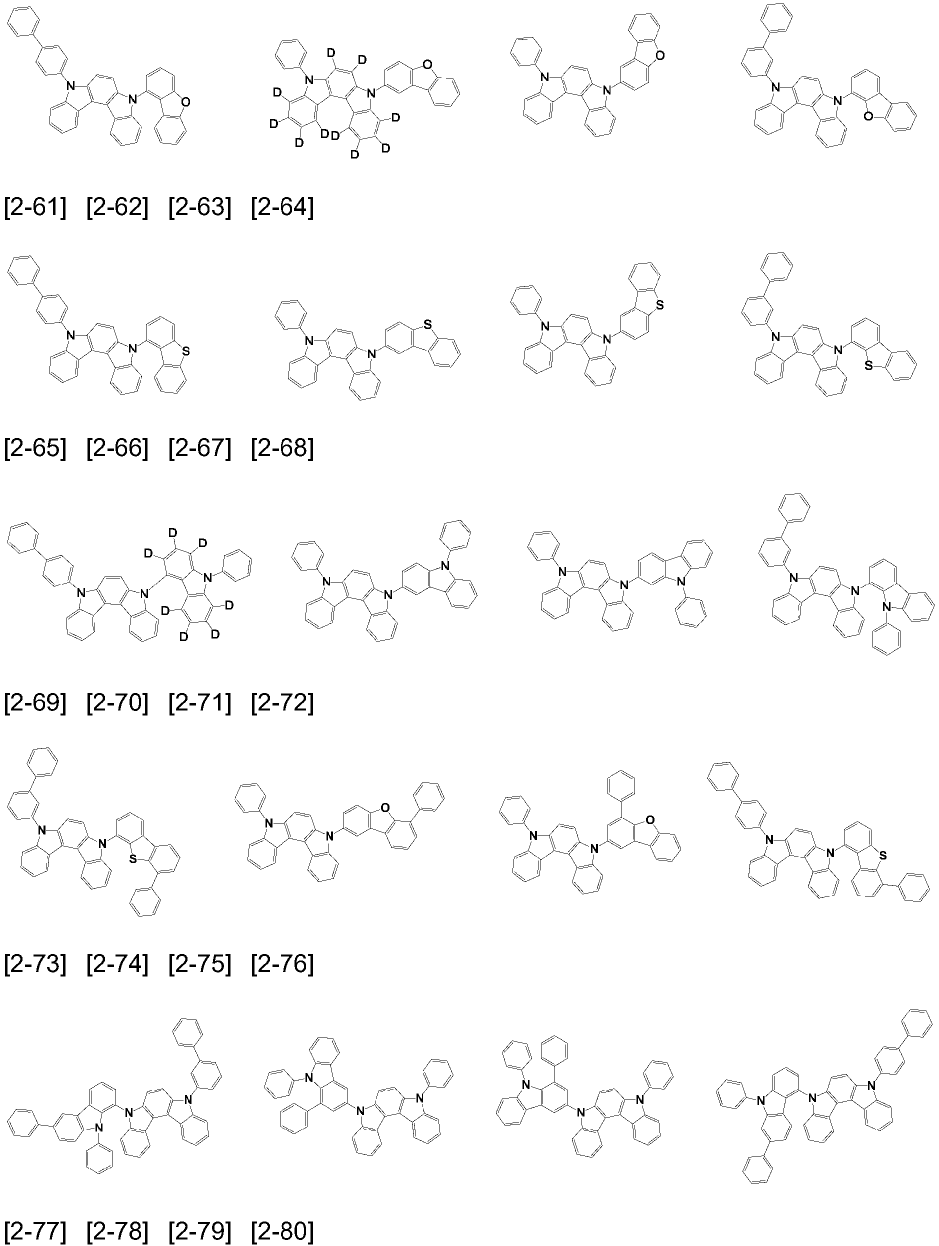

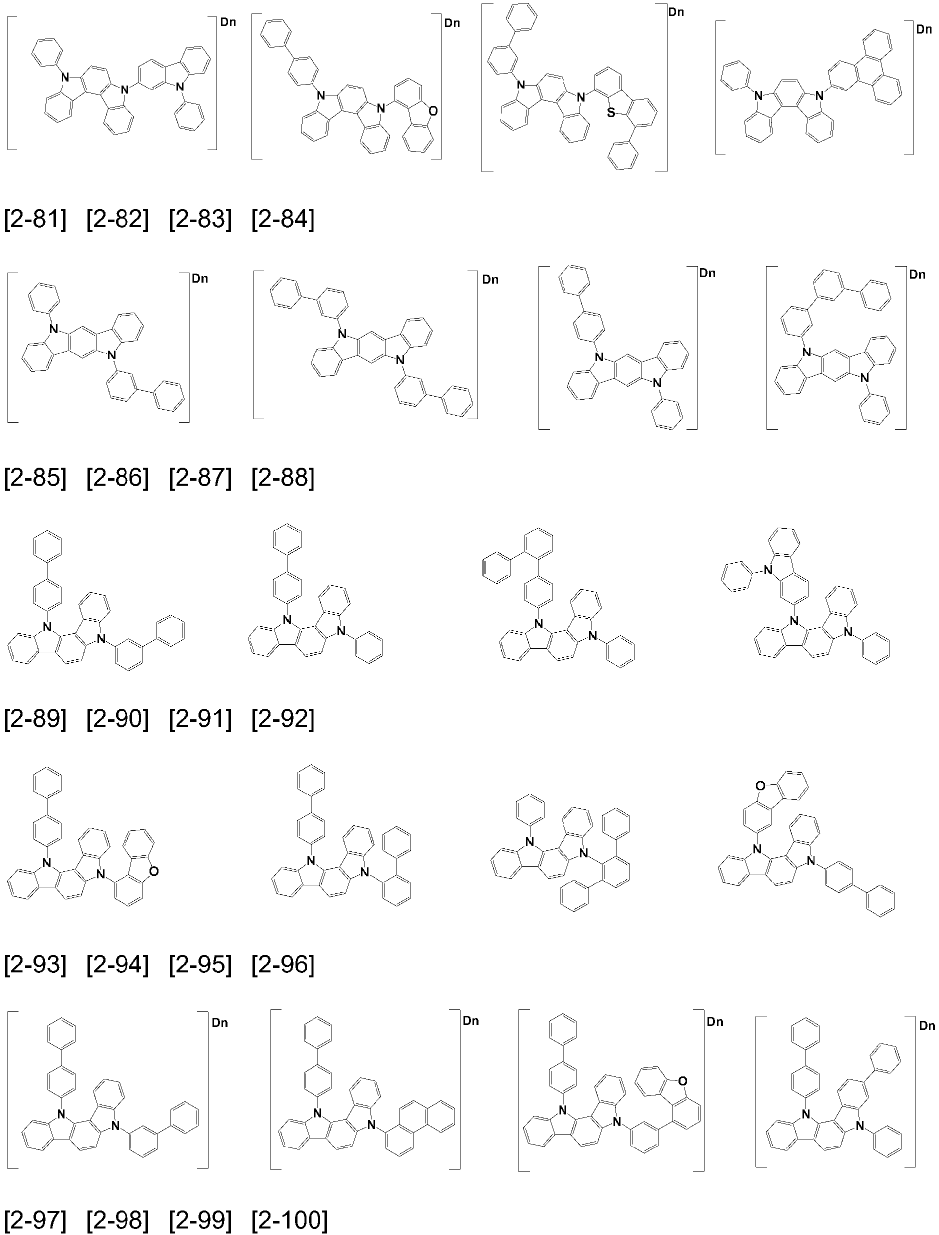

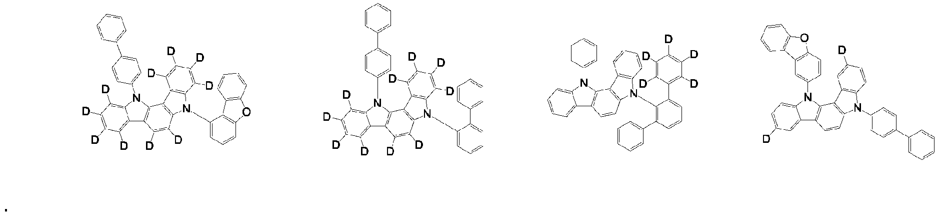

13. The organic optoelectronic device as claimed in claim 1, wherein
Ar⁶ is a substituted or unsubstituted phenyl group, and
Ar⁷ to Ar⁹ are each independently a substituted or unsubstituted C6 to C12 aryl group.

14. The organic optoelectronic device as claimed in claim 1, wherein
L⁷ is one selected from linking groups listed in Group III: 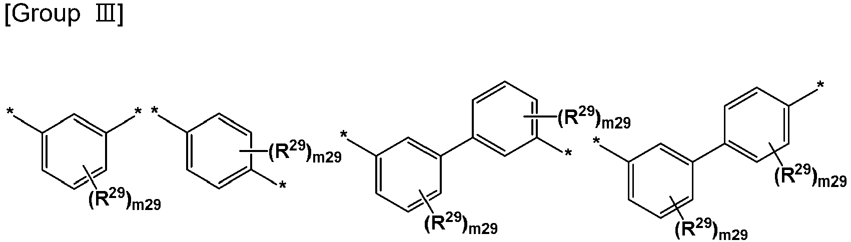
wherein, in Group III,
R²⁹ is hydrogen, deuterium, a cyano group, a substituted or unsubstituted C1 to C10 alkyl group, a substituted or unsubstituted C6 to C12 aryl group, or a substituted or unsubstituted C2 to C20 heteroaryl group,
m29 is one of integers of 1 to 4, and
* is a linking point.

15. The organic optoelectronic device as claimed in claim 1, wherein
the third compound is one selected from compounds listed in Group 3:

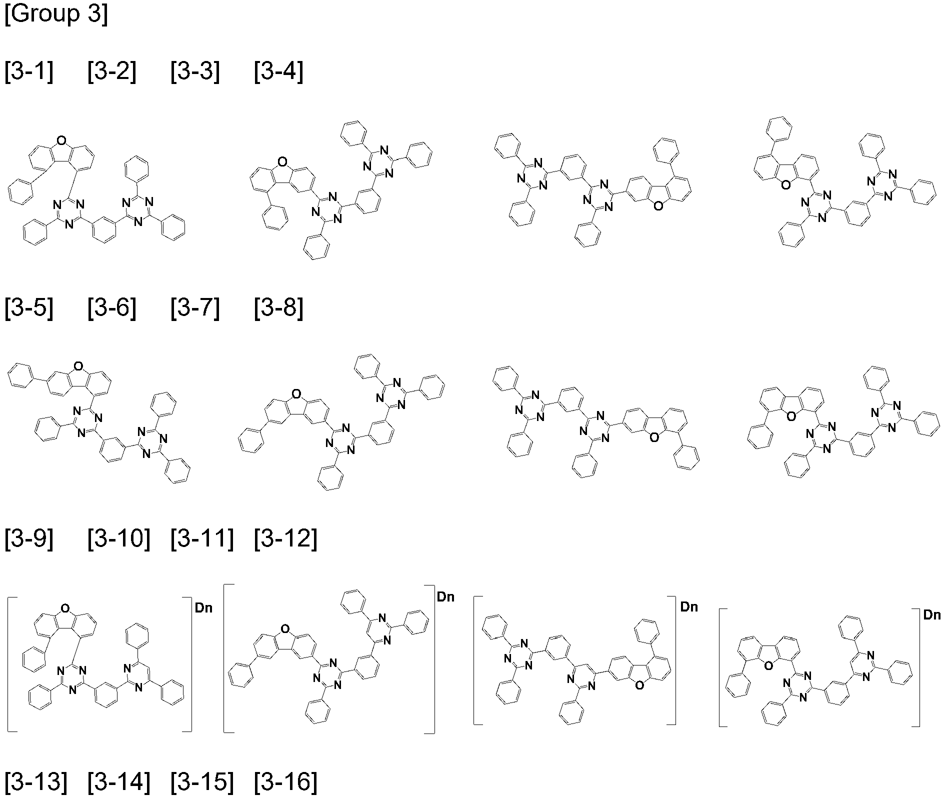

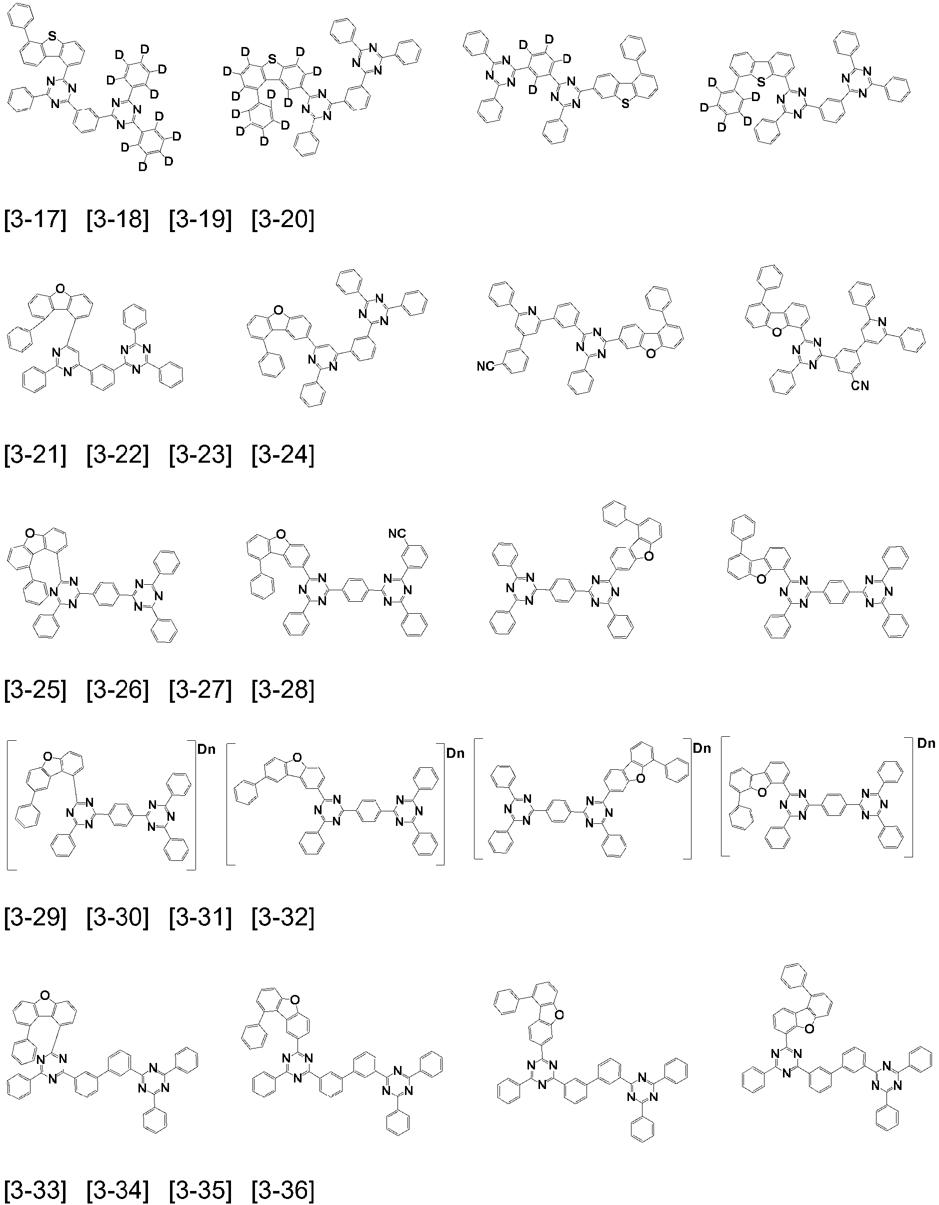

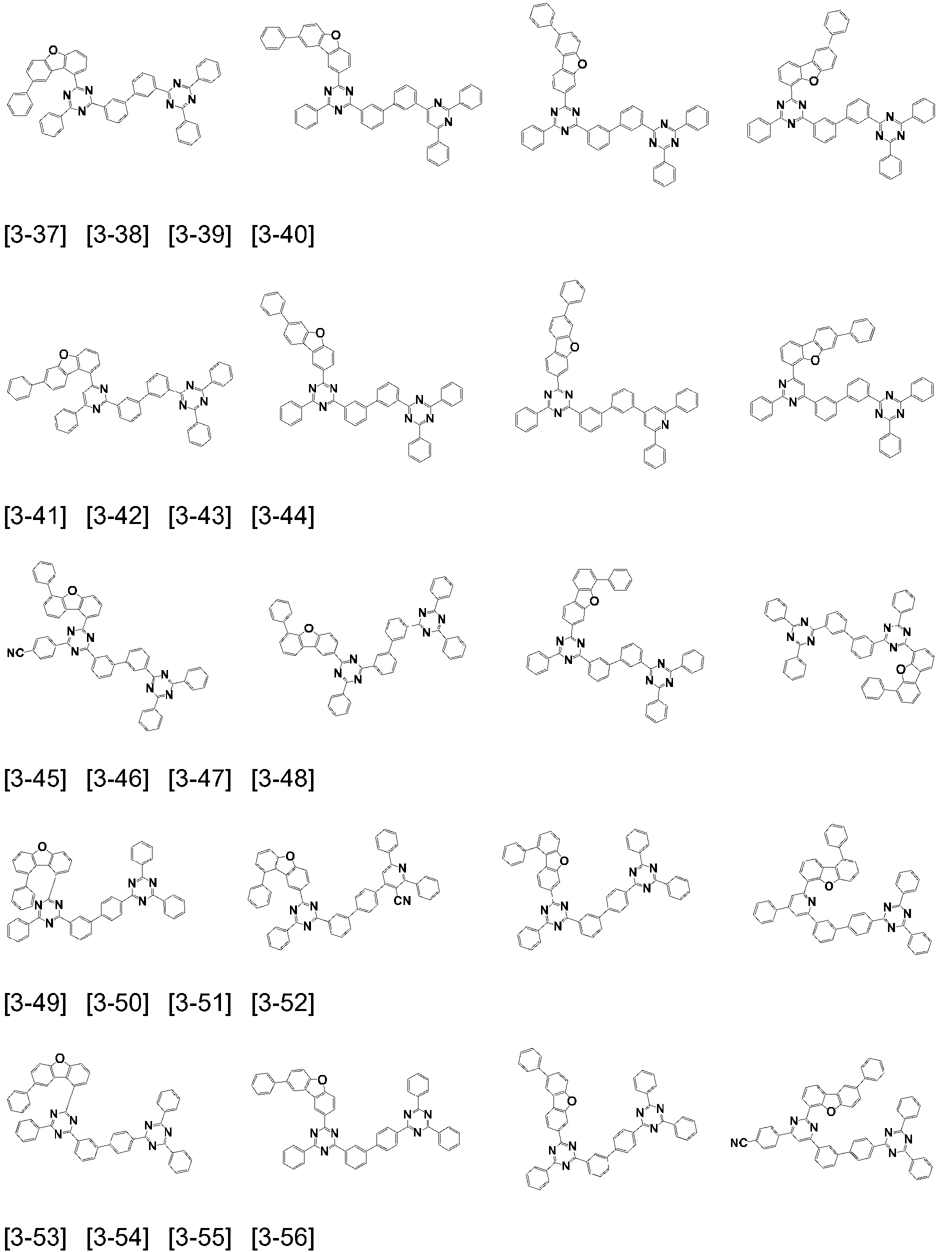

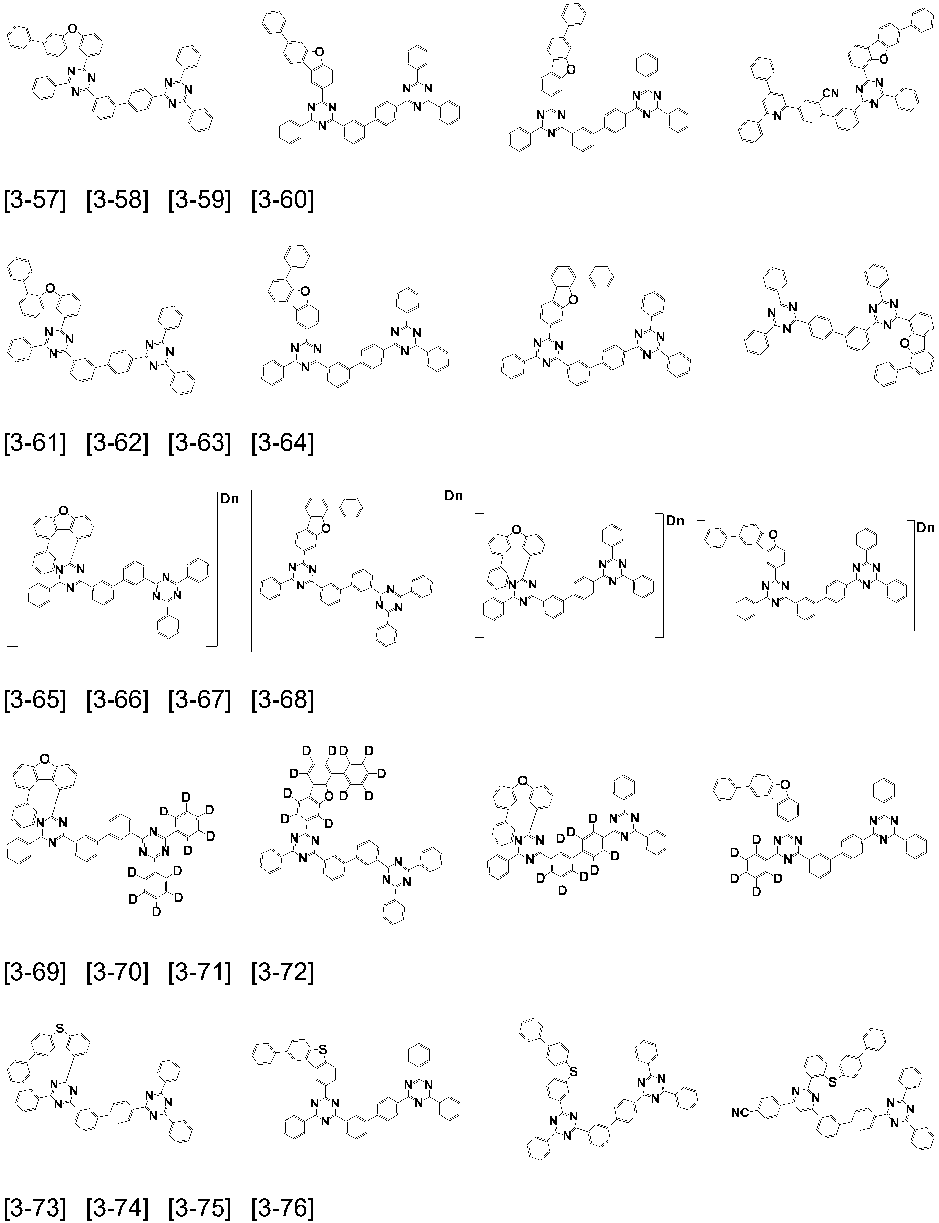

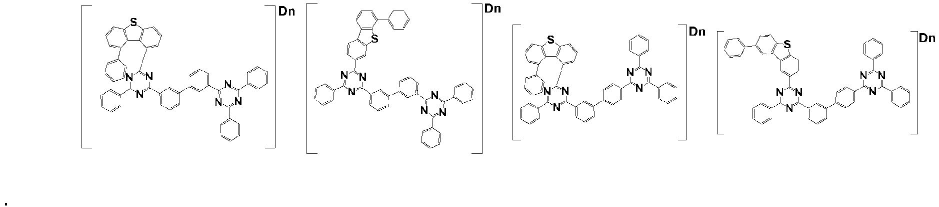

16. A display device comprising the organic optoelectronic device as claimed in any one of claims 1 to 15.
